(19) Europäisches Patentamt
European Patent Office
Office européen des brevets

(11) EP 4 193 399 B1

(12) # EUROPÄISCHE PATENTSCHRIFT

(45) Veröffentlichungstag und Bekanntmachung des Hinweises auf die Patenterteilung:
**29.01.2025 Patentblatt 2025/05**

(21) Anmeldenummer: **21736325.8**

(22) Anmeldetag: **30.06.2021**

(51) Internationale Patentklassifikation (IPC):
***H10K 85/30*** *(2023.01)* ***H10K 85/60*** *(2023.01)*
*H10K 50/155* *(2023.01)* *H10K 50/15* *(2023.01)*

(52) Gemeinsame Patentklassifikation (CPC):
**H10K 85/633; H10K 85/30; H10K 85/615;**
H10K 50/155; H10K 50/156; Y02E 10/549

(86) Internationale Anmeldenummer:
**PCT/EP2021/067941**

(87) Internationale Veröffentlichungsnummer:
**WO 2021/170886 (02.09.2021 Gazette 2021/35)**

(54) **ELEKTRONISCHE VORRICHTUNG**

ELECTRONIC DEVICE

DISPOSITIF ÉLECTRONIQUE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **06.08.2020 EP 20189947**

(43) Veröffentlichungstag der Anmeldung:
**14.06.2023 Patentblatt 2023/24**

(73) Patentinhaber: **Merck Patent GmbH**
**64293 Darmstadt (DE)**

(72) Erfinder:
- **STENGEL, Ilona**
  **64293 DARMSTADT (DE)**
- **VOGES, Frank**
  **64293 DARMSTADT (DE)**
- **MUJICA-FERNAUD, Teresa**
  **64293 DARMSTADT (DE)**
- **ANÉMIAN, Rémi Manouk**
  **64293 DARMSTADT (DE)**

(74) Vertreter: **Merck Patent Association**
**Merck Patent GmbH**
**64271 Darmstadt (DE)**

(56) Entgegenhaltungen:
**EP-A1- 3 131 901** **EP-A1- 3 462 516**
**WO-A1-2016/062371**

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

EP 4 193 399 B1

## Beschreibung

Die vorliegende Anmeldung betrifft eine elektronische Vorrichtung, die eine Koordinationsverbindung enthaltend mindestens ein Bismut-Atom jeweils in der Lochinjektionsschicht und der Lochtransportschicht enthält.

Unter elektronischen Vorrichtungen im Sinne dieser Anmeldung werden sogenannte organische elektronische Vorrichtungen verstanden (organic electronic devices), welche organische Halbleitermaterialien als Funktionsmaterialien enthalten. Insbesondere werden darunter OLEDs (organische Elektrolumineszenzvorrichtungen) verstanden. Unter der Bezeichnung OLEDs werden elektronische Vorrichtungen verstanden, welche eine oder mehrere Schichten enthaltend organische Verbindungen aufweisen und unter Anlegen von elektrischer Spannung Licht emittieren. Der Aufbau und das allgemeine Funktionsprinzip von OLEDs sind dem Fachmann bekannt.

Bei elektronischen Vorrichtungen, insbesondere OLEDs, besteht weiterhin großes Interesse an einer Verbesserung der Leistungsdaten und der Eigenschaften. Dabei sind die Zusammensetzung und der Aufbau der Lochinjektionsschicht und der Lochtransportschicht sehr wichtig. Im Stand der Technik ist dazu bekannt, organische Verbindungen mit niedrigem LUMO (lowest unoccupied molecular orbital) in der Lochinjektionsschicht einzusetzen, und/oder Arylaminverbindungen in der Lochtransportschicht einzusetzen. Weiterhin ist es bekannt, Arylaminverbindungen zusammen mit p-Dotanden in der Lochtransportschicht einzusetzen, um eine Lochtransportschicht mit hoher Lochleitfähigkeit zu erhalten.

Die Verwendung von Koordinationsverbindungen von Bismut in OLEDs ist im Stand der Technik bekannt, beispielsweise als p-Dotanden in der Lochtransportschicht. Vorteile der Bi-Verbindungen als p-Dotanden gegenüber den üblichen im Stand der Technik bekannten p-Dotanden sind insbesondere die Dotierbarkeit von Lochtransportmaterialien mit niedrig liegendem HOMO und die geringe Eigenfarbe (geringe Absorption im VIS-Bereich) und das geringere Übersprechen zwischen Pixeln (crosstalk).

Die Verwendung von Koordinationsverbindungen von Bismuth in der Lochinjektionsschicht einer OLED wird bereits in den Dokumenten WO2016/062371 (A1) und EP3462516 (A1) vorgeschlagen.

Bei derartigen Vorrichtungen besteht jedoch weiterhin Verbesserungsbedarf in Bezug auf die Prozessierbarkeit, die Lebensdauer, die Effizienz, die Höhe der Betriebsspannung, den Anstieg der Betriebsspannung während des Betriebs der OLED und insbesondere den Crosstalk (Übersprechen aufgrund von Querleitfähigkeit und Leckströmen).

Crosstalk zwischen benachbarten Pixeln einer OLED tritt immer dann auf, wenn die Querleitfähigkeit zwischen den Pixeln zu groß ist. Da insbesondere bei kleinen Pixeln und kleinen Abständen zwischen den Pixeln aus prozesstechnischen Gründen oft auf den Einsatz von zusätzlichen Schattenmasken verzichtet wird, haben verschiedenfarbige Subpixel gemeinsame großflächige organische Schichten, beispielsweise Lochinjektionsschichten und Lochtransportschichten. Diese Schichten zeigen oft eine erhöhte Querleitfähigkeit. Ist die Querleitfähigkeit zu groß, kann beim Einschalten eines Pixels ein kleiner Leckstrom zu einem schwachen Mitleuchten des Nachbarpixels führen. Dies ist insbesondere dann störend, wenn die benachbarten Pixel, wie in den meisten RGB Displays unterschiedliche Farben habe. Leuchtet beispielsweise der blaue Pixel, der benachbarte rote Pixel aber nicht, fließt ein geringer Leckstrom, der den roten Pixel schwach leuchten lässt. Dann sind keine tief blauen Farben mehr möglich, weil der rote Pixel mitleuchtet, so dass sich der Farbeindruck verschlechtert. Das Problem des Crosstalks tritt insbesondere bei kleinen Pixeln und bei geringem Abstand der Pixel zueinander auf. Überraschend wurde gefunden, dass eine elektronische Vorrichtung, die eine Koordinationsverbindung enthaltend mindestens ein Bismut-Atom in der Lochinjektionsschicht und in der Lochtransportschicht enthält, die oben genannten Eigenschaften der Vorrichtung verbessert. Insbesondere weist eine derart aufgebaute Vorrichtung einen geringen Anstieg der Betriebsspannung während des Betriebs und einen geringen Crosstalk auf.

Gegenstand der vorliegenden Anmeldung ist damit eine elektronische Vorrichtung, enthaltend

- eine Anode,
- eine an die Anode kathodenseitig angrenzende Schicht A, die eine Verbindung K1, gewählt aus Koordinationsverbindungen enthaltend mindestens ein Bismut-Atom, in einem Anteil von mindestens 20% enthält,
- eine an die Schicht A kathodenseitig angrenzende Schicht B, die eine Verbindung H und eine weitere Verbindung K2, die gewählt ist aus Koordinationsverbindungen enthaltend mindestens ein Bismut-Atom, enthält;
- eine Kathode.

Unter der Angabe von Anteilen in % ist gemäß dem üblichen Verständnis des Fachmanns bei Schichten, die aus Lösung aufgebracht werden, Gewichts-% zu verstehen, und bei Schichten, die aus der Gasphase aufgebracht werden, Volumen-% zu verstehen. Bevorzugt ist allgemein im Rahmen der vorliegenden Anmeldung unter "%" Volumen-% zu verstehen.

Bei der Verwendung des Worts "eine", beispielsweise in der Definition "elektronische Vorrichtung, enthaltend eine Schicht A" ist grundsätzlich der Plural nicht ausgeschlossen, das heißt es können im oben genannten Fall auch zwei oder mehr Schichten A in der elektronischen Vorrichtung vorliegen.

Die elektronische Vorrichtung ist bevorzugt ausgewählt aus der Gruppe bestehend aus organischen integrierten

Schaltungen (OICs), organischen Feld-Effekt-Transistoren (OFETs), organischen Dünnfilmtransistoren (OTFTs), organischen lichtemittierenden Transistoren (OLETs), organischen Solarzellen (OSCs), organischen optischen Detektoren, organischen Photorezeptoren, organischen Feld-Quench-Devices (OFQDs), organischen lichtemittierenden elektrochemischen Zellen (OLECs), organischen Laserdioden (O-Laser) und besonders bevorzugt organischen Elektrolumineszenzvorrichtungen (OLEDs).

Die Anode der anmeldungsgemäßen Vorrichtung enthält bevorzugt ein Material mit hoher Austrittsarbeit. Bevorzugt weist die Anode eine Austrittsarbeit von größer als 4.5 eV vs. Vakuum auf. Hierfür sind besonders Metalle mit hohem Redoxpotential geeignet, wie beispielsweise Ag, Pt oder Au. Gemäß einer bevorzugten Ausführungsform ist die Anode eine Metall/Metalloxid-Elektrode, beispielsweise aus $Al/Ni/NiO_x$ oder $Al/PtO_x$. Für einige Anwendungen ist es bevorzugt, dass mindestens eine der Elektroden transparent oder teiltransparent ist, um entweder die Bestrahlung des organischen Materials (organische Solarzelle) oder die Auskopplung von Licht (OLED, O-LASER) zu ermöglichen. Bevorzugte Anodenmaterialien sind hier leitfähige gemischte Metalloxide. Besonders bevorzugte Materialien für die Anode sind Indium-Zinn-Oxid (ITO) oder Indium-Zink Oxid (IZO). Bevorzugt sind weiterhin leitfähige, dotierte organische Materialien, insbesondere leitfähige dotierte Polymere. Gemäß einer bevorzugten Ausführungsform besteht die Anode aus mehreren Schichten, beispielsweise aus einer inneren Schicht aus ITO und einer äußeren Schicht aus einem Metalloxid, bevorzugt Wolframoxid, Molybdänoxid oder Vanadiumoxid.

Die Schicht A grenzt bevorzugt direkt an die Anode an. Weiterhin ist es bevorzugt, dass die Schicht A eine Dicke von 0.5 nm bis 10 nm aufweist, besonders bevorzugt von 1 nm bis 5 nm, ganz besonders bevorzugt von 2 nm bis 4 nm. Die Schicht A ist bevorzugt eine Lochinjektionsschicht. Unter einer Lochinjektionsschicht wird im Rahmen der vorliegenden Anmeldung eine Schicht verstanden, die lochinjizierende und lochtransportierende Eigenschaften aufweist und direkt an die Anode angrenzt.

Die Schicht A enthält die Verbindung K1 bevorzugt in einem Anteil von mindestens 50%, besonders bevorzugt in einem Anteil von mindestens 90%, ganz besonders bevorzugt in einem Anteil von mindestens 99%. Gemäß einer bevorzugten Ausführungsform besteht die Schicht A im Wesentlichen aus der Verbindung K1. Am stärksten bevorzugt besteht die Schicht A aus der Verbindung K1. Dabei ist das Vorhandensein von Verunreinigungen in geringem Umfang nicht ausgeschlossen.

Die Verbindung K1 ist bevorzugt gewählt aus Koordinationsverbindungen enthaltend mindestens einen Liganden und mindestens ein Bi-Atom. Das Bismut-Atom liegt bevorzugt in der Oxidationsstufe +3 vor, als Bi(III). Das Bismut-Atom kann jedoch gemäß alternativen bevorzugten Ausführungsformen auch in der Stufe +2 oder +5 vorliegen.

Die Verbindung K1 ist bevorzugt eine starke Lewis-Säure, insbesondere eine Verbindung, die eine hohe Bereitschaft hat, ein Elektronenpaar eines anderen Atoms aufzunehmen.

Die Verbindung K1 kann ein mononuklearer Komplex von Bismut sein, ein binuklearer Komplex von Bismut oder ein polynuklearer Komplex von Bismut. Dabei ist es möglich, dass die Verbindung K1 ein mononuklearer Komplex von Bismut ist, sofern sie in der Gasphase vorliegt, und ein polynuklearer Komplex von Bismut ist, wenn sie in der Festkörperphase vorliegt. Das heißt, die Verbindung K1 kann, je nach Aggregatzustand, polymerisieren oder depolymerisieren.

Bevorzugt weist die Verbindung K1 als Koordinationsverbindung mindestens einen Liganden L auf, der eine organische Verbindung ist. Der Ligand L ist bevorzugt gewählt aus einzähnigen, zweizähnigen und dreizähnigen Liganden, besonders bevorzugt aus einzähnigen Liganden. Weiterhin bevorzugt ist der Ligand L negativ geladen, bevorzugt dreifach, zweifach oder einfach negativ geladen, besonders bevorzugt einfach negativ geladen.

Die Liganden L der Verbindung K1 können gleich oder verschieden gewählt sein. Bevorzugt sind sie gleich gewählt.

Die an das Bismutatom bindende Gruppe des Liganden L ist bevorzugt gewählt aus Carbonsäuregruppen, Thiocarbonsäuregruppen, im Besonderen Thiolsäuregruppen, Thionsäuregruppen und Dithiolsäuregruppen, Carbonsäureamidgruppen und Carbonsäureimidgruppen, besonders bevorzugt aus Carbonsäuregruppen. Bevorzugt sind Liganden enthaltend mindestens eine Gruppe gewählt aus Carbonsäuregruppen, Thiocarbonsäuregruppen, im Besonderen Thiolsäuregruppen, Thionsäuregruppen und Dithiolsäuregruppen, Carbonsäureamidgruppen und Carbonsäureimidgruppen, die zusätzlich mindestens eine elektronenziehende Gruppe aufweisen. Besonders bevorzugt sind Liganden enthaltend mindestens eine Carbonsäuregruppe, die zusätzlich zur Carbonsäuregruppe mindestens eine weitere elektronenziehende Gruppe aufweisen. Die elektronenziehende Gruppe ist bevorzugt gewählt aus F, Cl, Br, I, CN, $NO_2$ und Alkylgruppen mit 1 bis 20 C-Atomen, welche mindestens einen Substituenten gewählt aus F, Cl, CN und $NO_2$ aufweisen, besonders bevorzugt aus F, Cl, CN und $CF_3$. Besonders bevorzugt sind im Liganden L eine, zwei, oder drei solcher weiterer elektronenziehender Gruppen vorhanden, ganz besonders bevorzugt drei.

Bevorzugt entspricht der Ligand L einer der folgenden Formeln (L-I), (L-II), (L-III) und (L-IV)

| | |
|---|---|
| 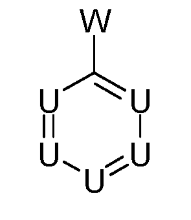 | 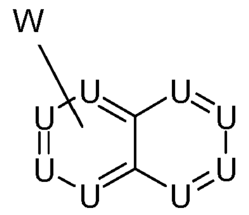 |
| Formel (L-I) | Formel (L-II) |
| 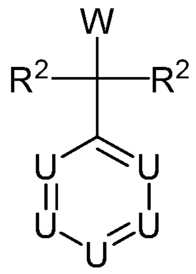 | 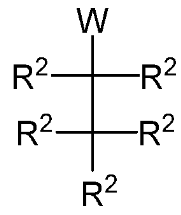 |
| Formel (L-III) | Formel (L-IV) |

wobei gilt:

W ist gewählt aus Carbonsäuregruppen, Thiocarbonsäuregruppen, im Besonderen Thiolsäuregruppen, Thionsäuregruppen und

Dithiolsäuregruppen, Carbonsäureamidgruppen und

Carbonsäureimidgruppen, besonders bevorzugt aus Carbonsäuregruppen;

U ist bei jedem Auftreten gleich oder verschieden gewählt aus N und $CR^1$, wenn an es keine Gruppe W gebunden ist, und U ist gleich C, wenn an es eine Gruppe W gebunden ist; und

$R^1$ ist bei jedem Auftreten gleich oder verschieden gewählt aus H, D, F, Cl, Br, I, $C(=O)R^2$, CN, $Si(R^2)_3$, $N(R^2)_2$, $P(=O)(R^2)_2$, $OR^2$, $S(=O)R^2$, $S(=O)_2R^2$, geradkettigen Alkyl- oder Alkoxygruppen mit 1 bis 20 C-Atomen, verzweigten oder cyclischen Alkyl- oder Alkoxygruppen mit 3 bis 20 C-Atomen, Alkenyl- oder Alkinylgruppen mit 2 bis 20 C-Atomen, aromatischen Ringsystemen mit 6 bis 40 aromatischen Ringatomen, und heteroaromatischen Ringsystemen mit 5 bis 40 aromatischen Ringatomen; wobei zwei oder mehr Reste $R^1$ miteinander verknüpft sein können und einen Ring bilden können; wobei die genannten Alkyl-, Alkoxy-, Alkenyl- und Alkinylgruppen und die genannten aromatischen Ringsysteme und heteroaromatischen Ringsysteme jeweils mit Resten $R^2$ substituiert sind; und wobei eine oder mehrere $CH_2$-Gruppen in den genannten Alkyl-, Alkoxy-, Alkenyl- und Alkinylgruppen durch $-R^2C=CR^2-$, -C=C-, $Si(R^2)_2$, C=O, $C=NR^2$, -C(=O)O-, $-C(=O)NR^2-$, $NR^2$, $P(=O)(R^2)$, -O-, -S-, SO oder $SO_2$ ersetzt sein können;

$R^2$ ist bei jedem Auftreten gleich oder verschieden gewählt aus H, D, F, Cl, Br, I, $C(=O)R^3$, CN, $Si(R^3)_3$, $N(R^3)_2$, $P(=O)(R^3)_2$, $OR^3$, $S(=O)R^3$, $S(=O)_2R^3$, geradkettigen Alkyl- oder Alkoxygruppen mit 1 bis 20 C-Atomen, verzweigten oder cyclischen Alkyl- oder Alkoxygruppen mit 3 bis 20 C-Atomen, Alkenyl- oder Alkinylgruppen mit 2 bis 20 C-Atomen, aromatischen Ringsystemen mit 6 bis 40 aromatischen Ringatomen, und heteroaromatischen Ringsystemen mit 5 bis 40 aromatischen Ringatomen; wobei zwei oder mehr Reste $R^2$ miteinander verknüpft sein können und einen Ring bilden können; wobei die genannten Alkyl-, Alkoxy-, Alkenyl- und Alkinylgruppen und die genannten aromatischen Ringsysteme und heteroaromatischen Ringsysteme jeweils mit Resten $R^3$ substituiert sind; und wobei eine oder mehrere $CH_2$-Gruppen in den genannten Alkyl-, Alkoxy-, Alkenyl- und Alkinylgruppen durch $-R^3C=CR^3-$, -C=C-, $Si(R^1)_2$, C=O, $C=NR^3$, -C(=O)O-, $-C(=O)NR^3-$, $NR^3$, $P(=O)(R^3)$, -O-, -S-, SO oder $SO_2$ ersetzt sein können;

$R^3$ ist bei jedem Auftreten gleich oder verschieden gewählt aus H, D, F, Cl, Br, I, CN, $NO_2$, Alkyl- oder Alkoxygruppen mit 1 bis 20 C-Atomen, Alkenyl-oder Alkinylgruppen mit 2 bis 20 C-Atomen, aromatischen Ringsystemen mit 6 bis 40 aromatischen Ringatomen und heteroaromatischen Ringsystemen mit 5 bis 40 aromatischen Ringatomen; wobei zwei oder mehr Reste $R^3$ miteinander verknüpft sein können und einen Ring bilden können; und wobei die genannten Alkyl-, Alkoxy-, Alkenyl- und Alkinylgruppen, aromatischen Ringsysteme und heteroaromatischen Ringsysteme mit

einem oder mehreren Resten gewählt aus F und CN substituiert sein können.

Die folgenden Definitionen gelten für die chemischen Gruppen, die in der vorliegenden Anmeldung verwendet werden. Sie gelten, soweit keine spezielleren Definitionen angegeben sind.

Unter einer Arylgruppe im Sinne dieser Erfindung wird entweder ein einzelner aromatischer Cyclus, also Benzol, oder ein kondensierter aromatischer Polycyclus, beispielsweise Naphthalin, Phenanthren oder Anthracen, verstanden. Ein kondensierter aromatischer Polycyclus besteht im Sinne der vorliegenden Anmeldung aus zwei oder mehr miteinander kondensierten einzelnen aromatischen Cyclen. Unter Kondensation zwischen Cyclen ist dabei zu verstehen, dass die Cyclen mindestens eine Kante miteinander teilen. Eine Arylgruppe im Sinne dieser Erfindung enthält 6 bis 40 aromatische Ringatome. Weiterhin enthält eine Arylgruppe kein Heteroatom als aromatisches Ringatom, sondern nur Kohlenstoffatome.

Unter einer Heteroarylgruppe im Sinne dieser Erfindung wird entweder ein einzelner heteroaromatischer Cyclus, beispielsweise Pyridin, Pyrimidin oder Thiophen, oder ein kondensierter heteroaromatischer Polycyclus, beispielsweise Chinolin oder Carbazol, verstanden. Ein kondensierter heteroaromatischer Polycyclus besteht im Sinne der vorliegenden Anmeldung aus zwei oder mehr miteinander kondensierten einzelnen aromatischen oder heteroaromatischen Cyclen, wobei wenigstens einer der aromatischen und heteroaromatischen Cyclen ein heteroaromatischer Cyclus ist. Unter Kondensation zwischen Cyclen ist dabei zu verstehen, dass die Cyclen mindestens eine Kante miteinander teilen. Eine Heteroarylgruppe im Sinne dieser Erfindung enthält 5 bis 40 aromatische Ringatome, von denen mindestens eines ein Heteroatom darstellt. Die Heteroatome der Heteroarylgruppe sind bevorzugt ausgewählt aus N, O und S.

Unter einer Aryl- oder Heteroarylgruppe, die jeweils mit den oben genannten Resten substituiert sein kann werden insbesondere Gruppen verstanden, welche abgeleitet sind von Benzol, Naphthalin, Anthracen, Phenanthren, Pyren, Dihydropyren, Chrysen, Perylen, Triphenylen, Fluoranthen, Benzanthracen, Benzphenanthren, Tetracen, Pentacen, Benzpyren, Furan, Benzofuran, Isobenzofuran, Dibenzofuran, Thiophen, Benzothiophen, Isobenzothiophen, Dibenzothiophen, Pyrrol, Indol, Isoindol, Carbazol, Pyridin, Chinolin, Isochinolin, Acridin, Phenanthridin, Benzo-5,6-chinolin, Benzo-6,7-chinolin, Benzo-7,8-chinolin, Phenothiazin, Phenoxazin, Pyrazol, Indazol, Imidazol, Benzimidazol, Benzimidazolo[1,2-a]benzimidazol, Naphthimidazol, Phenanthrimidazol, Pyridimidazol, Pyrazinimidazol, Chinoxalinimidazol, Oxazol, Benzoxazol, Naphthoxazol, Anthroxazol, Phenanthroxazol, Isoxazol, 1,2-Thiazol, 1,3-Thiazol, Benzothiazol, Pyridazin, Benzopyridazin, Pyrimidin, Benzpyrimidin, Chinoxalin, Pyrazin, Phenazin, Naphthyridin, Azacarbazol, Benzocarbolin, Phenanthrolin, 1,2,3-Triazol, 1,2,4-Triazol, Benzotriazol, 1,2,3-Oxadiazol, 1,2,4-Oxadiazol, 1,2,5-Oxadiazol, 1,3,4-Oxadiazol, 1,2,3-Thiadiazol, 1,2,4-Thiadiazol, 1,2,5-Thiadiazol, 1,3,4-Thiadiazol, 1,3,5-Triazin, 1,2,4-Triazin, 1,2,3-Triazin, Tetrazol, 1,2,4,5-Tetrazin, 1,2,3,4-Tetrazin, 1,2,3,5-Tetrazin, Purin, Pteridin, Indolizin und Benzothiadiazol.

Ein aromatisches Ringsystem im Sinne dieser Erfindung ist ein System, welches nicht notwendigerweise nur Arylgruppen enthält, sondern welches zusätzlich einen oder mehrere nicht-aromatische Ringe enthalten kann, die mit wenigstens einer Arylgruppe kondensiert sind. Diese nicht-aromatischen Ringe enthalten ausschließlich Kohlenstoffatome als Ringatome. Beispiele für Gruppen, die von dieser Definition umfasst sind, sind Tetrahydronaphthalin, Fluoren und Spirobifluoren. Weiterhin umfasst der Begriff aromatisches Ringsystem Systeme, die aus zwei oder mehr aromatischen Ringsystemen bestehen, die über Einfachbindungen miteinander verbunden sind, beispielsweise Biphenyl, Terphenyl, 7-Phenyl-2-fluorenyl, Quaterphenyl und 3,5-Diphenyl-1-phenyl. Ein aromatisches Ringsystem im Sinne dieser Erfindung enthält 6 bis 40 C-Atome und keine Heteroatome im Ringsystem. Die Definition von "aromatisches Ringsystem" umfasst nicht Heteroarylgruppen.

Ein heteroaromatisches Ringsystem entspricht der oben genannten Definition eines aromatischen Ringsystems, mit dem Unterschied dass es mindestens ein Heteroatom als Ringatom enthalten muss. Wie es beim aromatischen Ringsystem der Fall ist, muss das heteroaromatische Ringsystem nicht ausschließlich Arylgruppen und Heteroarylgruppen enthalten, sondern es kann zusätzlich einen oder mehrere nicht-aromatische Ringe enthalten, die mit wenigstens einer Aryl- oder Heteroarylgruppe kondensiert sind. Die nicht-aromatischen Ringe können ausschließlich C-Atome als Ringatome enthalten, oder sie können zusätzlich ein oder mehrere Heteroatome enthalten, wobei die Heteroatome bevorzugt gewählt sind aus N, O und S. Ein Beispiel für ein derartiges heteroaromatisches Ringsystem ist Benzopyranyl. Weiterhin werden unter dem Begriff "heteroaromatisches Ringsystem" Systeme verstanden, die aus zwei oder mehr aromatischen oder heteroaromatischen Ringsystemen bestehen, die miteinander über Einfachbindungen verbunden sind, wie beispielsweise 4,6-Diphenyl-2-triazinyl. Ein heteroaromatisches Ringsystem im Sinne dieser Erfindung enthält 5 bis 40 Ringatome, die gewählt sind aus Kohlenstoff und Heteroatomen, wobei mindestens eines der Ringatome ein Heteroatom ist. Die Heteroatome des heteroaromatischen Ringsystems sind bevorzugt ausgewählt aus N, O und S.

Die Begriffe "heteroaromatisches Ringsystem" und "aromatisches Ringsystem" gemäß der Definition der vorliegenden Anmeldung unterscheiden sich damit dadurch voneinander, dass ein aromatisches Ringsystem kein Heteroatom als Ringatom aufweisen kann, während ein heteroaromatisches Ringsystem mindestens ein Heteroatom als Ringatom aufweisen muss. Dieses Heteroatom kann als Ringatom eines nicht-aromatischen heterocyclischen Rings oder als Ringatom eines aromatischen heterocyclischen Rings vorliegen.

Entsprechend der obenstehenden Definitionen ist jede Arylgruppe vom Begriff "aromatisches Ringsystem"

umfasst, und jede Heteroarylgruppe ist vom Begriff "heteroaromatisches Ringsystem" umfasst.

Unter einem aromatischen Ringsystem mit 6 bis 40 aromatischen Ringatomen oder einem heteroaromatischen Ringsystem mit 5 bis 40 aromatischen Ringatomen, werden insbesondere Gruppen verstanden, die abgeleitet sind von den oben unter Arylgruppen und Heteroarylgruppen genannten Gruppen sowie von Biphenyl, Terphenyl, Quaterphenyl, Fluoren, Spirobifluoren, Dihydrophenanthren, Dihydropyren, Tetrahydropyren, Indenofluoren, Truxen, Isotruxen, Spirotruxen, Spiroisotruxen, Indenocarbazol, oder von Kombinationen dieser Gruppen.

Im Rahmen der vorliegenden Erfindung werden unter einer geradkettigen Alkylgruppe mit 1 bis 20 C-Atomen bzw. einer verzweigten oder cyclischen Alkylgruppe mit 3 bis 20 C-Atomen bzw. einer Alkenyl- oder Alkinylgruppe mit 2 bis 40 C-Atomen, in der auch einzelne H-Atome oder $CH_2$-Gruppen durch die oben bei der Definition der Reste genannten Gruppen substituiert sein können, bevorzugt die Reste Methyl, Ethyl, n-Propyl, i-Propyl, n-Butyl, i-Butyl, s-Butyl, t-Butyl, 2-Methylbutyl, n-Pentyl, s-Pentyl, Cyclopentyl, neoPentyl, n-Hexyl, Cyclohexyl, neo-Hexyl, n-Heptyl, Cycloheptyl, n-Octyl, Cyclooctyl, 2-Ethylhexyl, Trifluormethyl, Pentafluorethyl, 2,2,2-Trifluorethyl, Ethenyl, Propenyl, Butenyl, Pentenyl, Cyclopentenyl, Hexenyl, Cyclohexenyl, Heptenyl, Cycloheptenyl, Octenyl, Cyclooctenyl, Ethinyl, Propinyl, Butinyl, Pentinyl, Hexinyl oder Octinyl verstanden.

Unter einer Alkoxy- oder Thioalkylgruppe mit 1 bis 20 C-Atomen, in der auch einzelne H-Atome oder $CH_2$-Gruppen durch die oben bei der Definition der Reste genannten Gruppen substituiert sein können, werden bevorzugt Methoxy, Trifluormethoxy, Ethoxy, n-Propoxy, i-Propoxy, n-Butoxy, i-Butoxy, s-Butoxy, t-Butoxy, n-Pentoxy, s-Pentoxy, 2-Methylbutoxy, n-Hexoxy, Cyclohexyloxy, n-Heptoxy, Cycloheptyloxy, n-Octyloxy, Cyclooctyloxy, 2-Ethylhexyloxy, Pentafluorethoxy, 2,2,2-Trifluorethoxy, Methylthio, Ethylthio, n-Propylthio, i-Propylthio, n-Butylthio, i-Butylthio, s-Butylthio, t-Butylthio, n-Pentylthio, s-Pentylthio, n-Hexylthio, Cyclohexylthio, n-Heptylthio, Cycloheptylthio, n-Octylthio, Cyclooctylthio, 2-Ethylhexylthio, Trifluormethylthio, Pentafluorethylthio, 2,2,2-Trifluorethylthio, Ethenylthio, Propenylthio, Butenylthio, Pentenylthio, Cyclopentenylthio, Hexenylthio, Cyclohexenylthio, Heptenylthio, Cycloheptenylthio, Octenylthio, Cyclooctenylthio, Ethinylthio, Propinylthio, Butinylthio, Pentinylthio, Hexinylthio, Heptinylthio oder Octinylthio verstanden.

Unter der Formulierung, dass zwei oder mehr Reste miteinander einen Ring bilden können, soll im Rahmen der vorliegenden Anmeldung unter anderem verstanden werden, dass die beiden Reste miteinander durch eine chemische Bindung verknüpft sind. Weiterhin soll unter der oben genannten Formulierung aber auch verstanden werden, dass für den Fall, dass einer der beiden Reste Wasserstoff darstellt, der zweite Rest unter Bildung eines Rings an die Position, an die das Wasserstoffatom gebunden war, bindet.

Bevorzugt ist $R^1$ bei jedem Auftreten gleich oder verschieden gewählt aus H, D, F, Cl, Br, CN, $NO_2$, $Si(R^2)_3$, $N(R^2)_2$, geradkettigen Alkyl- oder Alkoxygruppen mit 1 bis 20 C-Atomen, verzweigten oder cyclischen Alkyl- oder Alkoxygruppen mit 3 bis 20 C-Atomen, aromatischen Ringsystemen mit 6 bis 40 aromatischen Ringatomen, und heteroaromatischen Ringsystemen mit 5 bis 40 aromatischen Ringatomen; wobei die genannten Alkyl- und Alkoxygruppen, die genannten aromatischen Ringsysteme und die genannten heteroaromatischen Ringsysteme jeweils mit Resten $R^2$ substituiert sind; und wobei in den genannten Alkyl- oder Alkoxygruppen eine oder mehrere $CH_2$-Gruppen durch -C=C-, $-R^2C=CR^2-$, $Si(R^2)_2$, C=O, $C=NR^2$, $-NR^2-$, -O-, -S-, -C(=O)O- oder $-C(=O)NR^2-$ ersetzt sein können.

Bevorzugt ist $R^2$ bei jedem Auftreten gleich oder verschieden gewählt aus H, D, F, Cl, Br, CN, $NO_2$, $Si(R^3)_3$, $N(R^3)_2$, geradkettigen Alkyl- oder Alkoxygruppen mit 1 bis 20 C-Atomen, verzweigten oder cyclischen Alkyl- oder Alkoxygruppen mit 3 bis 20 C-Atomen, aromatischen Ringsystemen mit 6 bis 40 aromatischen Ringatomen, und heteroaromatischen Ringsystemen mit 5 bis 40 aromatischen Ringatomen; wobei die genannten Alkyl- und Alkoxygruppen, die genannten aromatischen Ringsysteme und die genannten heteroaromatischen Ringsysteme jeweils mit Resten $R^3$ substituiert sind; und wobei in den genannten Alkyl- oder Alkoxygruppen eine oder mehrere $CH_2$-Gruppen durch -C=C-, $-R^3C=CR^3-$, $Si(R^3)_2$, C=O, $C=NR^3$, $-NR^3-$, -O-, -S-, -C(=O)O- oder $-C(=O)NR^3-$ ersetzt sein können.

Bevorzugt ist in den Formeln (L-I) bis (L-III) jeweils mindestens eine Gruppe $R^1$ vorhanden, welche gewählt ist aus F, CI, Br, CN, $NO_2$ und Alkylgruppen mit 1 bis 20 C-Atomen, welche mindestens einen Substituenten gewählt aus F, CI, CN und $NO_2$ aufweisen. Unter den genannten Gruppen besonders bevorzugt sind F, CI, CN und $CF_3$.

Besonders bevorzugt sind eine, zwei, oder drei solcher Gruppen $R^1$ vorhanden, ganz besonders bevorzugt drei.

Bevorzugt ist in Formel (L-IV) mindestens eine Gruppe $R^2$ vorhanden, welche gewählt ist aus F, CI, Br, CN, $NO_2$ und Alkylgruppen mit 1 bis 20 C-Atomen, welche mindestens einen Substituenten gewählt aus F, CI, CN und $NO_2$ aufweisen. Unter den genannten Gruppen besonders bevorzugt sind F, CI, CN und $CF_3$. Besonders bevorzugt sind eine, zwei, oder drei solcher Gruppen $R^2$ vorhanden, ganz besonders bevorzugt drei. Bevorzugte Liganden L sind gewählt aus fluorierten Benzoesäure-Derivaten, fluorierten oder nicht-fluorierten Phenylessigsäurederivaten und fluorierten oder nicht-fluorierten Essigsäurederivaten.

Bevorzugte fluorierte Benzoesäure-Derivate sind: 2-(Trifluoromethyl)benzoesäure; 3,5-Difluorobenzoesäure; 3-Hydroxy-2,4,6-triiodobenzoesäure; 3-Fluoro-4-methylbenzoesäure; 3-(Trifluoromethoxy)benzoesäure; 4-(Trifluoromethoxy)benzoesäure; 4-Chloro-2 ,5-difluorobenzoesäure; 2-Chloro-4 ,5-difluorobenzoesäure; 2,4,5-Trifluorobenzoesäure; 2-Fluorobenzoesäure; 4-Fluorobenzoesäure; 2,3,4-Trifluorobenzoesäure; 2,3,5-Trifluorobenzoesäure; 2,3-Difluorobenzoesäure; 2,4-Bis(trifluoromethyl)benzoesäure; 2,4-Difluorobenzoesäure; 2,5-Difluorobenzoesäure; 2,6-Bis-(trifluoromethyl)benzoesäure; 2,6-Difluorobenzoesäure; 2-Chloro-6-fluorobenzoesäure; 2-Fluoro-4-(trifluoromethyl)benzoesäure; 2-Fluoro-5-(trifluoromethyl)benzoesäure; 2-Fluoro-6-(trifluoromethyl)benzoesäure; 3,4, 5-Trifluorobenzoesäure; 3,4-Difluorobenzoesäure; 3 ,5-Bis(trifluoromethyl)benzoesäure; 3- (Trifluoromethyl)benzoesäure; 3-Chloro-4-fluorobenzoesäure; 3-Fluoro-5- (trifluoromethyl)benzoesäure; 3-Fluorobenzoesäure; 4-Fluoro-2- (trifluoromethyl)benzoesäure; 4-Fluoro-3-(trifluoromethyl)benzoesäure; 5-Fluoro-2-methylbenzoesäure; 2-(Trifluoromethoxy)benzoesäure; 2,3,5-Trichlorobenzoesäure; 4-(Trifluoromethyl)benzoesäure; Pentafluorobenzoesäure; und 2,3,4,5-Tetrafluorobenzoesäure. Am stärksten bevorzugt ist 2,4-Bis(trifluoromethyl)benzoesäure.

Bevorzugte fluorierte oder nicht-fluorierte Phenylessigsäurederivate sind: 2-Fluor-Phenylessigsäure; 3-Fluor-Phenylessigsäure; 4-Fluor-Phenylessigsäure; 2 ,3-Difluor-Phenylessigsäure; 2,4-Difluor-Phenylessigsäure; 2,6-Difluor-Phenylessigsäure; 3,4-Difluor-Phenylessigsäure; 3,5-Difluor-Phenylessigsäure; Pentafluor-Phenylessigsäure; 2-Chloro-6-fluor-Phenylessigsäure; 2-Chloro-3,6-difluor-Phenylessigsäure; 3-Chloro-2,6-difluor-Phenylessigsäure; 3-Chloro-4-fluor-Phenylessigsäure; 5-Chloro-2-fluor-Phenylessigsäure; 2,3,4-Trifluor-Phenylessigsäure; 2,3,5-Trifluor-Phenylessigsäure; 2,3,6-Trifluor-Phenylessigsäure; 2,4,5-Trifluor-Phenylessigsäure; 2,4,6-Trifluor-Phenylessigsäure; 3,4,5-Trifluor-Phenylessigsäure; 3-Chloro-2-fluor-Phenylessigsäure; 6-Fluor-Phenylessigsäure; 4-Chloro-2-fluor-Phenylessigsäure; 2-Chloro-4-fluor-Phenylessigsäure.

Bevorzugte fluorierte oder nicht-fluorierte Essigsäurederivate sind: Difluoroessigsäure; Trifluoroessigsäure; Chlorodifluoroessigsäure; (3-Chlorophenyl)-difluoroessigsäure; (3,5-Difluorophenyl)-difluoroessigsäure; (4-Butylphenyl) difluoroessigsäure; (4-tert-Butylphenyl)difluoroessigsäure; (3 ,4-Dimethylphenyl )-difluoroessigsäure; (3-Chloro-4-fluorophenyl)-difluoroessigsäure; (4-Chlorophenyl)-difluoroessigsäure; 2-Biphenyl-3', 5'-difluoroessigsäure; 3-Biphenyl-3',5'-difluoroessigsäure; 4-Biphenyl-3 ', 5 '-difluoroessigsäure; 2-Biphenyl-3 ',4 '-difluoroessigsäure; 3-Biphenyl-3 ',4 '-difluoroessigsäure; 4-Biphenyl-3 ' ,4 '-difluoroessigsäure und 2,2-Difluoro-propionsäure und deren höhere Homologe.

Die in der oben genannten Liste in protonierter Form genannten Liganden L liegen in der Verbindung K1 bevorzugt in deprotonierter Form vor.

Bevorzugt grenzt die Schicht B direkt kathodenseitig an die Schicht A an. Bevorzugt ist die Schicht B eine lochtransportierende Schicht. Die Schicht B hat bevorzugt eine Dicke von 5 nm bis 100 nm, besonders bevorzugt von 10 nm bis 50 nm, ganz besonders bevorzugt von 10 bis 30 nm.

Die Schicht B enthält bevorzugt die Verbindung K2 als p-Dotand. Unter einem p-Dotanden wird dabei eine Verbindung verstanden, die als Mindermengenkomponente einer Hauptkomponente hinzugefügt wird, wodurch die Lochleitfähigkeit einer Schicht enthaltend die Mindermengenkomponente und die Hauptkomponente deutlich erhöht wird.

Die Verbindung K2 bildet mit der Verbindung H in der Schicht B bevorzugt ein Lewissäure- Lewisbase-Paar, wobei die Verbindung K2 als Lewissäure wirkt und die Verbindung H als Lewis-Base. Ohne an diese Theorie gebunden zu sein, wird angenommen, dass dies dadurch geschieht, dass ein freies Elektronenpaar der Verbindung H in Wechselwirkung mit dem Bi-Atom der Verbindung K2 tritt.

Die Schicht B kann zusätzlich zu der Verbindung H und der Verbindung K2 weitere Verbindungen enthalten. Bevorzugt besteht sie aus Verbindung H und Verbindung K2, wobei dies nicht ausschließt, dass Verunreinigungen in geringem Umfang in der Schicht vorliegen. Gemäß einer bevorzugten Ausführungsform enthält die Schicht B genau eine Verbindung H und genau eine Verbindung K2. Gemäß einer alternativen bevorzugten Ausführungsform enthält die Schicht B genau zwei verschiedene Verbindungen H und genau eine Verbindung K2.

Die Verbindung K2 liegt bevorzugt als Dotand in der Schicht B vor. Es ist bevorzugt, dass die Schicht B die Verbindung K2 in einer Konzentration von 0.1 % bis 20 %, besonders bevorzugt von 0.5% bis 12 %, ganz besonders bevorzugt von 1% bis 10 % und am stärksten bevorzugt von 2% bis 8 % enthält. Die Prozentangaben sind dabei bevorzugt Vol.-%.

Die Verbindung K2 ist bevorzugt gewählt aus Koordinationsverbindungen enthaltend mindestens einen Liganden und mindestens ein Bi-Atom. Das Bismut-Atom liegt bevorzugt in der Oxidationsstufe +3 vor, als Bi(III). Das Bismut-Atom kann jedoch gemäß alternativen bevorzugten Ausführungsformen auch in der Stufe +2 oder +5 vorliegen.

Die Verbindung K2 ist bevorzugt eine starke Lewis-Säure. Unter einer starken Lewis-Säure wird insbesondere eine Verbindung verstanden, die eine hohe Bereitschaft hat, ein Elektronenpaar eines anderen Atoms aufzunehmen.

Die Verbindung K2 kann ein mononuklearer Komplex von Bismut sein, ein binuklearer Komplex von Bismut oder ein polynuklearer Komplex von Bismut. Dabei ist es möglich, dass die Verbindung K1 ein mononuklearer Komplex von Bismut ist, sofern sie in der Gasphase vorliegt, und ein polynuklearer Komplex von Bismut ist, wenn sie in der Festkörperphase vorliegt. Das heißt, die Verbindung K2 kann, je nach Aggregatzustand, polymerisieren oder depolymerisieren.

Bevorzugt weist die Verbindung K2 als Koordinationsverbindung mindestens einen Liganden L auf, der eine organische Verbindung ist. Der Ligand L ist bevorzugt gewählt aus einzähnigen, zweizähnigen und dreizähnigen Liganden, besonders bevorzugt aus einzähnigen Liganden. Weiterhin bevorzugt ist der Ligand L negativ geladen, bevorzugt dreifach, zweifach oder einfach negativ geladen, besonders bevorzugt einfach negativ geladen.

Die Liganden L der Verbindung K2 können gleich oder verschieden gewählt sein. Bevorzugt sind sie gleich gewählt.

Die an das Bismutatom bindende Gruppe des Liganden L in der Verbindung K2 ist bevorzugt gewählt aus Carbonsäuregruppen, Thiocarbonsäuregruppen, im Besonderen Thiolsäuregruppen, Thionsäuregruppen und Dithiolsäuregruppen, Carbonsäureamidgruppen und Carbonsäureimidgruppen, besonders bevorzugt aus Carbonsäuregruppen. Bevorzugt sind Liganden enthaltend mindestens eine Gruppe gewählt aus Carbonsäuregruppen, Thiocarbonsäuregruppen, im Besonderen Thiolsäuregruppen, Thionsäuregruppen und

Dithiolsäuregruppen, Carbonsäureamidgruppen und Carbonsäureimidgruppen, die zusätzlich mindestens eine elektronenziehende Gruppe aufweisen. Besonders bevorzugt sind Liganden enthaltend mindestens eine Carbonsäuregruppe, die zusätzlich zur Carbonsäuregruppe mindestens eine weitere elektronenziehende Gruppe aufweisen. Die elektronenziehende Gruppe ist bevorzugt gewählt aus F, Cl, Br, I, CN, $NO_2$ und Alkylgruppen mit 1 bis 20 C-Atomen, welche mindestens einen Substituenten gewählt aus F, Cl, CN und $NO_2$ aufweisen, besonders bevorzugt aus F, Cl, CN und $CF_3$. Besonders bevorzugt sind im Liganden L eine, zwei, oder drei solcher weiterer elektronenziehender Gruppen vorhanden, ganz besonders bevorzugt drei.

Bevorzugt entspricht der Ligand L in der Verbindung K2 einer der Formeln (L-I), (L-II), (L-III) und (L-IV), wie oben definiert, unter Einbeziehung aller bevorzugten Ausführungsformen.

Bevorzugte Liganden L in der Verbindung K2 sind gewählt aus fluorierten Benzoesäure-Derivaten, fluorierten oder nicht-fluorierten Phenylessigsäurederivaten und fluorierten oder nicht-fluorierten Essigsäurederivaten. Bevorzugte fluorierte Benzoesäure-Derivate, bevorzugte fluorierte und nicht-fluorierte Phenylessigsäurederivate und bevorzugte fluorierte und nicht-fluorierte Essigsäurederivate sind wie in den obenstehenden Listen angegeben. Die Liganden liegen in der Verbindung K2 bevorzugt in deprotonierter Form vor.

Verbindung K1 und K2 können gleich oder verschieden sein, bevorzugt sind sie gleich.

Die Verbindung H ist bevorzugt eine lochtransportierende Verbindung. Besonders bevorzugt ist sie gewählt aus aromatischen Aminen. Unter aromatischem Amin wird dabei eine Verbindung verstanden, die drei aromatische Gruppen gebunden an ein Stickstoffatom enthält. Bevorzugt sind die drei aromatischen Gruppen dabei nicht miteinander verbunden. Vom Begriff "aromatische Gruppe" sind dabei sowohl heteroaromatische als auch aromatische Gruppen, die kein Heteroatom im Ringsystem enthalten, umfasst. Bevorzugt enthält die Verbindung H eine einzige Aminogruppe. Weiterhin ist es bevorzugt, dass die Verbindung H keine kondensierte Arylgruppe mit mehr als 10 aromatischen Ringatomen und keine kondensierte Heteroarylgruppe mit mehr als 14 aromatischen Ringatomen enthält.

Die Verbindung H hat bevorzugt ein HOMO von -5.1 eV bis -5.7 eV, bevorzugt -5.2 eV bis -5.7 eV, bestimmt mittels Cyclovoltammetrie. Dabei wird das folgende Verfahren verwendet: Bei dieser Methode wird die Spannung kontinuierlich erhöht oder erniedrigt, bis das Umkehrpotential erreicht wird und man wieder zur Ausgangsspannung zurückkehrt. Während dieser Zeit wird der Stromfluss gemessen. Ansteigender Strom bedeutet, dass ein Redoxvorgang abläuft. Da die Redoxvorgänge diffusionskontrolliert ablaufen, fällt der Strom nach einiger Zeit wieder ab, sodass ein Peak entsteht. Nach Erreichen des Umkehrpotentials wird auf dem "Rückweg" die elektrochemisch erzeugte Spezies wieder in ihren Ursprungszustand versetzt, wenn eine reversible Reaktion vorliegt. Der Mittelwert der beiden Peakpotentiale stellt das Halbstufenpotential dar.

Es wird standardmäßig DCM als Lösungsmittel verwendet. Da das Potential der Referenzelektrode schwanken kann, wird als interner Standard Ferrocen (Fc) bzw. Decamethylferrocen (dmFc) zugegeben; so ist eine Referenzierung auf Ferrocen/ Ferrocenium möglich.

Das HOMO wird dabei wie folgt berechnet:

$$\text{HOMO (eV)} = -4.8\text{eV}-(E_{\text{Probenpeak}} - E_{\text{Referenzpeak}}) - (\text{Offset}_{\text{dmFc/Fc}})$$

wobei gilt:

$E_{\text{Probenpeak}}$ = Halbstufenpotential der Verbindung in eV
$E_{\text{Referenzpeak}}$ = Halbstufenpotential der Referenzverbindung in eV
$\text{Offset}_{\text{dmFc/Fc}}$ = Potentialdifferenz zwischen Halbstufenpotential von Fc und dmFc in eV.

Bevorzugt entspricht die Verbindung H der folgenden Formel

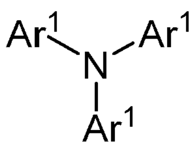

Formel (H),

wobei für die auftretenden Gruppen gilt:

> $Ar^1$ ist bei jedem Auftreten gleich oder verschieden gewählt aus aromatischen Ringsystemen mit 6 bis 60 aromatischen Ringatomen, die mit Resten $R^4$ substituiert sind, und heteroaromatischen Ringsystemen mit 5 bis 60 aromatischen Ringatomen, die mit Resten $R^4$ substituiert sind; dabei können Gruppen $Ar^1$ untereinander über Reste $R^4$ verbunden sein;
>
> $R^4$ ist bei jedem Auftreten gleich oder verschieden gewählt aus H, D, F, Cl, Br, I, $C(=O)R^5$, CN, $Si(R^5)_3$, $N(R^5)_2$, $P(=O)(R^5)_2$, $OR^5$, $S(=O)R^5$, $S(=O)_2R^5$, geradkettigen Alkyl- oder Alkoxygruppen mit 1 bis 20 C-Atomen, verzweigten oder cyclischen Alkyl- oder Alkoxygruppen mit 3 bis 20 C-Atomen, Alkenyl- oder Alkinylgruppen mit 2 bis 20 C-Atomen, aromatischen Ringsystemen mit 6 bis 40 aromatischen Ringatomen, und heteroaromatischen Ringsystemen mit 5 bis 40 aromatischen Ringatomen; wobei zwei oder mehr Reste $R^4$ miteinander verknüpft sein können und einen Ring bilden können; wobei die genannten Alkyl-, Alkoxy-, Alkenyl- und Alkinylgruppen und die genannten aromatischen Ringsysteme und heteroaromatischen Ringsysteme jeweils mit Resten $R^5$ substituiert sind; und wobei eine oder mehrere $CH_2$-Gruppen in den genannten Alkyl-, Alkoxy-, Alkenyl- und Alkinylgruppen durch $-R^5C=CR^5-$, -C≡C-, $Si(R^5)_2$, C=O, $C=NR^5$, -C(=O)O-, $-C(=O)NR^5-$, $NR^5$, $P(=O)(R^5)$, -O-, -S-, SO oder $SO_2$ ersetzt sein können;
>
> $R^5$ ist bei jedem Auftreten gleich oder verschieden gewählt aus H, D, F, Cl, Br, I, CN, Alkyl- oder Alkoxygruppen mit 1 bis 20 C-Atomen, Alkenyl- oder Alkinylgruppen mit 2 bis 20 C-Atomen, aromatischen Ringsystemen mit 6 bis 40 aromatischen Ringatomen und heteroaromatischen Ringsystemen mit 5 bis 40 aromatischen Ringatomen; wobei zwei oder mehr Reste $R^5$ miteinander verknüpft sein können und einen Ring bilden können; und wobei die genannten Alkyl-, Alkoxy-, Alkenyl- und Alkinylgruppen, aromatischen Ringsysteme und heteroaromatischen Ringsysteme mit einem oder mehreren Resten gewählt aus F und CN substituiert sein können.

Bevorzugt ist mindestens eine Gruppe $Ar^1$ in der Verbindung der Formel (H) gewählt aus Phenyl, Biphenyl, Terphenyl, Quaterphenyl, Naphthyl, Phenanthryl, Fluoranthenyl, Fluorenyl, Indenofluorenyl, Spirobifluorenyl, Furanyl, Benzofuranyl, Isobenzofuranyl, Dibenzofuranyl, Thiophenyl, Benzothiophenyl, Isobenzothiophenyl, Dibenzothiophenyl, Indolyl, Isoindolyl, Carbazolyl, Indolocarbazolyl, Indenocarbazolyl, Pyridyl, Chinolinyl, Isochinolinyl, Acridyl, Phenanthridyl, Benzimidazolyl, Pyrimidyl, Pyrazinyl, und Triazinyl, die jeweils mit Resten $R^4$ substituiert sind; besonders bevorzugt gewählt aus Phenyl, Biphenyl, Terphenyl, Quaterphenyl, Naphthyl, Phenanthryl, Fluoranthenyl, Fluorenyl, Indenofluorenyl, Spirobifluorenyl, Dibenzofuranyl, Dibenzothiophenyl, Carbazolyl, Acridyl, und Phenanthridyl, die jeweils mit Resten $R^4$ substituiert sind.

Bevorzugt ist $R^4$ bei jedem Auftreten gleich oder verschieden gewählt aus H, D, F, CN, $Si(R^5)_3$, $N(R^5)_2$, geradkettigen Alkyl- oder Alkoxygruppen mit 1 bis 20 C-Atomen, verzweigten oder cyclischen Alkyl- oder Alkoxygruppen mit 3 bis 20 C-Atomen, aromatischen Ringsystemen mit 6 bis 40 aromatischen Ringatomen, und heteroaromatischen Ringsystemen mit 5 bis 40 aromatischen Ringatomen; wobei die genannten Alkyl- und Alkoxygruppen, die genannten aromatischen Ringsysteme und die genannten heteroaromatischen Ringsysteme jeweils mit Resten $R^5$ substituiert sind; und wobei in den genannten Alkyl- oder Alkoxygruppen eine oder mehrere $CH_2$-Gruppen durch -C≡C-, $-R^5C=CR^5-$, $Si(R^5)_2$, C=O, $C=NR^5$, $-NR^5-$, -O-, -S-, -C(=O)O- oder $-C(=O)NR^5-$ ersetzt sein können.

Bevorzugt entspricht Verbindung H einer der folgenden Formeln:

| | |
|---|---|
| 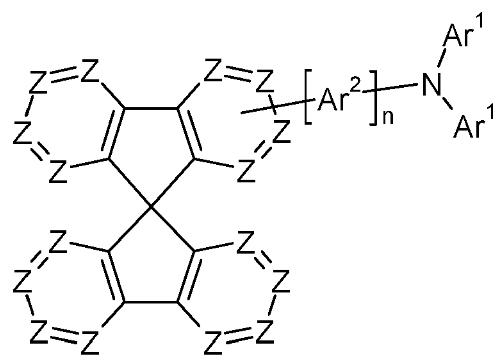 | 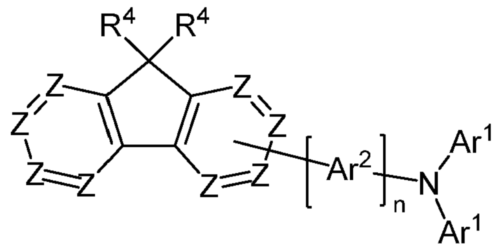 |
| Formel (H-I) | Formel (H-II) |

(fortgesetzt)

| | |
|---|---|
| 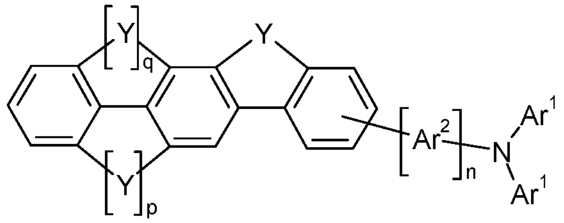 | |
| Formel (H-III) | |

wobei die freien Positionen in Formel (H-III) jeweils mit einem Rest $R^4$ substituiert sind, und wobei für die auftretenden Gruppen und Indices gilt:

Z ist bei jedem Auftreten gleich oder verschieden $CR^4$ oder N;

Y ist bei jedem Auftreten gleich oder verschieden O, S, $C(R^4)_2$, $Si(R^4)_2$, $PR^4$, $NR^4$, $C(R^4)_2$-$C(R^4)_2$, oder $CR^4$=$CR^4$;

$Ar^1$ ist definiert wie oben und entspricht bevorzugt den oben angegebenen bevorzugten Ausführungsformen;

$Ar^2$ ist ein aromatisches Ringsystem mit 6 bis 20 aromatischen Ringatomen, das mit Resten $R^4$ substituiert ist, oder ein heteroaromatisches Ringsystem mit 5 bis 20 aromatischen Ringatomen, das mit Resten $R^4$ substituiert ist;

n,p,q ist gleich oder verschieden 0 oder 1.

Unter den Formeln (H-I) bis (H-III) ist die Formel (H-I) bevorzugt.

Es ist bevorzugt, dass in einem Ring nicht mehr als drei Gruppen Z gleich N sind. Bevorzugt sind nicht mehr als 2 benachbarte Gruppen Z gleich N. Besonders bevorzugt ist Z gleich $CR^4$.

Es ist bevorzugt, dass Y bei jedem Auftreten gleich oder verschieden O, S, $NR^4$ oder $(CR^4)_2$ ist, besonders bevorzugt $(CR^4)_2$.

Bevorzugt ist mindestens einer der Indices p und q gleich 1. Bevorzugt ist die Summe der Indices p und q gleich 1.

Bevorzugt umfasst $Ar^2$ mindestens eine Gruppe gewählt aus Benzol, Naphthalin, Phenanthren, Fluoranthen, Biphenyl, Terphenyl, Quaterphenyl, Fluoren, Indenofluoren, Spirobifluoren, Furan, Benzofuran, Isobenzofuran, Dibenzofuran, Thiophen, Benzothiophen, Isobenzothiophen, Dibenzothiophen, Indol, Isoindol, Carbazol, Indolocarbazol, Indenocarbazol, Pyridin, Chinolin, Isochinolin, Acridin, Phenanthridin, Benzimidazol, Pyrimidin, Pyrazin, und Triazin, wobei die genannten Gruppen mit Resten $R^4$ substituiert sind. Bevorzugt besteht $Ar^2$ ausschließlich aus einer der oben genannten Gruppen oder aus einer Kombination von mehreren der oben genannten Gruppen.

Bevorzugte Ausführungsformen der oben genannten Formeln (H-I) bis (H-III) entsprechen den folgenden Formeln

| | |
|---|---|
| 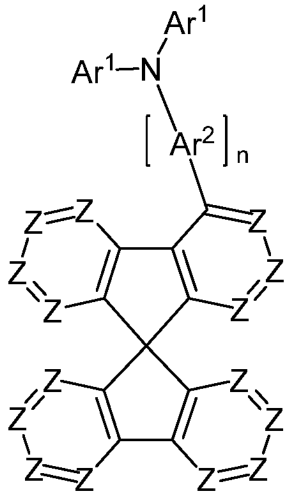 | 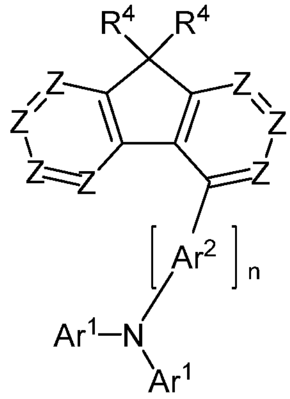 |
| Formel (H-I-I) | Formel (H-II-I) |
| 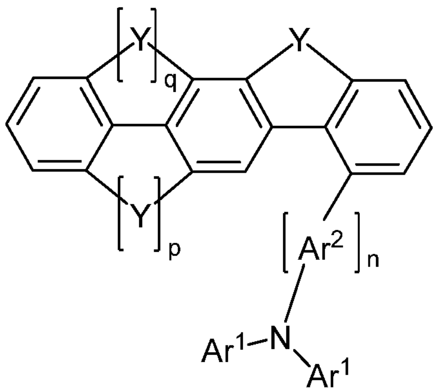 | |
| Formel (H-III-I) | |

wobei die freien Positionen in Formel (H-III-I) jeweils mit einem Rest $R^4$ substituiert sind, und wobei die auftretenden Gruppen und Indices definiert sind wie oben, und bevorzugt ihren oben angegebenen bevorzugten Ausführungsformen entsprechen. Unter den Formeln (H-I-I) bis (H-III-I) ist die Formel (H-I-I) bevorzugt.

Bevorzugte Ausführungsformen von Verbindungen der Formel (H) sind die folgenden Verbindungen:

| | | |
|---|---|---|
| 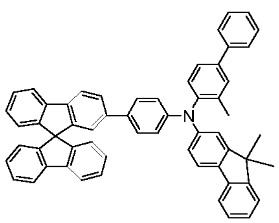 | 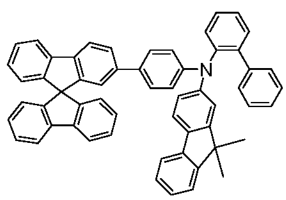 | 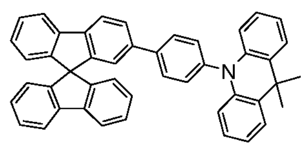 |
| 1 | 2 | 3 |
| 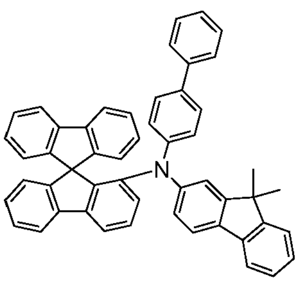 | 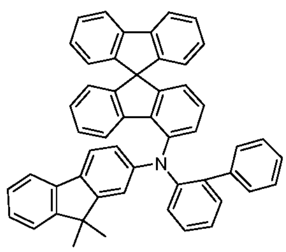 | 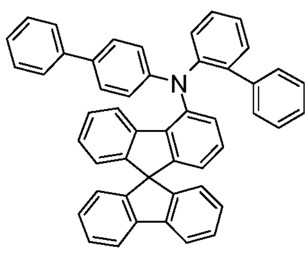 |

(fortgesetzt)

| | | |
|---|---|---|
| 4 | 5 | 6 |
| 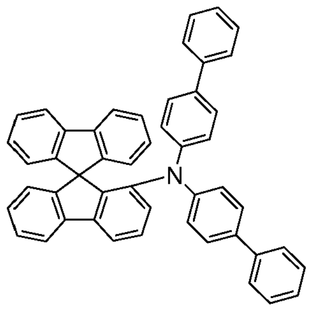 | 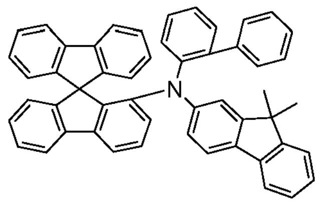 | 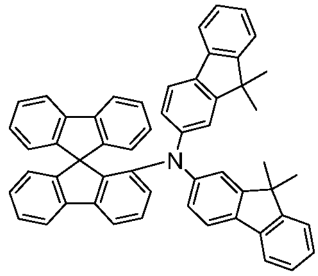 |
| 7 | 8 | 9 |
| 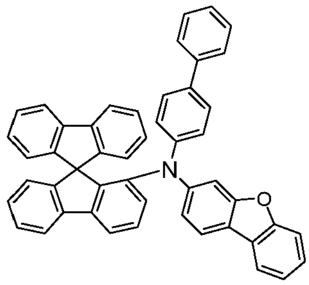 | 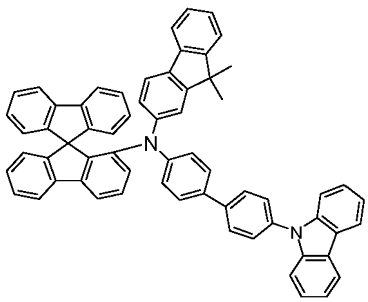 | 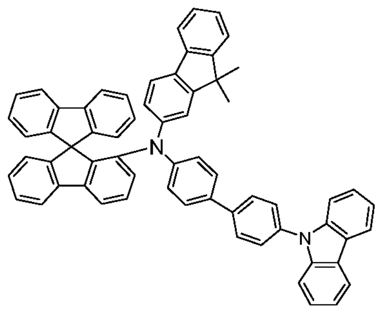 |
| 10 | 11 | 12 |
| 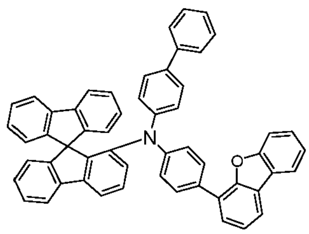 | 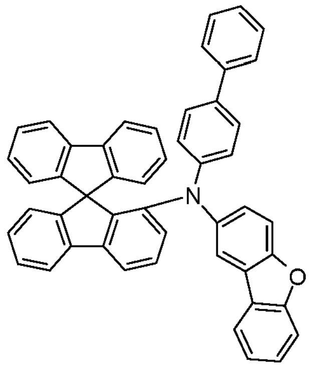 | 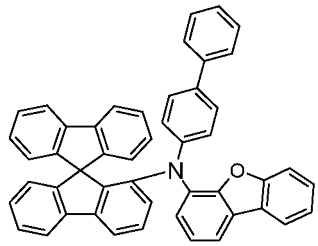 |
| 13 | 14 | 15 |
| 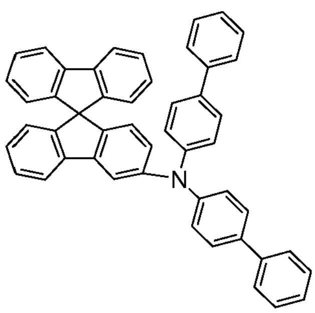 | 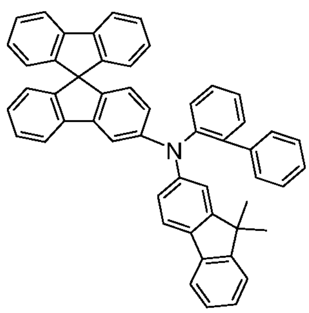 | 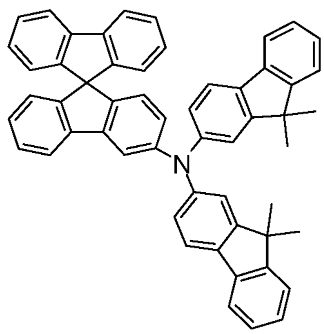 |
| 16 | 17 | 18 |

(fortgesetzt)

| | | |
|---|---|---|
| 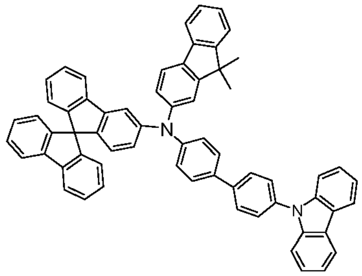 | 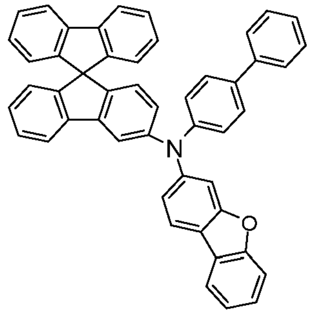 | 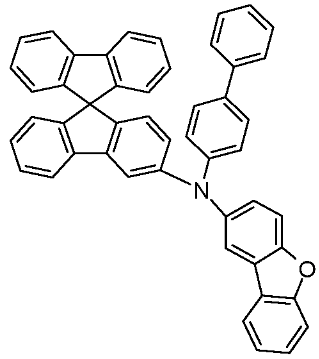 |
| 19 | 20 | 21 |
| 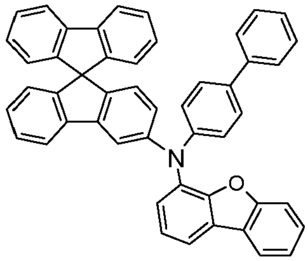 | 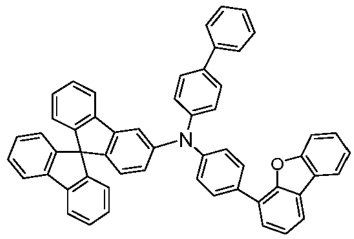 | 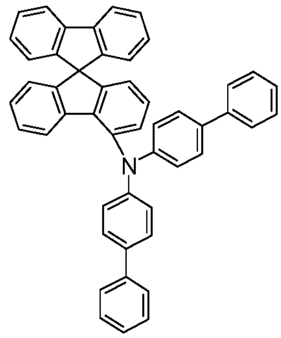 |
| 22 | 23 | 24 |
| 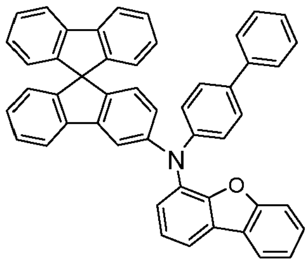 | 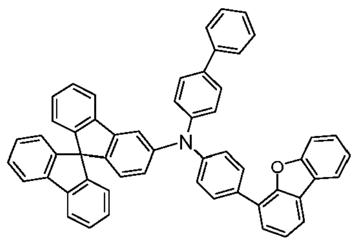 | 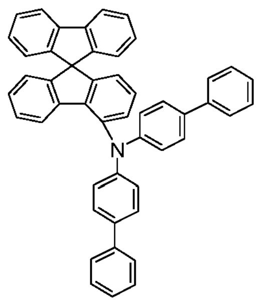 |
| 25 | 26 | 27 |
| 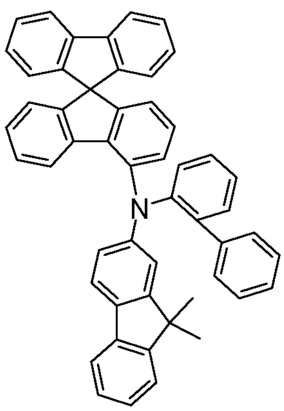 | 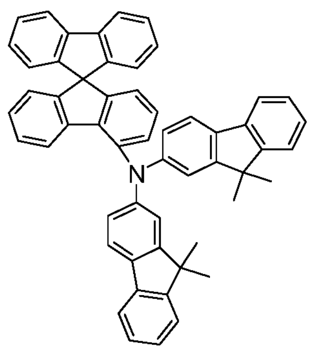 | 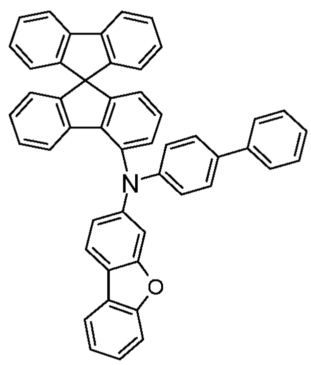 |
| 28 | 29 | 30 |

(fortgesetzt)

| | | |
|---|---|---|
| 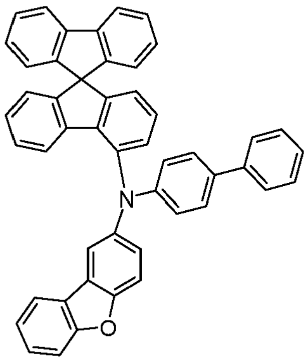 | 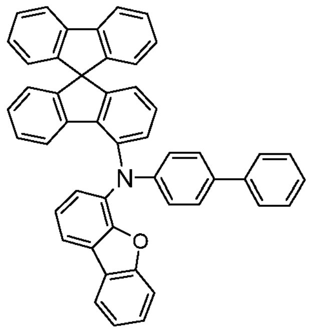 | 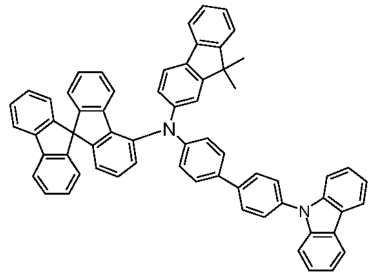 |
| 31 | 32 | 33 |
| 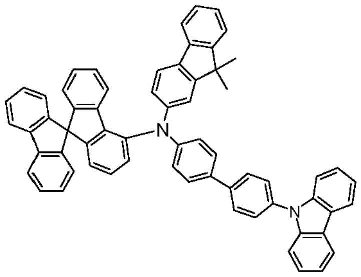 | 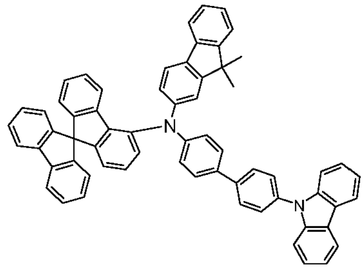 | 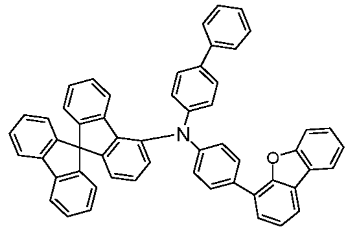 |
| 34 | 35 | 36 |
| 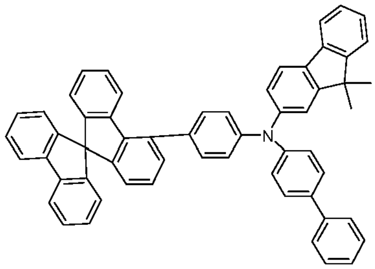 | | 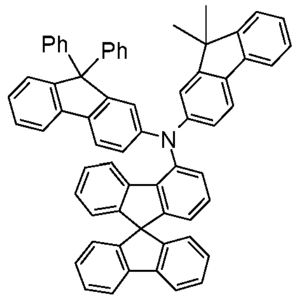 |
| 37 | | 38 |
| 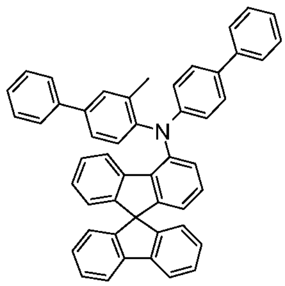 | 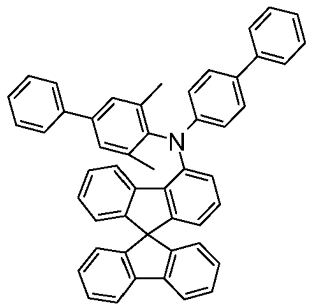 | |
| 39 | | 40 |
| 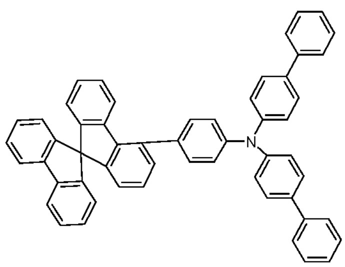 | 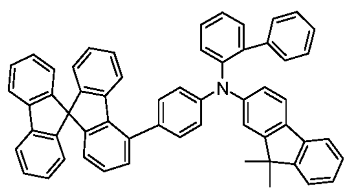 | 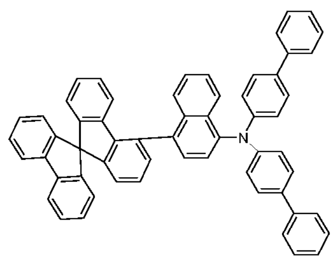 |

(fortgesetzt)

| 41 | 42 | 43 |
| --- | --- | --- |
| 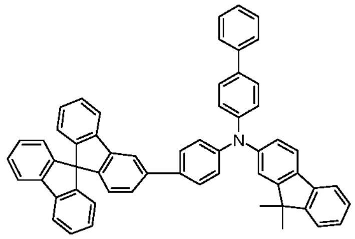 | 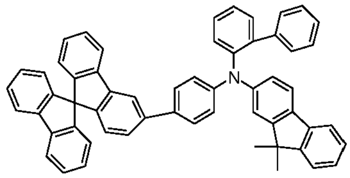 | 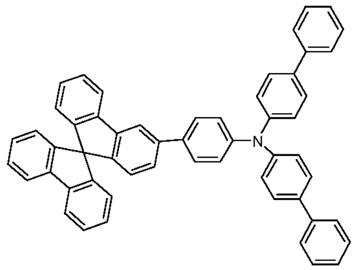 |
| 44 | 45 | 46 |
| 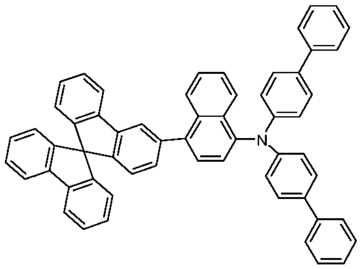 | 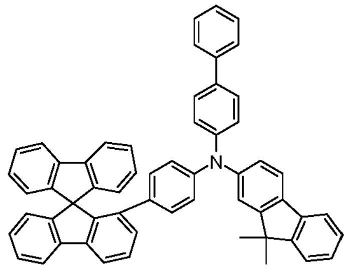 | 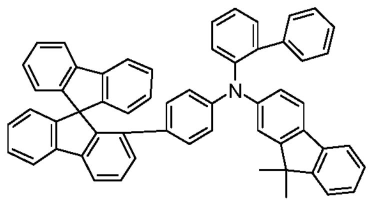 |
| 47 | 48 | 49 |
| 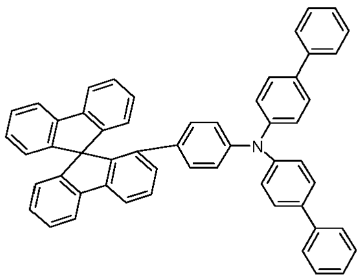 | 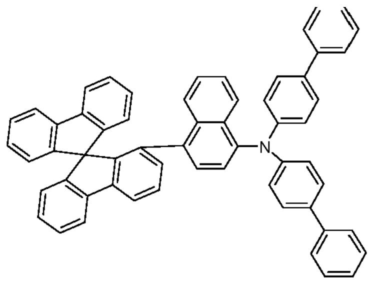 | 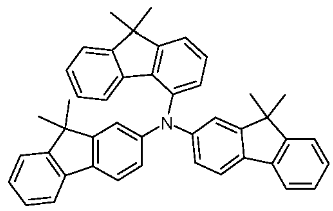 |
| 50 | 51 | 52 |
| 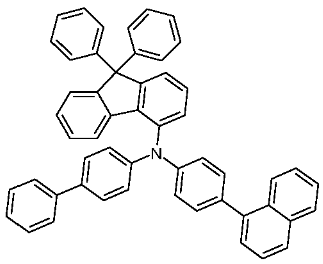 | 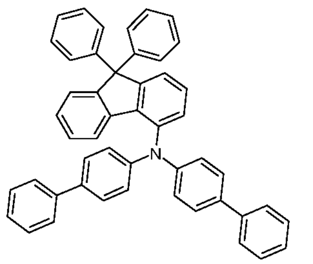 | 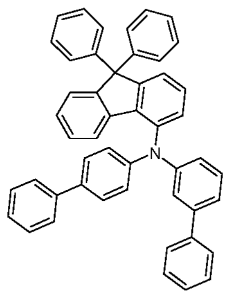 |
| 53 | 54 | 55 |
| 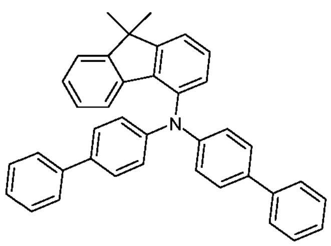 | 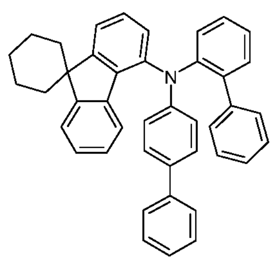 | 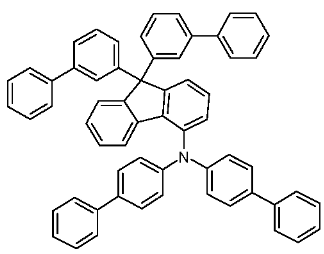 |
| 56 | 57 | 58 |

(fortgesetzt)

| | | |
|---|---|---|
| 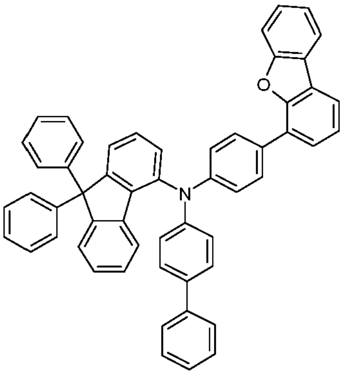 | 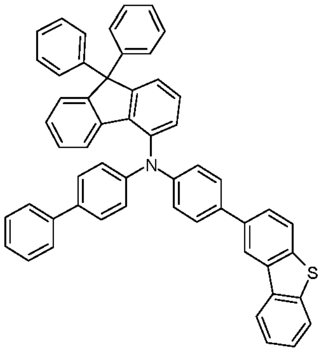 | 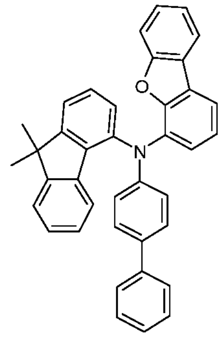 |
| 59 | 60 | 61 |
| 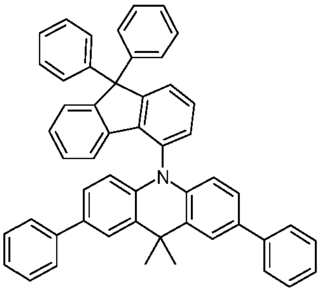 | 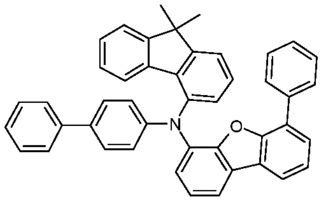 | 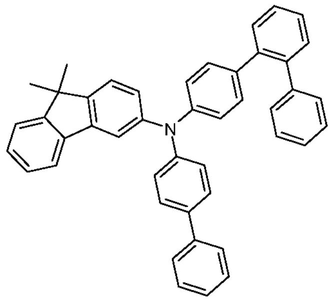 |
| 62 | 63 | 64 |
| 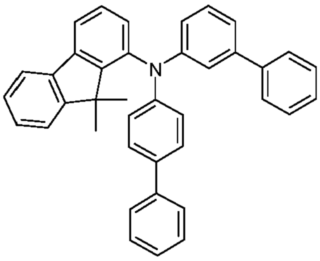 | 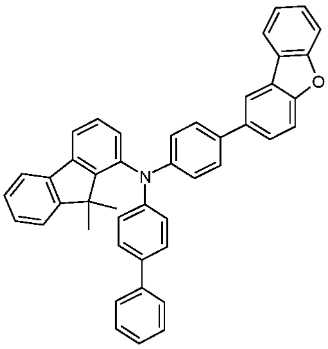 | 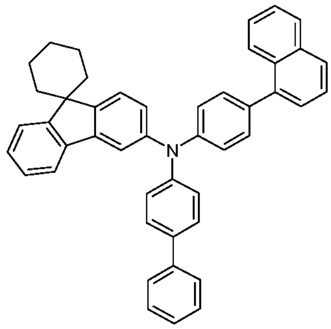 |
| 65 | 66 | 67 |
| 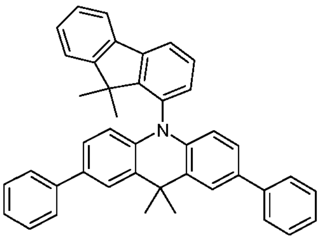 | 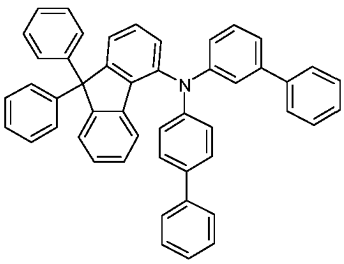 | 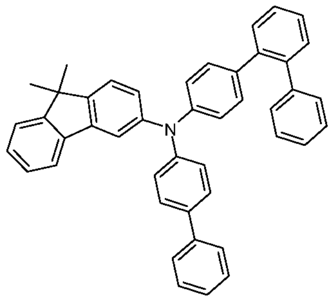 |
| 68 | 69 | 70 |

(fortgesetzt)

| | | |
|---|---|---|
| 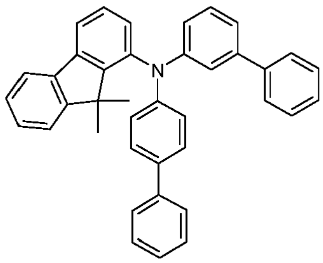 | 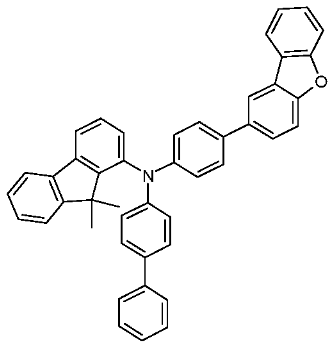 | 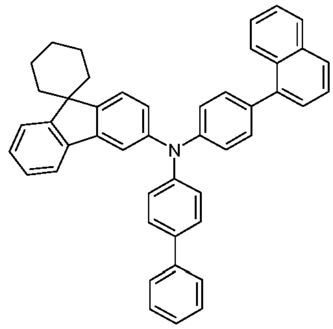 |
| 71 | 72 | 73 |
| 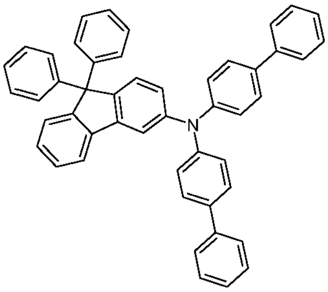 | 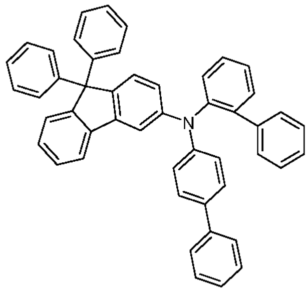 | 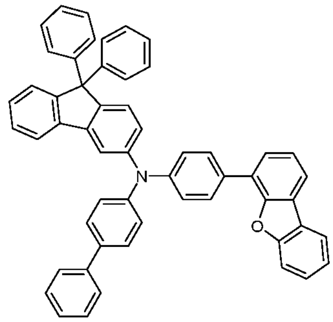 |
| 74 | 75 | 76 |
| 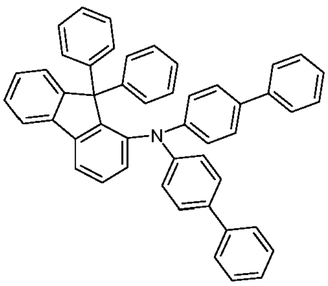 | 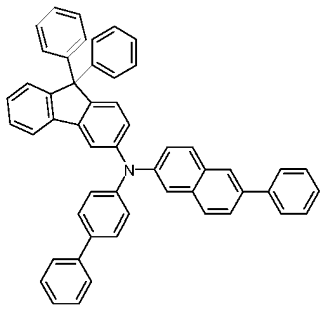 | 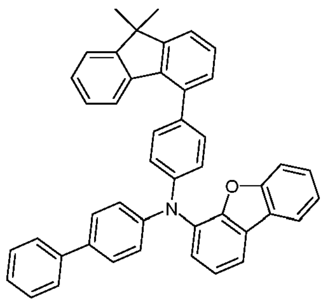 |
| 77 | 78 | 79 |
| 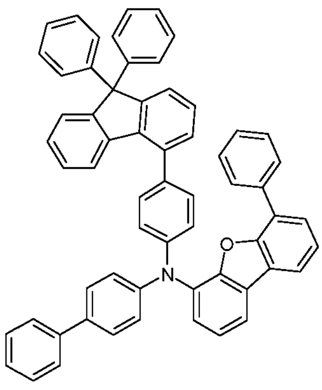 | 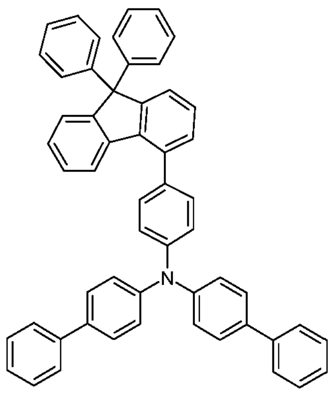 | 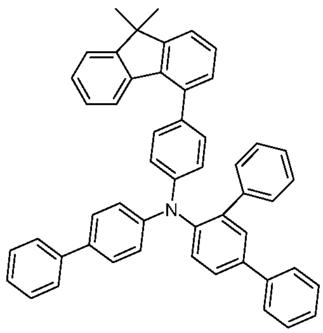 |
| 80 | 81 | 82 |

(fortgesetzt)

| | | |
|---|---|---|
| 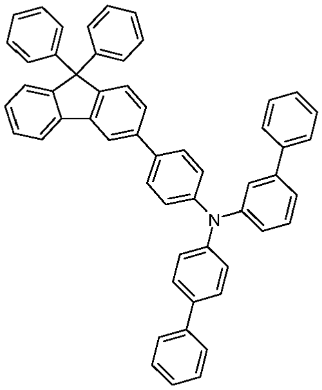 | 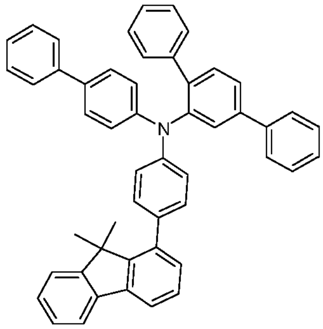 | 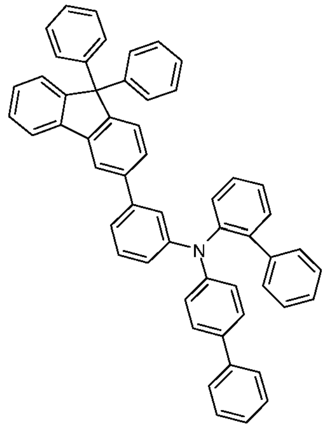 |
| 83 | 84 | 85 |
| 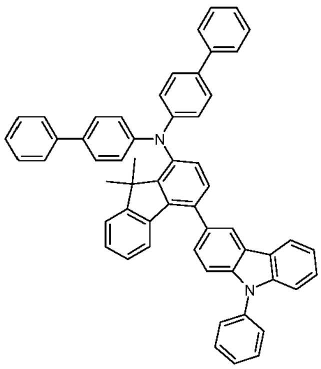 | 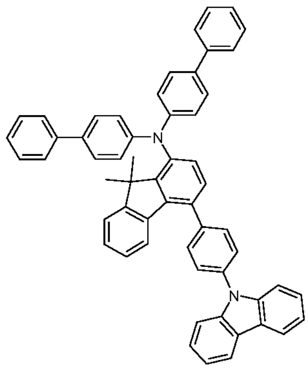 | 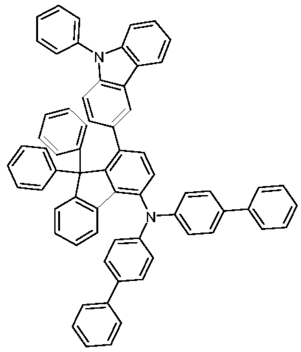 |
| 86 | 87 | 88 |
| 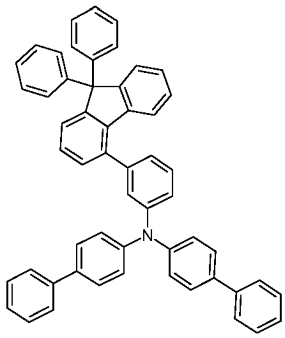 | 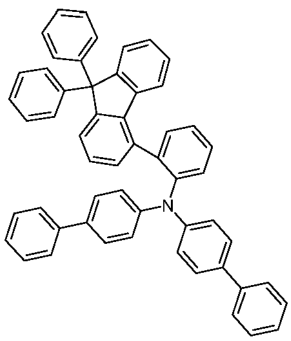 | 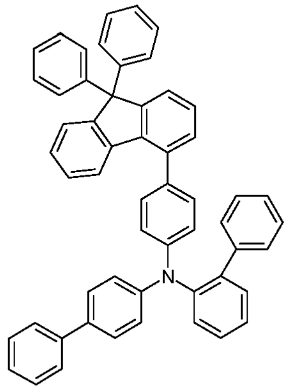 |
| 89 | 90 | 91 |
| 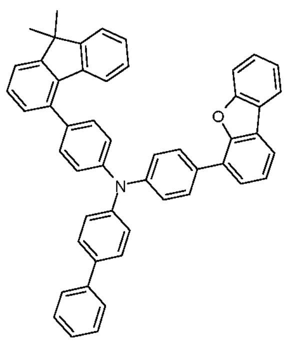 | 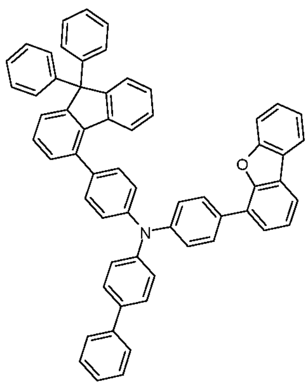 | 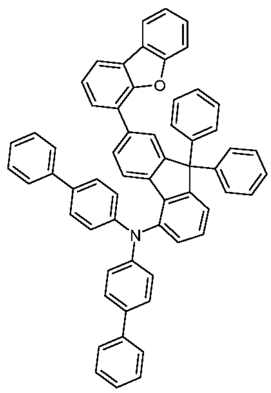 |

(fortgesetzt)

| 92 | 93 | 94 |
|---|---|---|
| 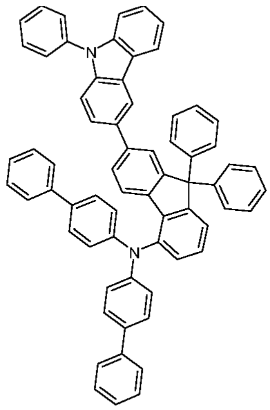 | 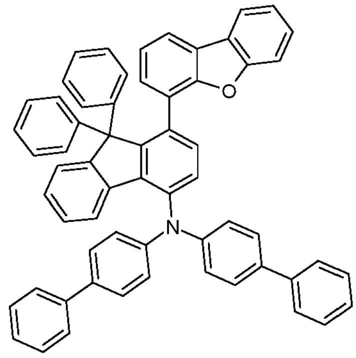 96 | 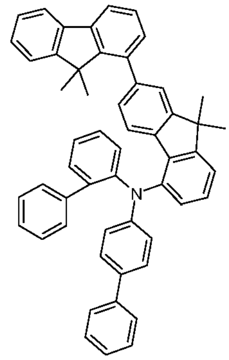 |
| 95 | 96 | 97 |
| 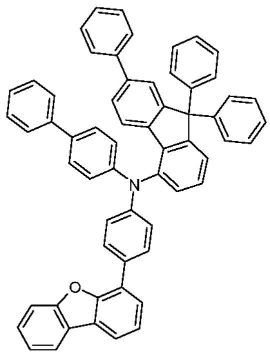 | 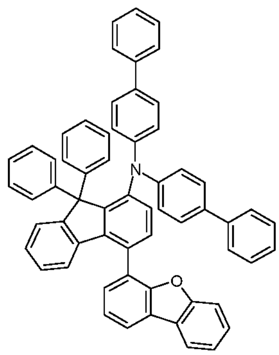 | 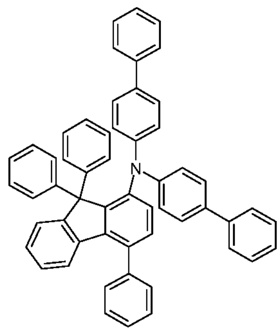 |
| 98 | 99 | 100 |
| 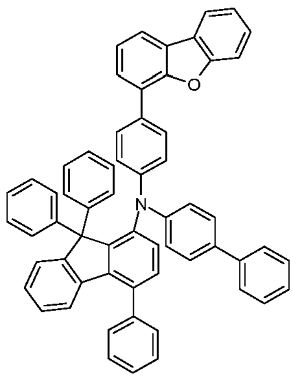 | 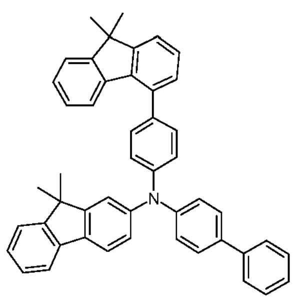 | 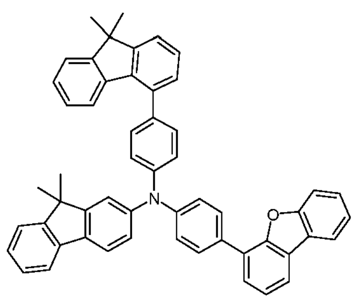 |
| 101 | 102 | 103 |
| 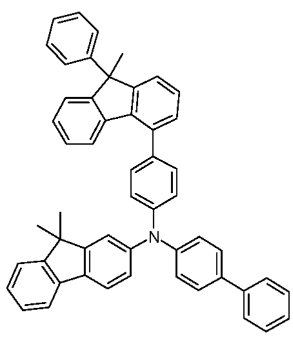 | 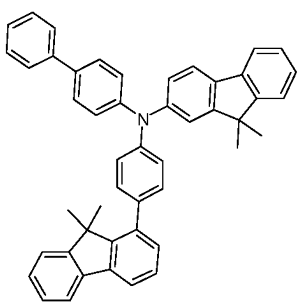 | 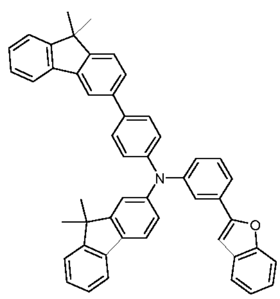 |
| 104 | 105 | 106 |

(fortgesetzt)

| | | |
|---|---|---|
| 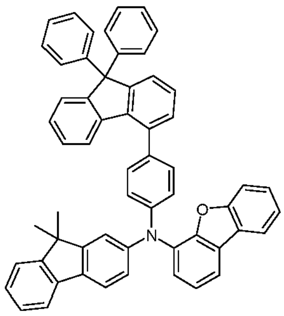 | 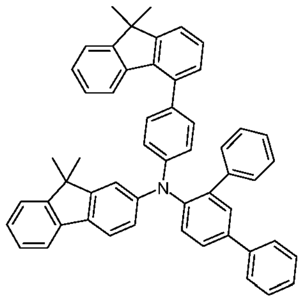 | 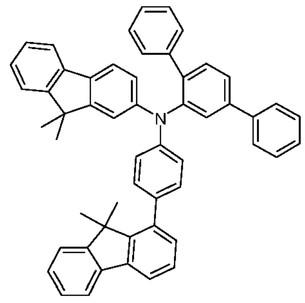 |
| 107 | 108 | 109 |
| 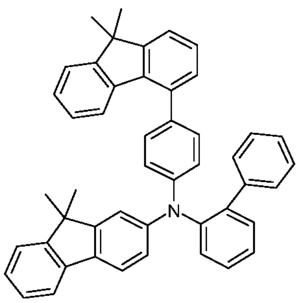 | 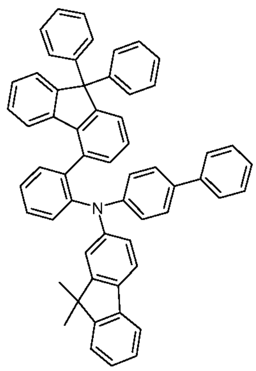 | 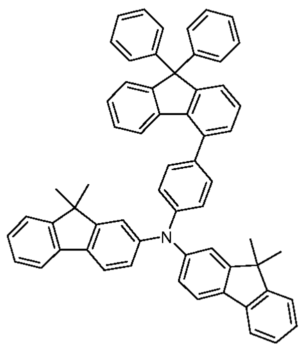 |
| 110 | 111 | 112 |
| 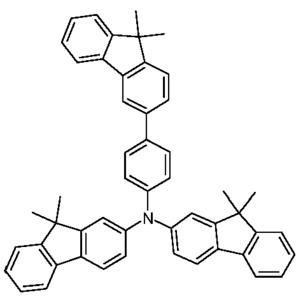 | 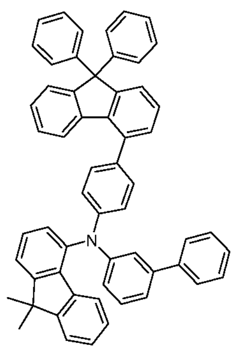 | 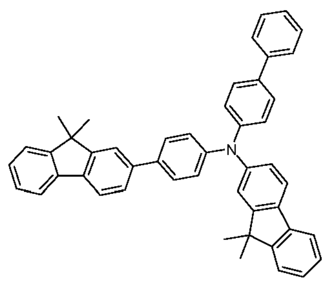 |
| 113 | 114 | 115 |
| 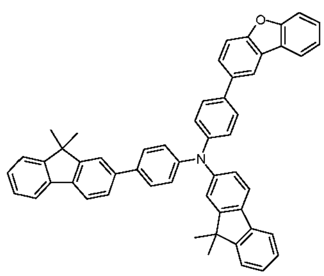 | 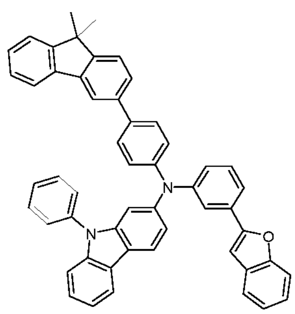 | 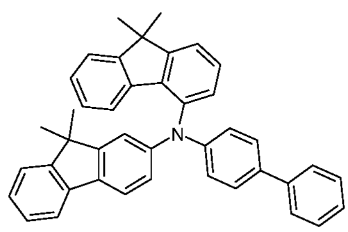 |
| 116 | 117 | 118 |

(fortgesetzt)

| | | |
|---|---|---|
| 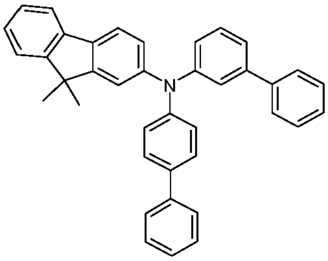 | 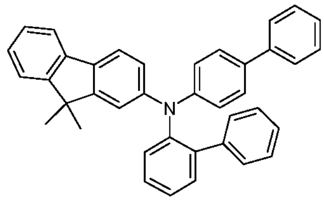 | 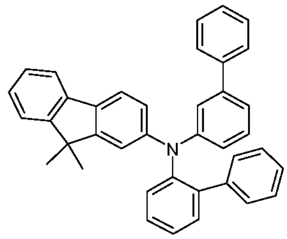 |
| 119 | 120 | 121 |
| 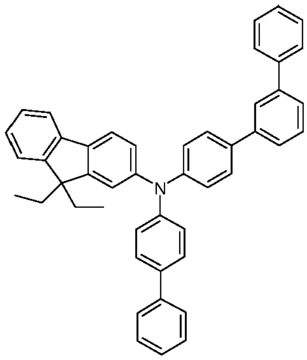 | 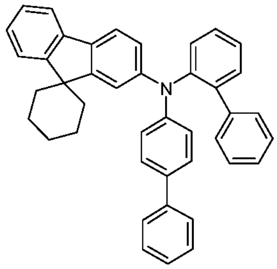 | 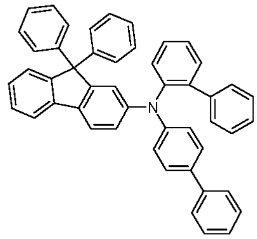 |
| 122 | 123 | 124 |
| 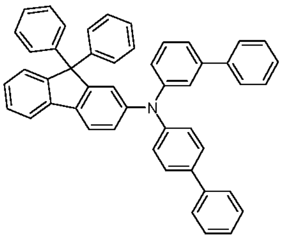 | 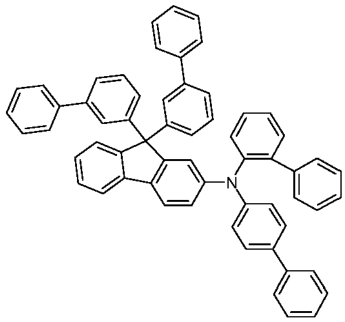 | 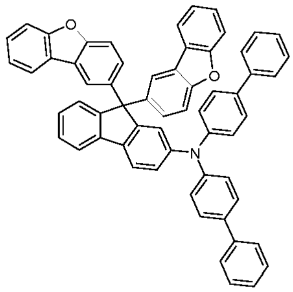 |
| 125 | 126 | 127 |
| 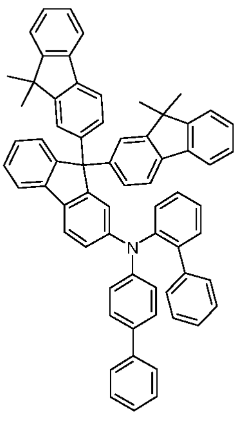 | 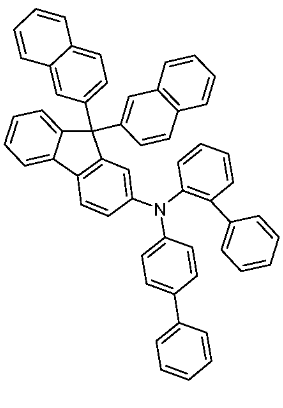 | 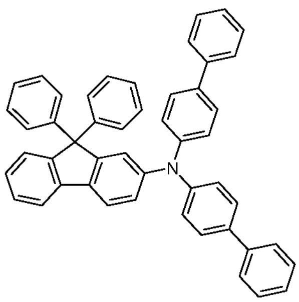 |
| 128 | 129 | 130 |

(fortgesetzt)

| | | |
|---|---|---|
| 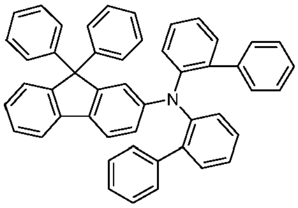 | 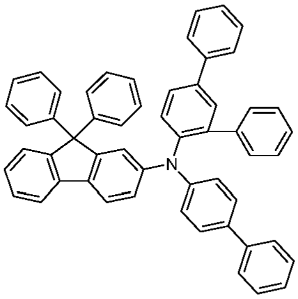 | 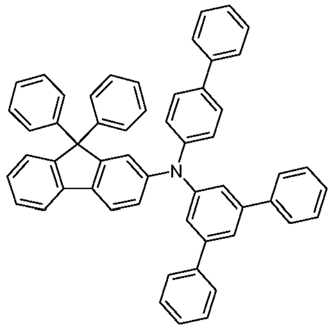 |
| 131 | 132 | 133 |
| 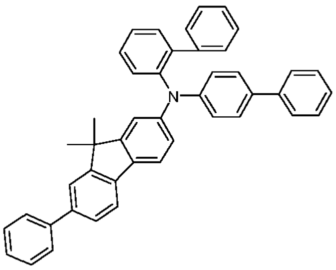 | 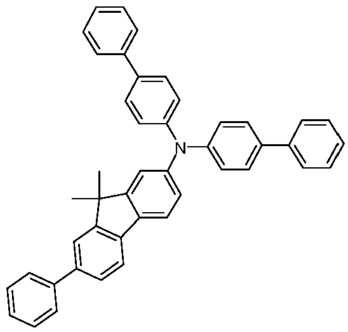 | 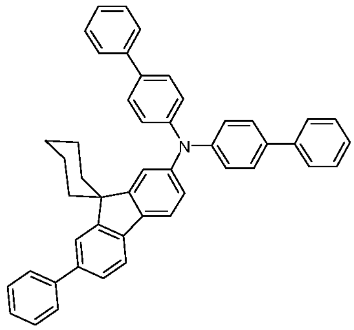 |
| 134 | 135 | 136 |
| 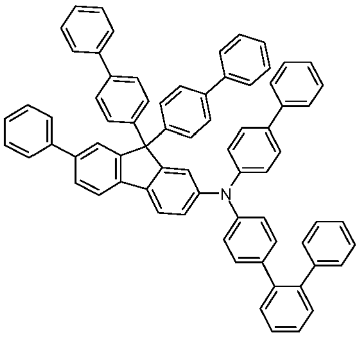 | 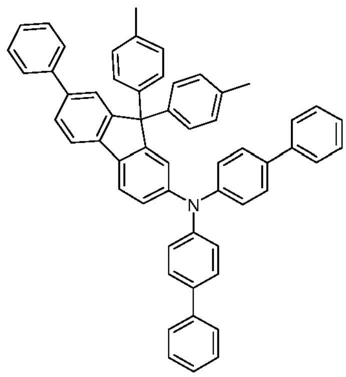 | 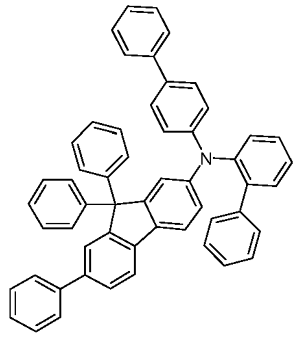 |
| 137 | 138 | 139 |
| 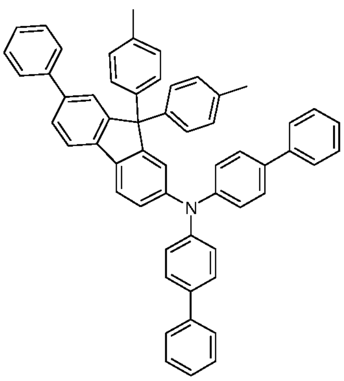 | 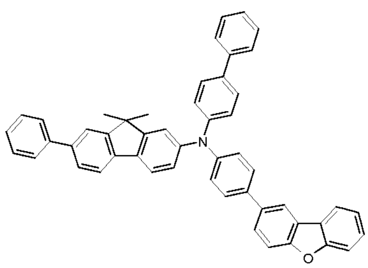 | 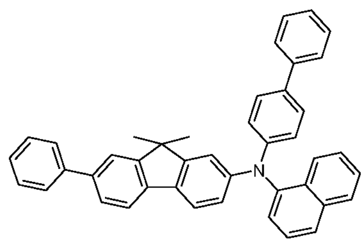 |
| 140 | 141 | 142 |

(fortgesetzt)

| | | |
|---|---|---|
| 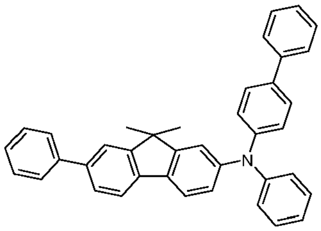 | 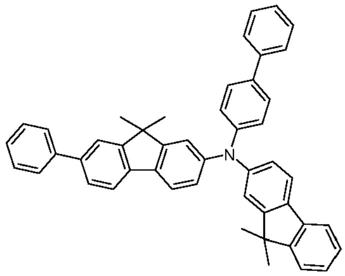 | 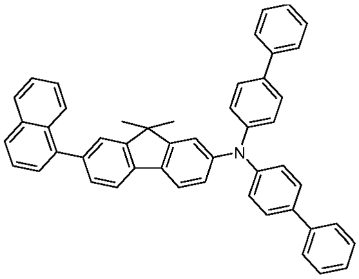 |
| 143 | 144 | 145 |
| 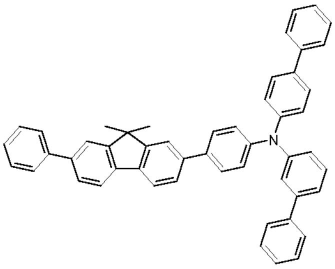 | | 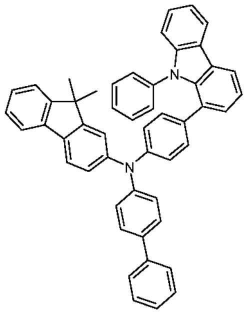 |
| 146 | | 147 |
| 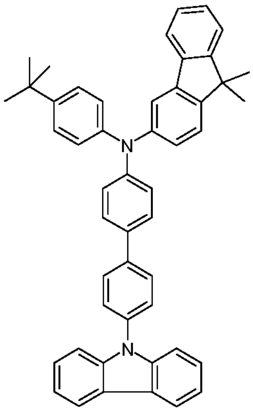 | 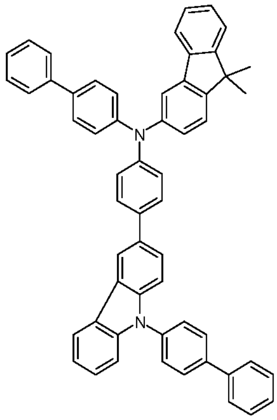 | 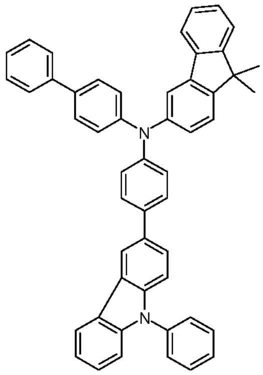 |
| 148 | 149 | 150 |
| 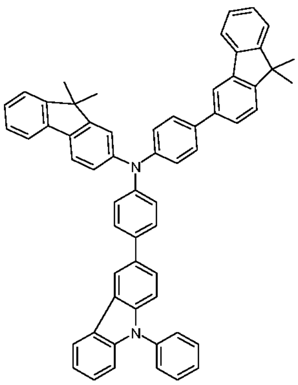 | 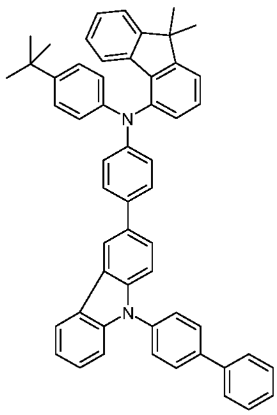 | 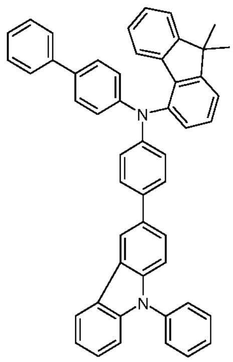 |
| 151 | 152 | 153 |

(fortgesetzt)

| | | |
|---|---|---|
| 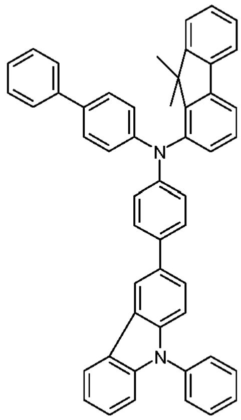 | 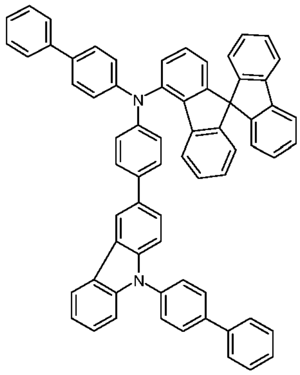 | 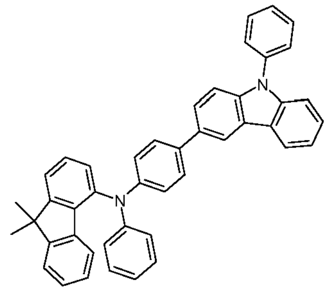 |
| 154 | 155 | 156 |
| 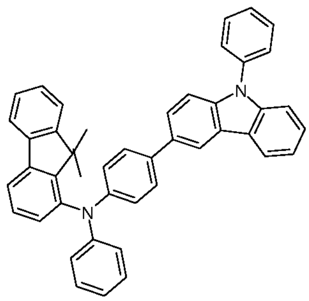 | 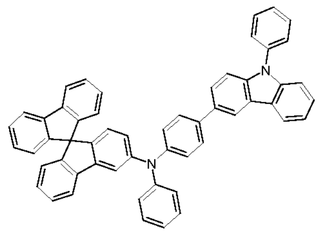 | 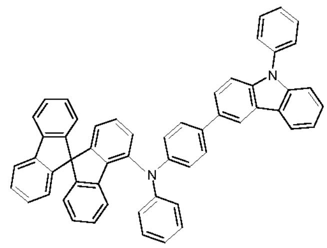 |
| 157 | 158 | 159 |
| 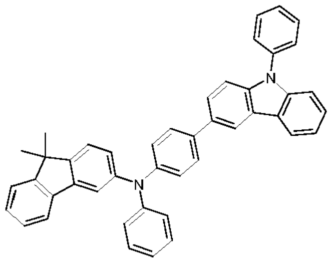 | 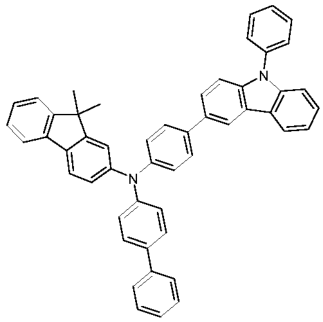 | 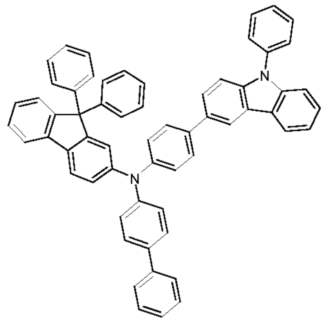 |
| 160 | 161 | 162 |
| 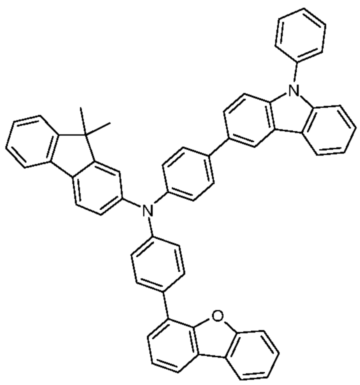 | | 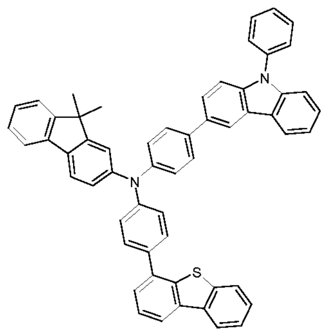 |
| 163 | | 164 |

(fortgesetzt)

| | | |
|---|---|---|
| 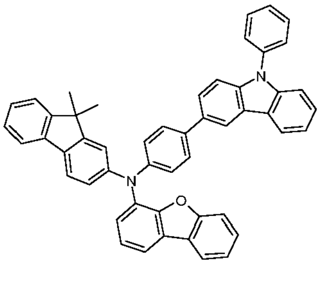 | 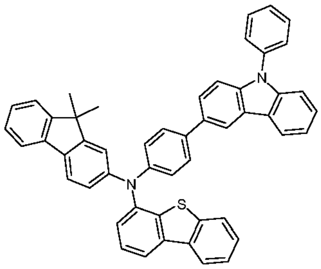 | 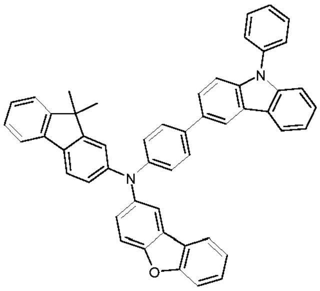 |
| 165 | 166 | 167 |
| 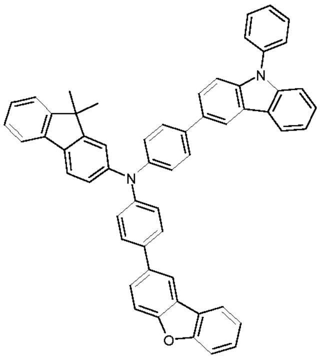 | 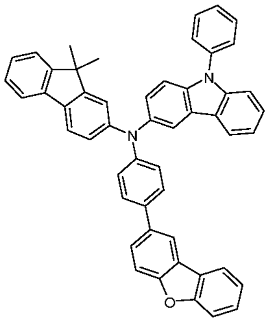 | 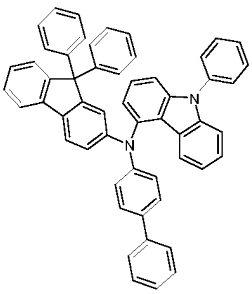 |
| 168 | 169 | 170 |
| 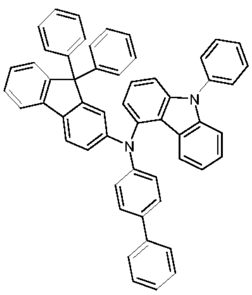 | 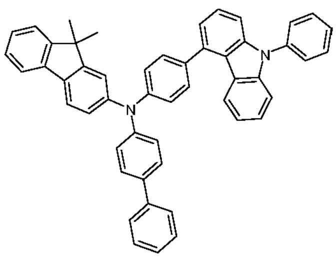 | 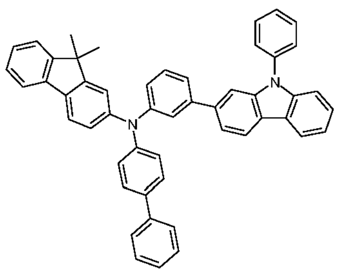 |
| 171 | 172 | 173 |
| 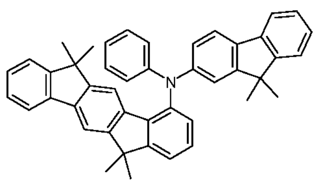 | 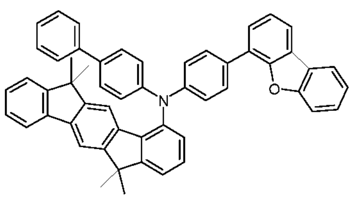 | 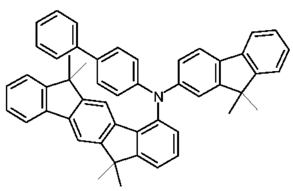 |
| 174 | 175 | 176 |
| 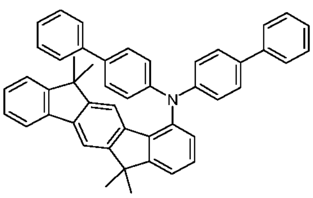 | 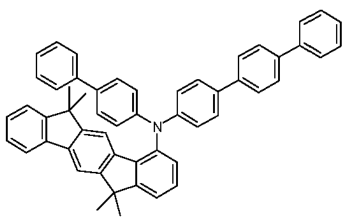 | 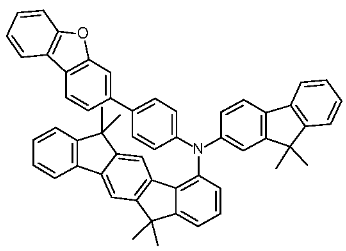 |
| 177 | 178 | 179 |

(fortgesetzt)

| | | |
|---|---|---|
| 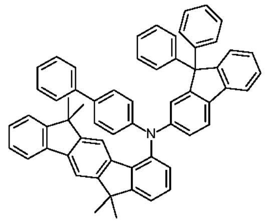 | 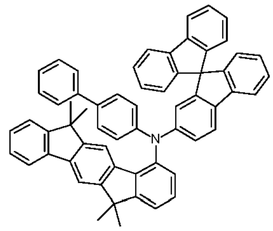 | 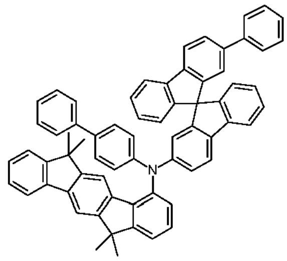 |
| 180 | 181 | 182 |
| 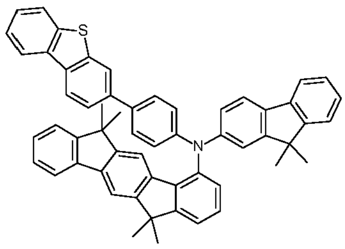 | 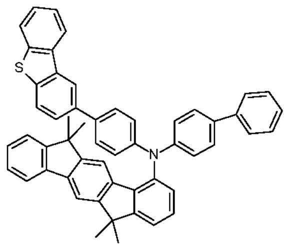 | 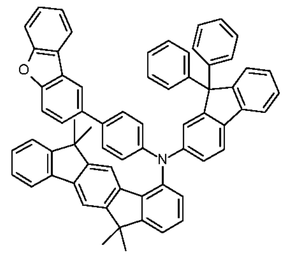 |
| 183 | 184 | 185 |
| 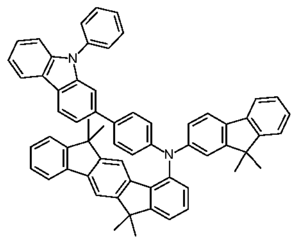 | 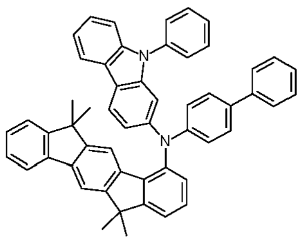 | 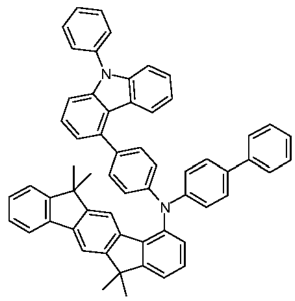 |
| 186 | 187 | 188 |
| 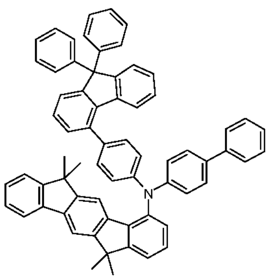 | 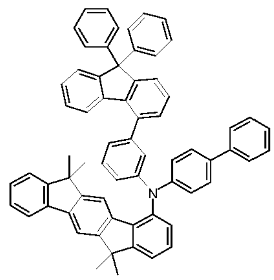 | 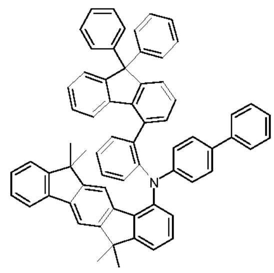 |
| 189 | 190 | 191 |
| 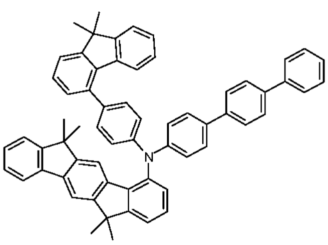 | 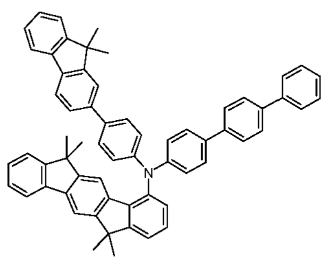 | 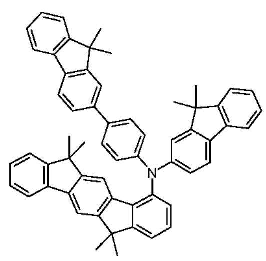 |
| 192 | 193 | 194 |

(fortgesetzt)

| | | |
|---|---|---|
| 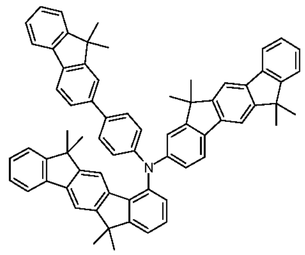 | 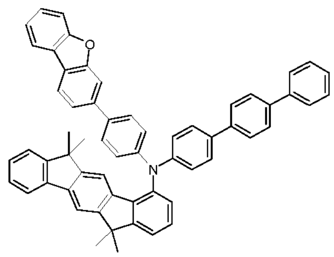 | 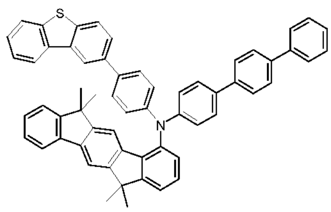 |
| 195 | 196 | 197 |
| 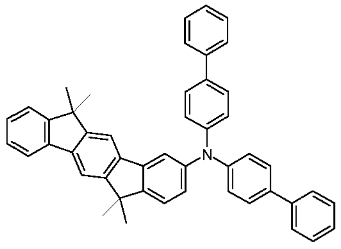 | 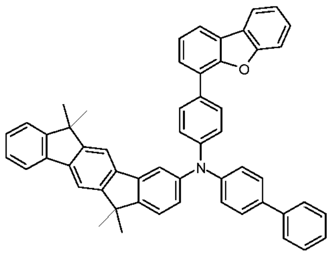 | 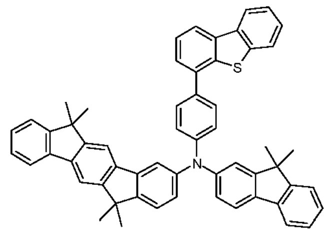 |
| 198 | 199 | 200 |
| 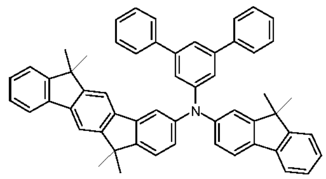 | 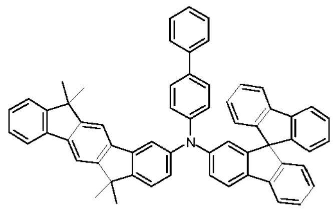 | 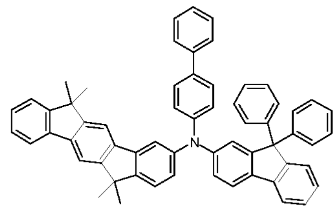 |
| 201 | 202 | 202 |
| 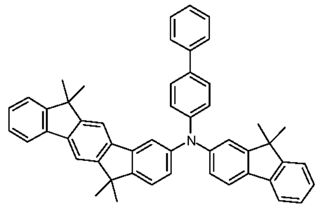 | 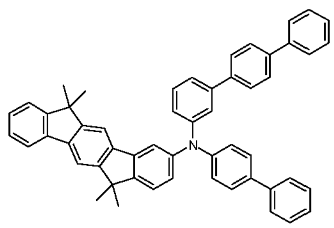 | 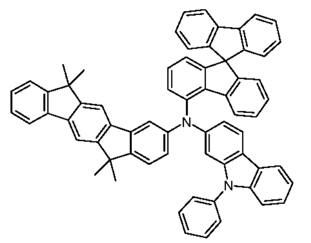 |
| 203 | 204 | 205 |
| 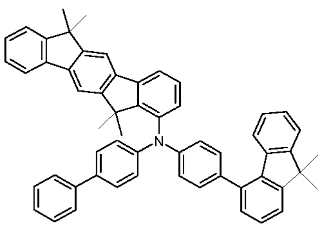 | 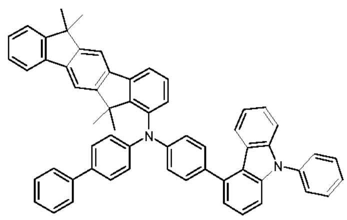 | 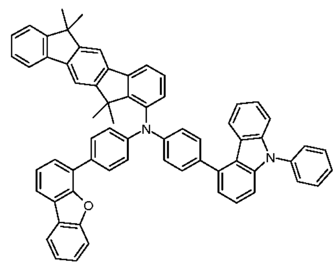 |
| 206 | 207 | 208 |

(fortgesetzt)

| | | |
|---|---|---|
| 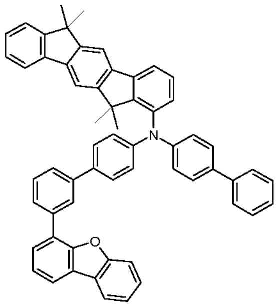 | 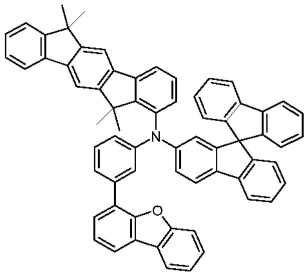 | 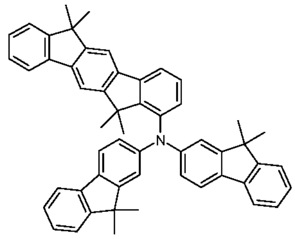 |
| 209 | 210 | 211 |
| 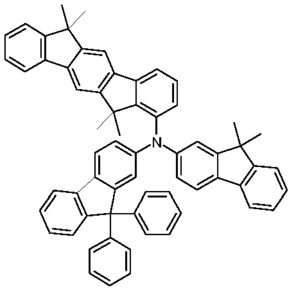 | 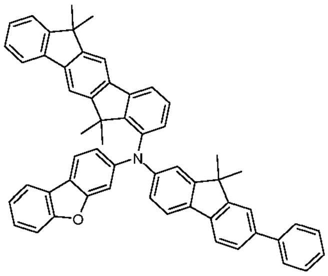 | 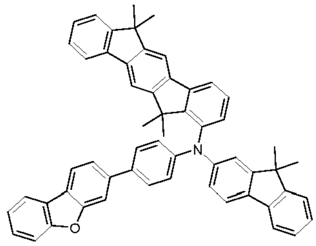 |
| 212 | 213 | 214 |
| 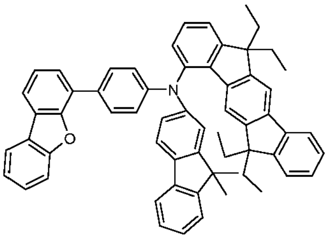 | 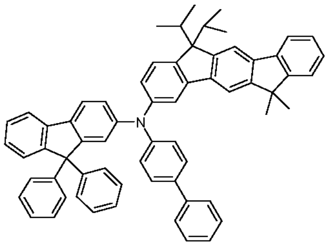 | 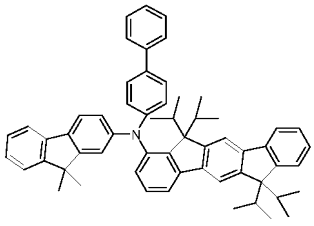 |
| 215 | 214 | 217 |
| 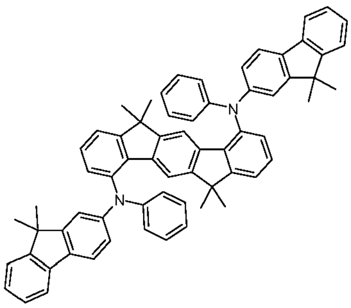 | 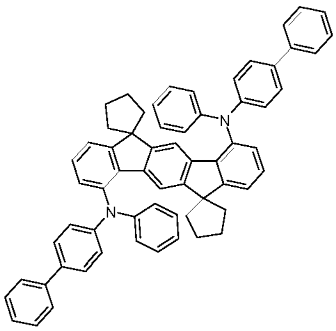 | 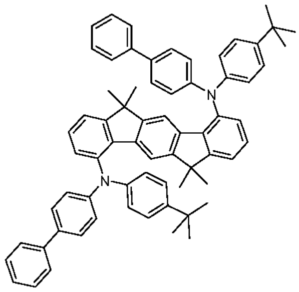 |
| 218 | 219 | 220 |
| 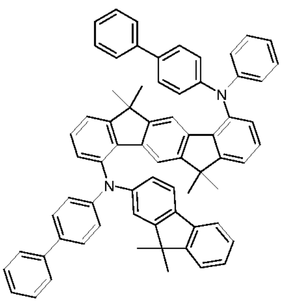 | 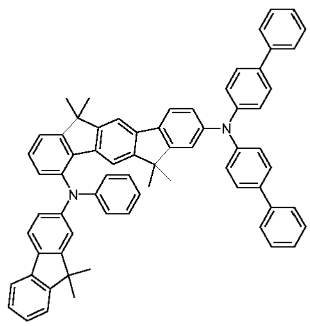 | 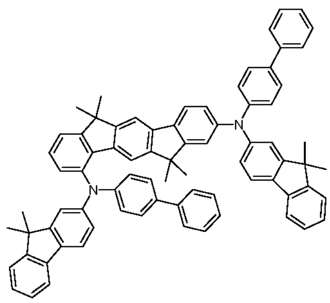 |

(fortgesetzt)

| 221 | 222 | 223 |
|---|---|---|
| 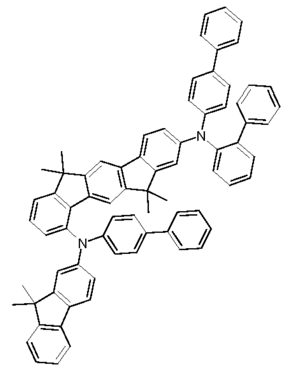 | 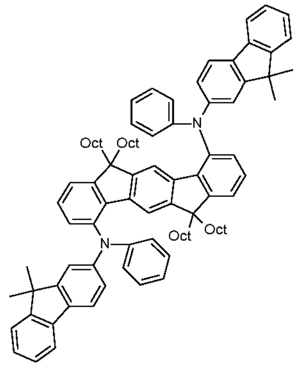 | 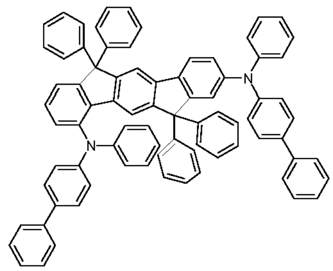 |
| 224 | 225 | 226 |
| 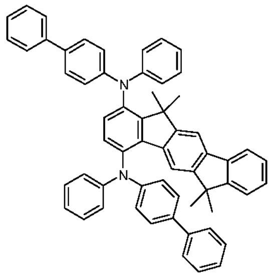 | 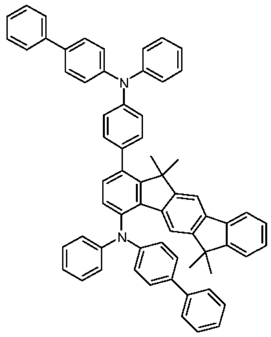 | 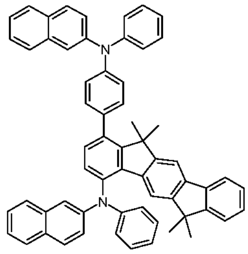 |
| 227 | 228 | 229 |
| 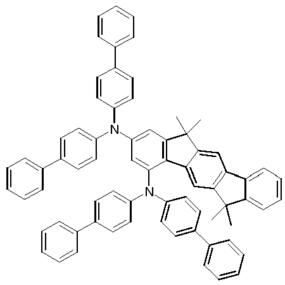 | 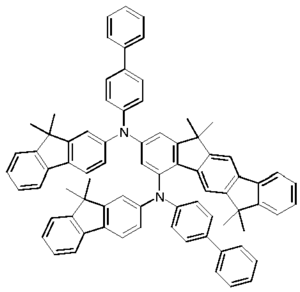 | 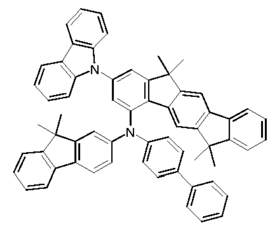 |
| 230 | 231 | 232 |
| 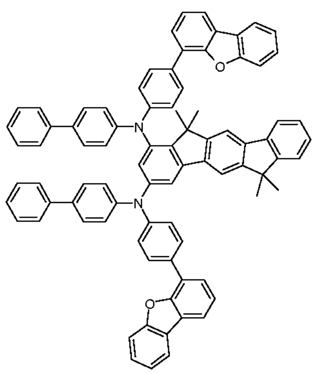 | 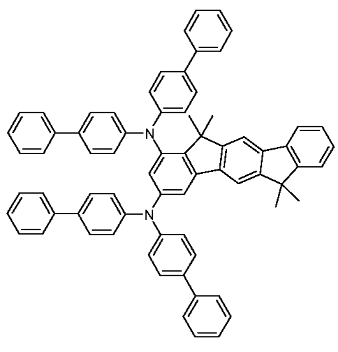 | 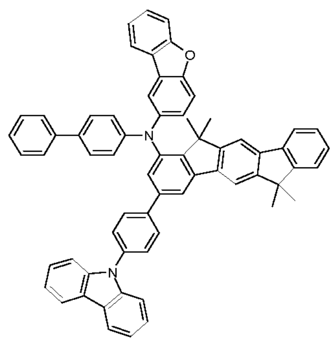 |
| 233 | 234 | 235 |

(fortgesetzt)

| | | |
|---|---|---|
| 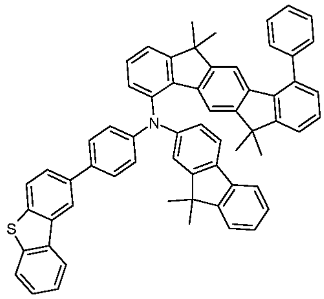 | 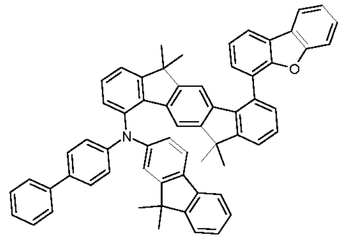 | 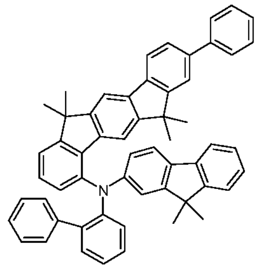 |
| 236 | 237 | 238 |
| 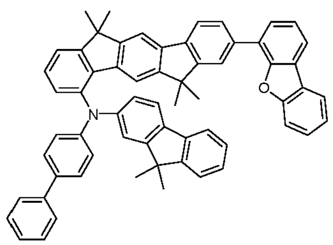 | 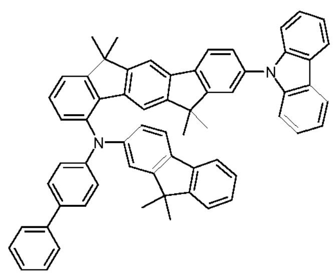 | 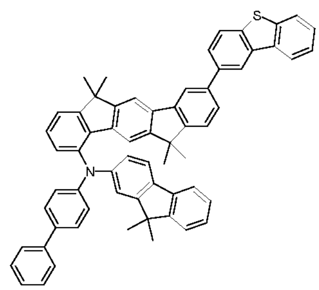 |
| 239 | 240 | 241 |
| 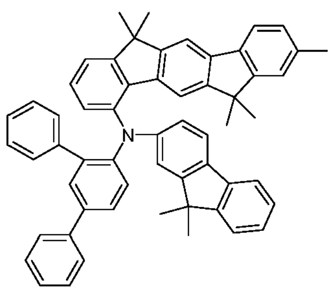 | 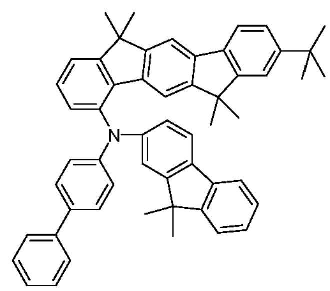 | 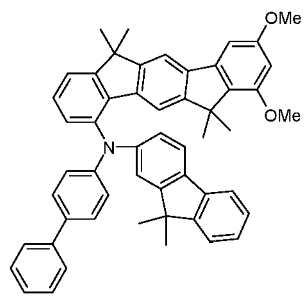 |
| 242 | 243 | 244 |
| 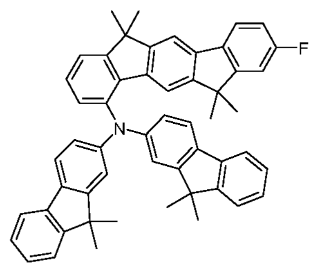 | 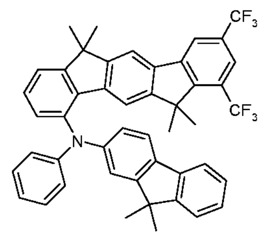 | 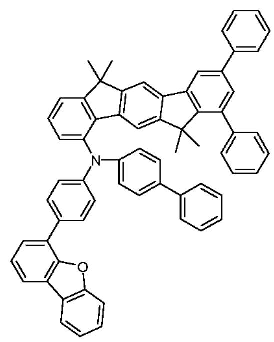 |
| 245 | 246 | 247 |

(fortgesetzt)

| | | |
|---|---|---|
| 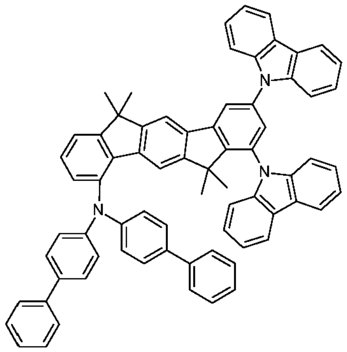 | 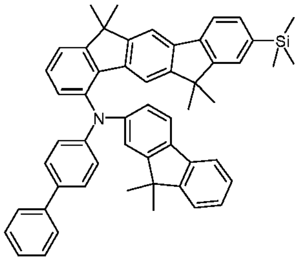 | 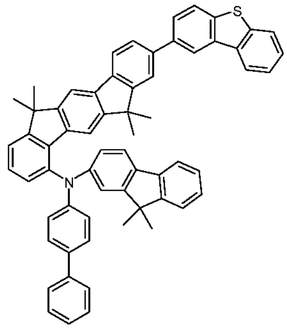 |
| 248 | 249 | 250 |
| 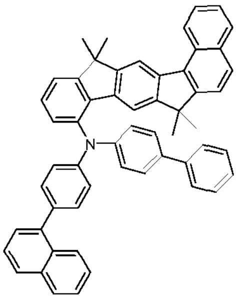 | 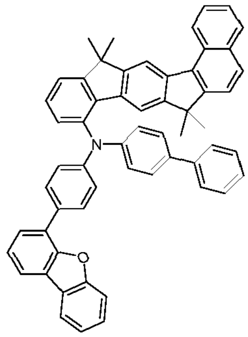 | 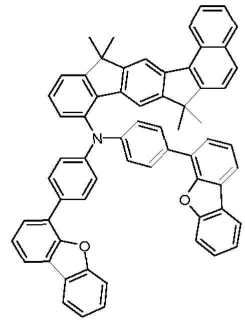 |
| 251 | 252 | 253 |
| 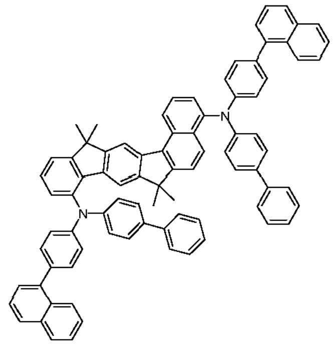 | 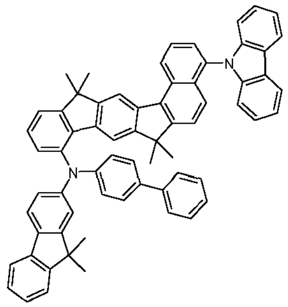 | 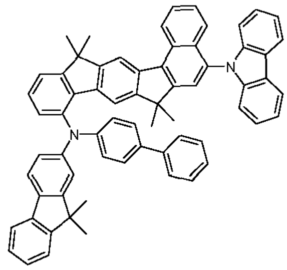 |
| 254 | 255 | 256 |
| 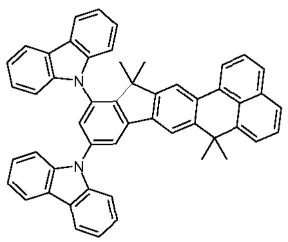 | 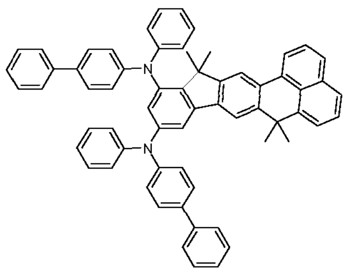 | 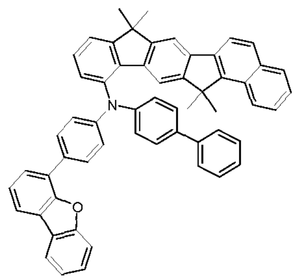 |
| 257 | 258 | 259 |

(fortgesetzt)

| | | |
|---|---|---|
| 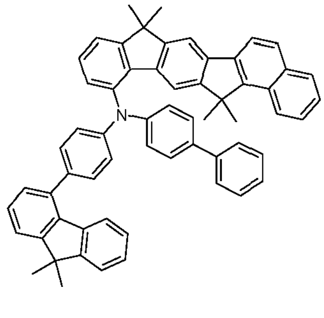 | 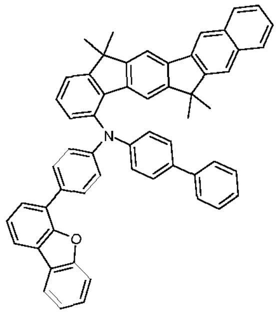 | 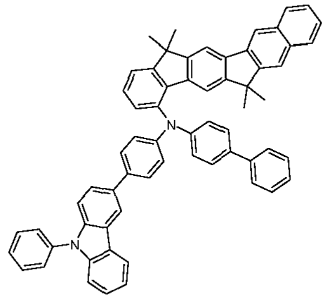 |
| 260 | 261 | 262 |
| 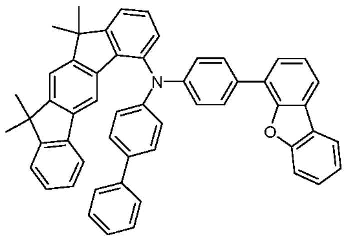 | 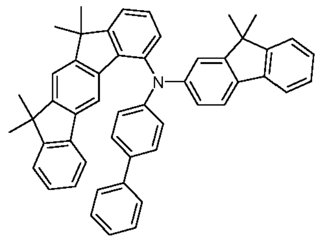 | 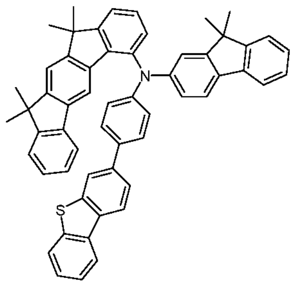 |
| 263 | 264 | 265 |
| 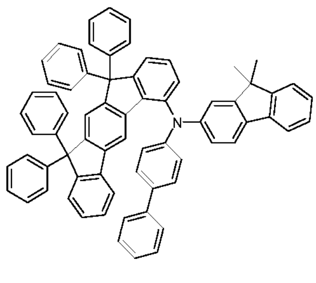 | 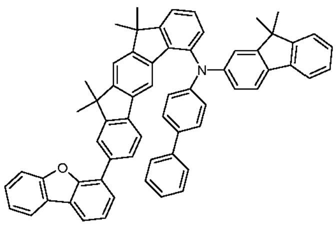 | 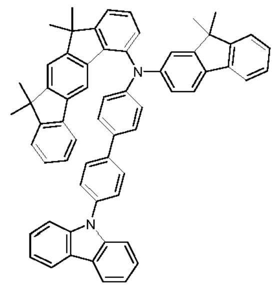 |
| 266 | 267 | 268 |
| 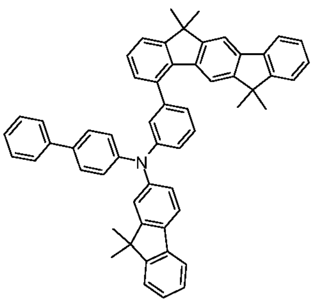 | 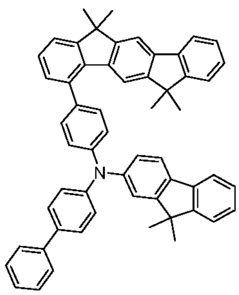 | 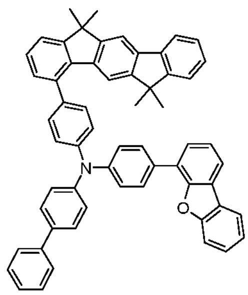 |
| 269 | 270 | 271 |

(fortgesetzt)

| | | |
|---|---|---|
| 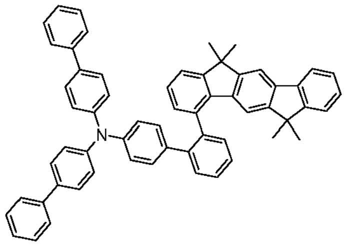 | 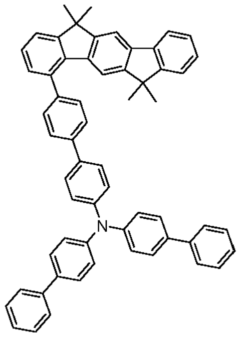 | 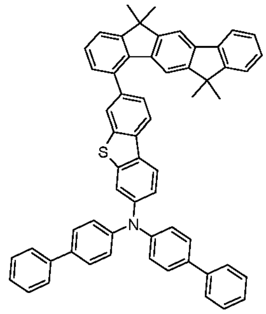 |
| 272 | 273 | 274 |
| 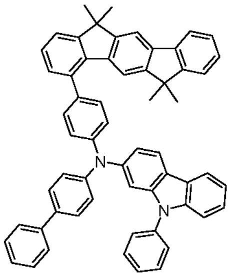 | 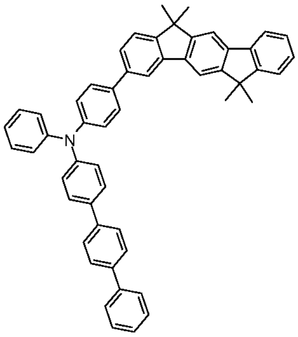 | 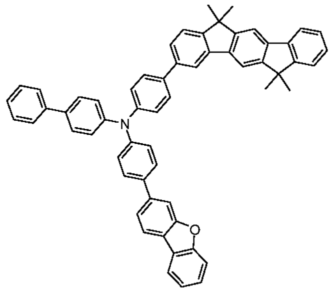 |
| 275 | 276 | 277 |
| 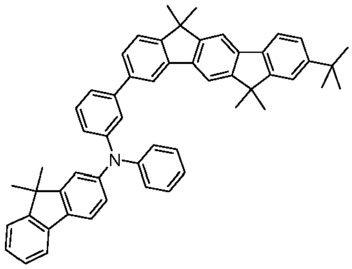 | 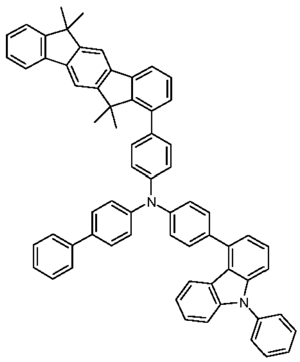 | 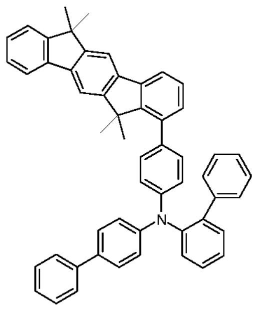 |
| 278 | 279 | 280 |
| 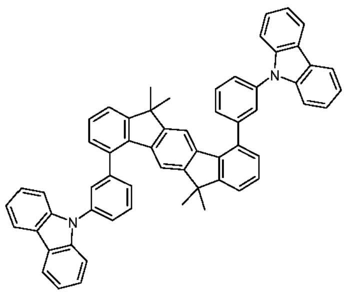 | 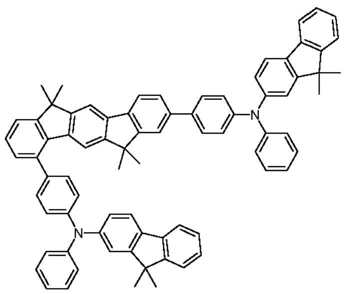 | 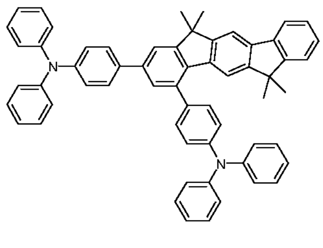 |
| 281 | 282 | 283 |

(fortgesetzt)

| | | |
|---|---|---|
| 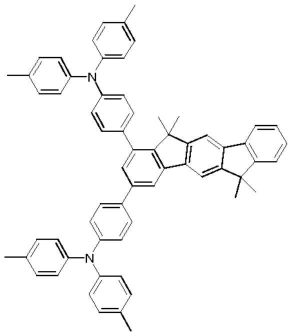 | 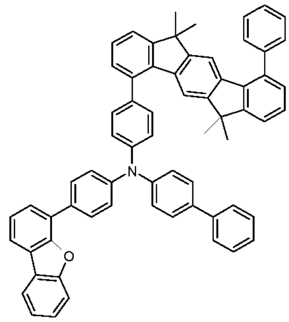 | 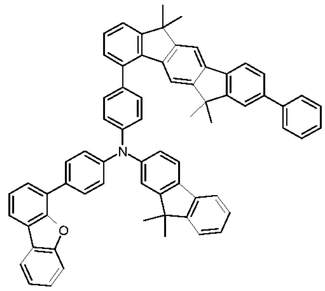 |
| 284 | 285 | 286 |
| 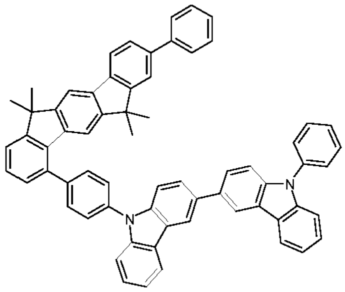 | 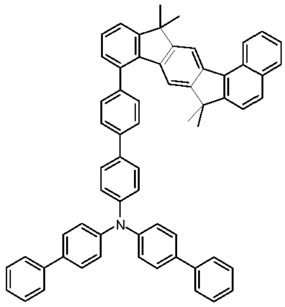 | 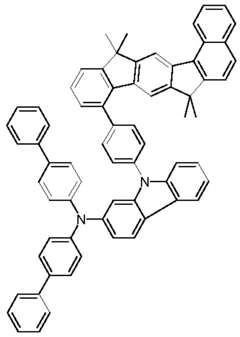 |
| 287 | 288 | 289 |
| 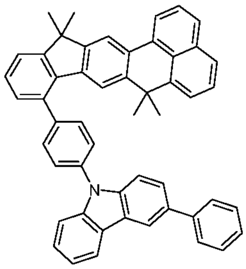 | 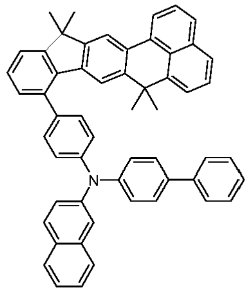 | 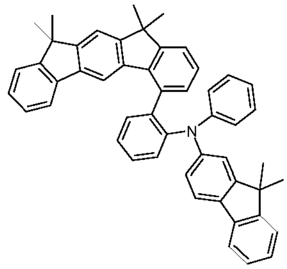 |
| 290 | 291 | 292 |
| 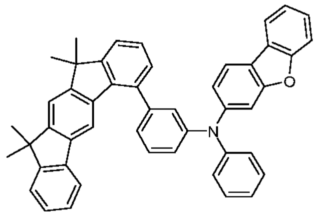 | 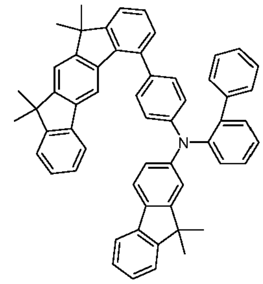 | 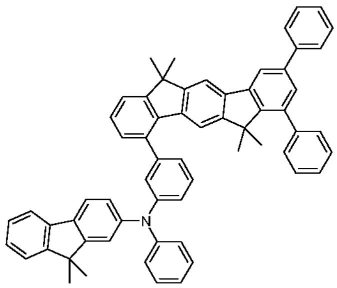 |
| 293 | 294 | 295 |

(fortgesetzt)

| | | |
|---|---|---|
| 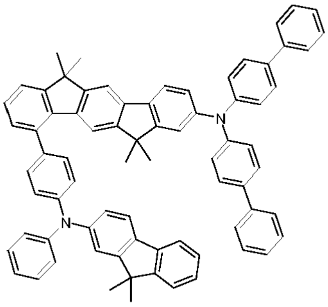 | 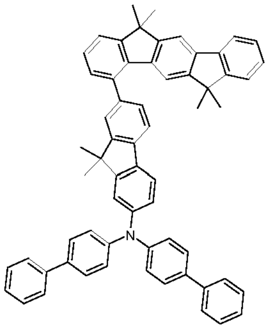 | 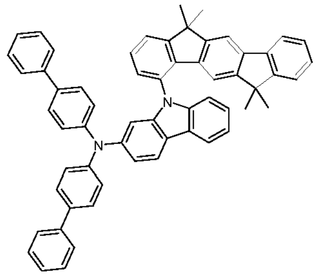 |
| 296 | 297 | 298 |
| 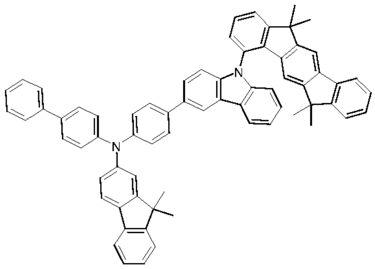 | 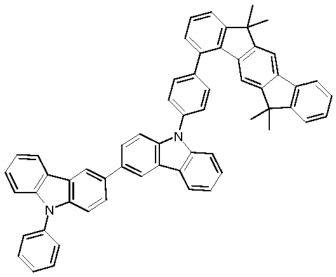 | 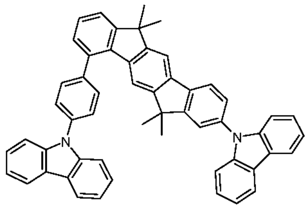 |
| 299 | 300 | 301 |
| 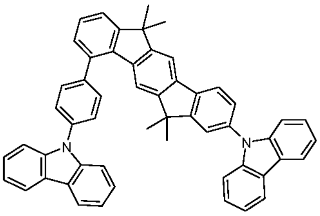 | 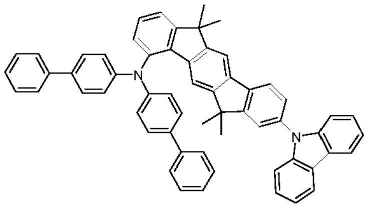 | 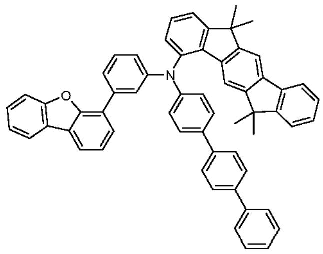 |
| 302 | 303 | 304 |
| 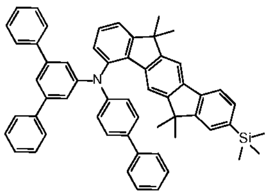 | 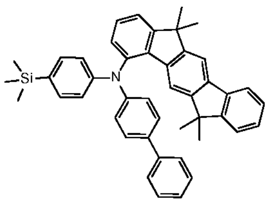 | 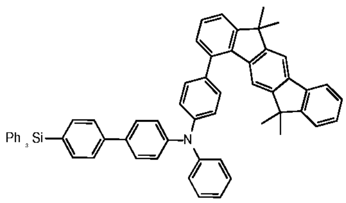 |
| 305 | 306 | 307 |
| 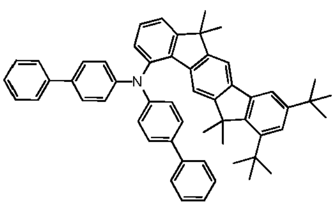 | 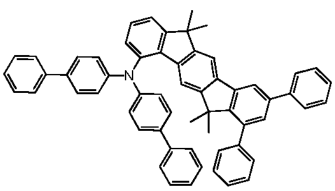 | 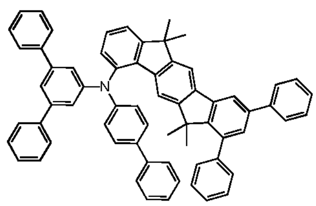 |
| 308 | 309 | 310 |

(fortgesetzt)

| | | |
|---|---|---|
| 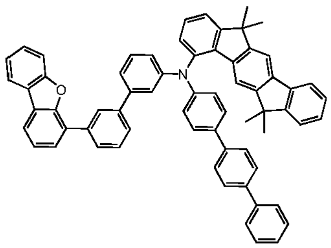 | 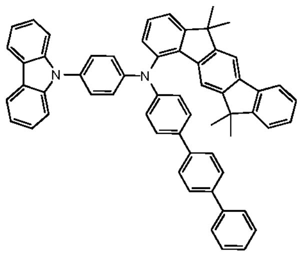 | 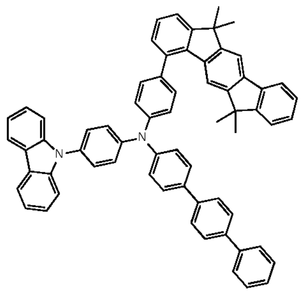 |
| 311 | 312 | 313 |
| 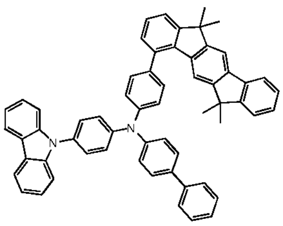 | 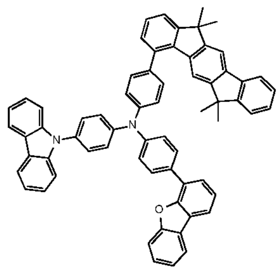 | 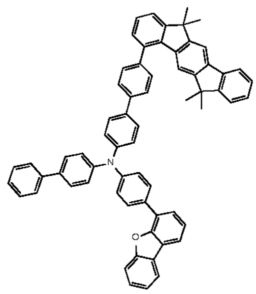 |
| 314 | 315 | 316 |
| 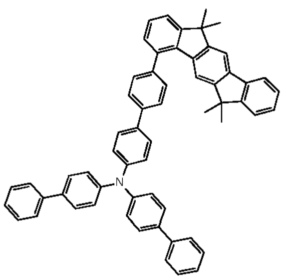 | 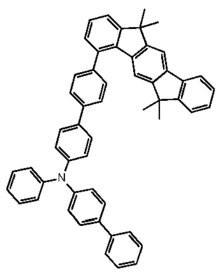 | 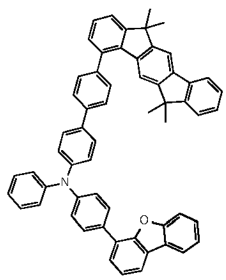 |
| 317 | 318 | 319 |
| 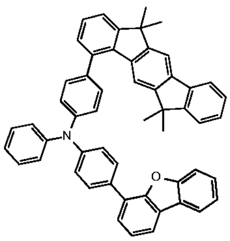 | 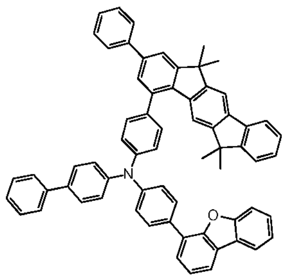 | 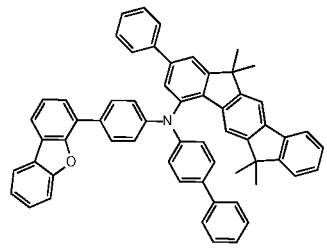 |
| 320 | 321 | 322 |
| 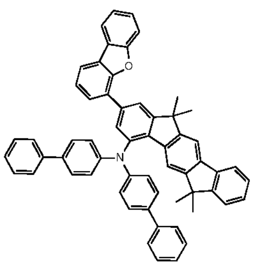 | 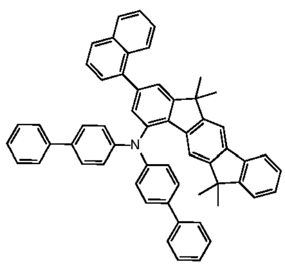 | 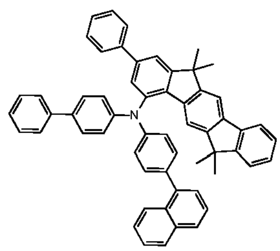 |
| 323 | 324 | 325 |

(fortgesetzt)

| | | |
|---|---|---|
| 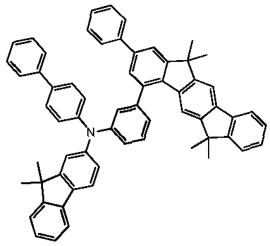 | 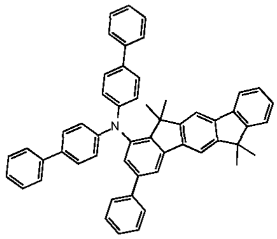 | 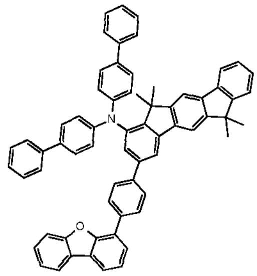 |
| 326 | 327 | 328 |
| 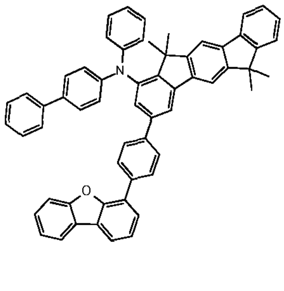 | 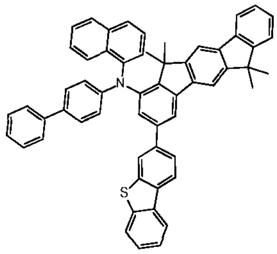 | 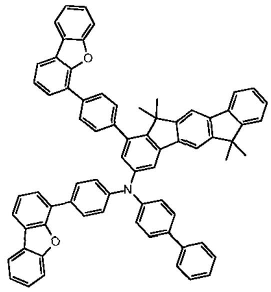 |
| 329 | 330 | 331 |
| 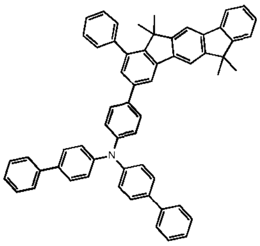 | 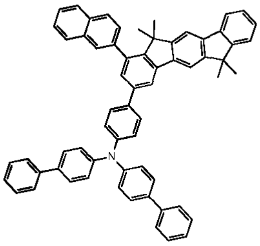 | 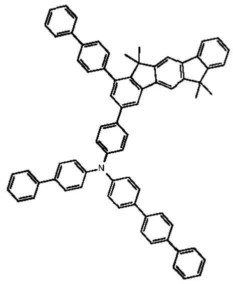 |
| 332 | 333 | 334 |
| 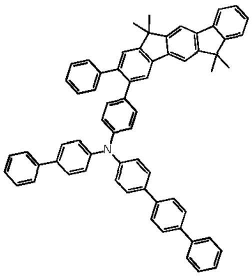 | 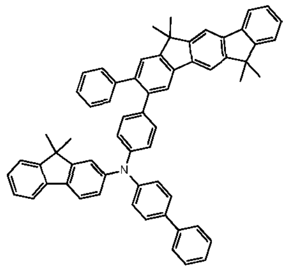 | 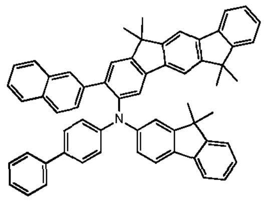 |
| 335 | 336 | 337 |
| 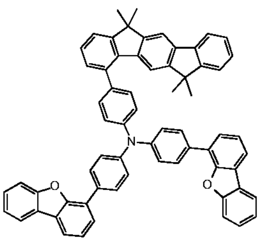 | 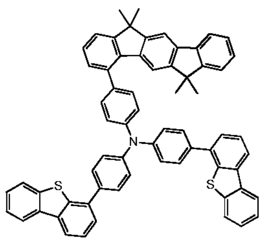 | 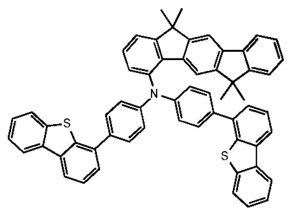 |
| 338 | 339 | 340 |

(fortgesetzt)

| | | |
|---|---|---|
| 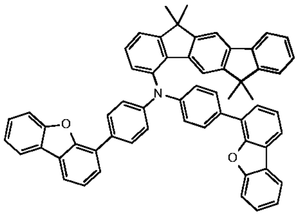 | 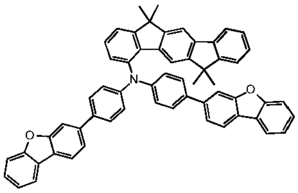 | 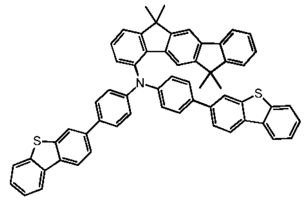 |
| 341 | 342 | 343 |
| 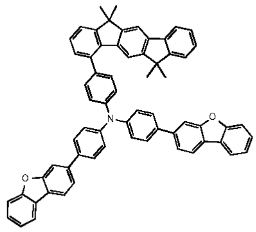 | 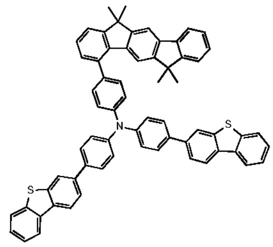 | 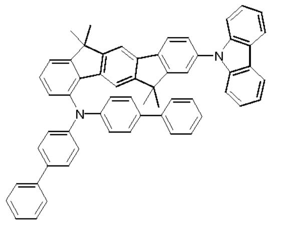 |
| 344 | 345 | 346 |
| 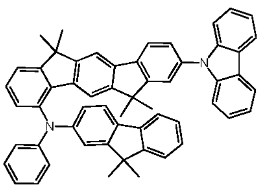 | 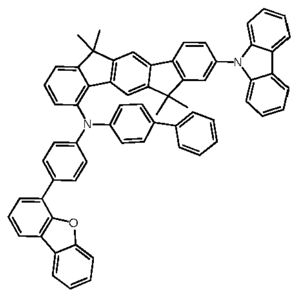 | 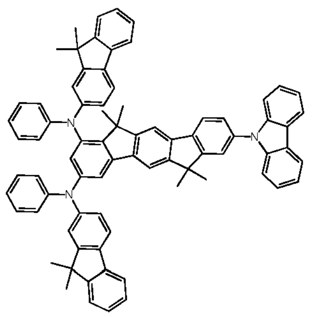 |
| 347 | 348 | 349 |
| 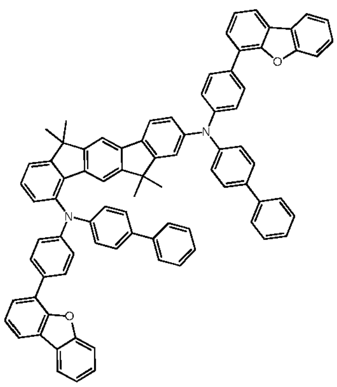 | 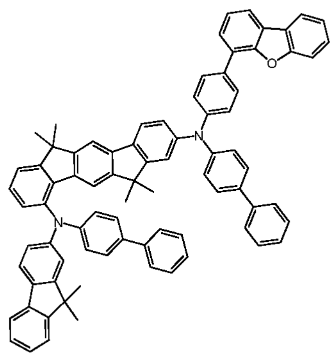 | 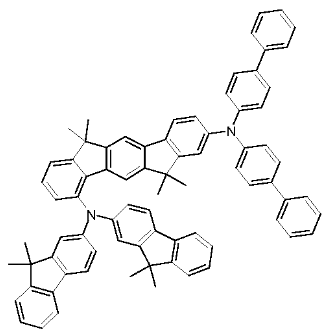 |
| 350 | 351 | 352 |

(fortgesetzt)

| | | |
|---|---|---|
| 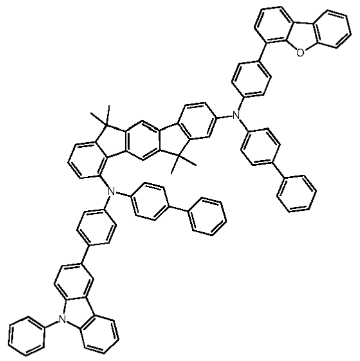 | 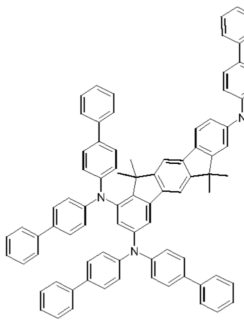 | 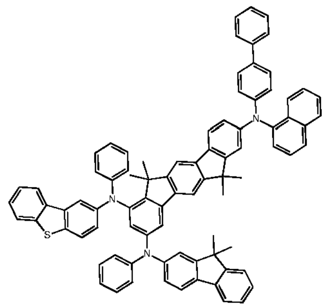 |
| 353 | 355 | 356 |

Die elektronische Vorrichtung enthält bevorzugt eine oder mehrere emittierende Schichten zwischen Schicht B und Kathode.

Die emittierende Schicht der Vorrichtung kann einen oder mehrere phosphoreszierende Emitter enthalten, und/oder sie kann einen oder mehrere fluoreszierende Emitter enthalten.

Vom Begriff phosphoreszierende emittierende Verbindungen sind typischerweise Verbindungen umfasst, bei denen die Lichtemission durch einen spin-verbotenen Übergang erfolgt, beispielsweise einen Übergang aus einem angeregten Triplettzustand oder einem Zustand mit einer höheren Spinquantenzahl, beispielsweise einem Quintett-Zustand.

Als phosphoreszierende emittierende Verbindungen (= Triplettemitter) eignen sich insbesondere Verbindungen, die bei geeigneter Anregung Licht, vorzugsweise im sichtbaren Bereich, emittieren und außerdem mindestens ein Atom der Ordnungszahl größer 20, bevorzugt größer 38 und kleiner 84, besonders bevorzugt größer 56 und kleiner 80 enthalten. Bevorzugt werden als phosphoreszierende emittierende Verbindungen Verbindungen, die Kupfer, Molybdän, Wolfram, Rhenium, Ruthenium, Osmium, Rhodium, Iridium, Palladium, Platin, Silber, Gold oder Europium enthalten, verwendet, insbesondere Verbindungen, die Iridium, Platin oder Kupfer enthalten. Dabei werden im Sinne der vorliegenden Erfindung alle lumineszierenden Iridium-, Platin- oder Kupferkomplexe als phosphoreszierende emittierende Verbindungen angesehen.

Beispiele für derartige phosphoreszierende emittierende Verbindungen können den Anmeldungen WO 00/70655, WO 01/41512, WO 02/02714, WO 02/15645, EP 1191613, EP 1191612, EP 1191614, WO 05/033244, WO 05/019373 und US 2005/0258742 entnommen werden. Generell eignen sich alle phosphoreszierenden Komplexe, wie sie gemäß dem Stand der Technik für phosphoreszierende OLEDs verwendet werden und wie sie dem Fachmann auf dem Gebiet der organischen Elektrolumineszenzvorrichtungen bekannt sind. Auch kann der Fachmann ohne erfinderisches Zutun weitere phosphoreszierende Komplexe in Kombination mit dem erfindungsgemäßen Material in einer OLED einsetzen.

Die phosphoreszierende emittierende Verbindung liegt in der emittierenden Schicht bevorzugt in Kombination mit einem oder mehreren Matrixmaterialien vor. Bevorzugte Matrixmaterialien für phosphoreszierende Emitter sind neben den erfindungsgemäßen Verbindungen aromatische Ketone, aromatische Phosphinoxide oder aromatische Sulfoxide oder Sulfone, Triarylamine, Carbazolderivate, z. B. CBP (N,N-Biscarbazolylbiphenyl) oder Carbazolderivate, Indolocarbazolderivate, Indenocarbazolderivate, Azacarbazolderivate, bipolare Matrixmaterialien, Silane, Azaborole oder Boronester, Triazinderivate, Zinckomplexe, Diazasilol- bzw. Tetraazasilol-Derivate, Diazaphosphol-Derivate, überbrückte Carbazol-Derivate, Triphenylenderivate, oder Lactame.

In einer alternativen Ausführungsform, ebenfalls bevorzugten Ausführungsform weist die elektronische Vorrichtung eine emittierende Schicht auf, die eine fluoreszierende emittierende Verbindung enthält. Bevorzugt enthält die emittierende Schicht in diesem Fall eine Arylaminoverbindung als fluoreszierende emittierende Verbindung, besonders bevorzugt in Kombination mit einem Hostmaterial. Das Hostmaterial ist in diesem Fall bevorzugt gewählt aus Verbindungen enthaltend eine oder mehrere Anthracengruppen.

Bevorzugte fluoreszierende emittierende Verbindungen zur Verwendung in der emittierenden Schicht der elektronischen Vorrichtung sind ausgewählt aus der Klasse der Arylamine. Unter einem Arylamin bzw. einem aromatischen Amin im Sinne dieser Erfindung wird eine Verbindung verstanden, die drei substituierte oder unsubstituierte aromatische oder heteroaromatische Ringsysteme direkt an den Stickstoff gebunden enthält. Bevorzugt ist mindestens eines dieser aromatischen oder heteroaromatischen Ringsysteme ein kondensiertes Ringsystem, besonders bevorzugt mit mindestens 14 aromatischen Ringatomen. Bevorzugte Beispiele hierfür sind aromatische Anthracenamine, aromatische Anthracendiamine, aromatische Pyrenamine, aromatische Pyrendiamine, aromatische Chrysenamine oder aromatische Chrysendiamine. Unter einem aromatischen Anthracenamin wird eine Verbindung verstanden, in der eine Diarylaminogruppe direkt an eine Anthracengruppe gebunden ist, vorzugsweise in 9-Position. Unter einem aromatischen Anthracendiamin wird eine Verbindung verstanden, in der zwei Diarylaminogruppen direkt an eine Anthracengruppe gebunden sind, vorzugsweise in 9,10-Position. Aromatische Pyrenamine, Pyrendiamine, Chrysenamine und Chrysendiamine sind analog dazu definiert, wobei die Diarylaminogruppen am Pyren bevorzugt in 1-Position bzw. in 1 ,6-Position gebunden sind. Weitere bevorzugte emittierende Verbindungen sind Indenofluorenamine bzw. - diamine, Benzoindenofluorenamine bzw. -diamine, und Dibenzoindenofluorenamine bzw. -diamine, sowie Indenofluorenderivate mit kondensierten Arylgruppen. Ebenfalls bevorzugt sind Pyren-Arylamine. Ebenfalls bevorzugt sind Benzoindenofluoren-Amine, Benzofluoren-Amine, erweiterte Benzoindenofluorene, Phenoxazine, und Fluoren-Derivate, die mit Furan-Einheiten oder mit Thiophen-Einheiten verbunden sind.

Als Matrixmaterialien für fluoreszierende emittierende Verbindungen kommen Materialien verschiedener Stoffklassen in Frage. Bevorzugte Matrixmaterialien sind ausgewählt aus den Klassen der Oligoarylene (z. B. 2,2',7,7'-Tetraphenylspirobifluoren), insbesondere der Oligoarylene enthaltend kondensierte aromatische Gruppen, der Oligoarylenvinylene, der polypodalen Metallkomplexe, der lochleitenden Verbindungen, der elektronenleitenden Verbindungen, insbesondere Ketone, Phosphinoxide, und Sulfoxide; der Atropisomere, der Boronsäurederivate und der Benzanthracene. Besonders bevorzugte Matrixmaterialien sind ausgewählt aus den Klassen der Oligoarylene, enthaltend Naphthalin, Anthracen, Benzanthracen und/oder Pyren oder Atropisomere dieser Verbindungen, der Oligoarylenvinylene, der Ketone, der Phosphinoxide und der Sulfoxide. Ganz besonders bevorzugte Matrixmaterialien sind ausgewählt aus den Klassen der Oligoarylene, enthaltend Anthracen, Benzanthracen, Benzphenanthren und/oder Pyren oder Atropisomere dieser Verbindungen. Unter einem Oligoarylen im Sinne dieser Erfindung soll eine Verbindung verstanden werden, in der mindestens drei Aryl- bzw. Arylengruppen aneinander gebunden sind.

Die emittierende Schicht der elektronischen Vorrichtung kann auch Systeme umfassend mehrere Matrixmaterialien (Mixed-Matrix-Systeme) und/oder mehrere Emitterverbindungen enthalten. Auch in diesem Fall sind die Emitter im Allgemeinen diejenigen Materialien, deren Anteil im System der kleinere ist und die Matrixmaterialien sind diejenigen Materialien, deren Anteil im System der größere ist. In Einzelfällen kann jedoch der Anteil eines einzelnen Matrixmaterials im System kleiner sein als der Anteil einer einzelnen Emitterverbindung.

Die Mixed-Matrix-Systeme umfassen bevorzugt zwei oder drei verschiedene Matrixmaterialien, besonders bevorzugt zwei verschiedene Matrixmaterialien. Bevorzugt stellt dabei eines der beiden Materialien ein Material mit unter anderem lochtransportierenden Eigenschaften und das andere Material ein Material mit unter anderem elektronentransportierenden Eigenschaften dar. Die beiden unterschiedlichen Matrixmaterialien können in einem Verhältnis von 1:50 bis 1:1, bevorzugt 1:20 bis 1:1, besonders bevorzugt 1:10 bis 1:1 und ganz besonders bevorzugt 1:4 bis 1:1 vorliegen. Bevorzugt werden Mixed-Matrix-Systeme in phosphoreszierenden organischen Elektrolumineszenzvorrichtungen eingesetzt.

Die Mixed-Matrix-Systeme können einen oder mehrere Emitterverbindungen umfassen, bevorzugt einen oder mehrere phosphoreszierende Emitterverbindungen. Allgemein werden Mixed-Matrix-Systeme bevorzugt in phosphoreszierenden organischen Elektrolumineszenzvorrichtungen eingesetzt.

Besonders geeignete Matrixmaterialien für Mixed-Matrix-Systeme sind ausgewählt aus den oben angegebenen bevorzugten Matrixmaterialien für phosphoreszierende Emitter oder den bevorzugten Matrixmaterialien für fluoreszierende Emitter, je nachdem welche Art von Emitter im Mixed-Matrix-System eingesetzt wird.

Die elektronische Vorrichtung weist bevorzugt folgende Schichten in der folgenden Reihenfolge auf:

- Anode-
- Lochinjektionsschicht-
- Lochtransportschicht-
- optional weitere Lochtransportschicht(en)-
- emittierende Schicht-
- optional Lochblockierschicht-
- Elektronentransportschicht-
- Elektroneninjektionsschicht-
- Kathode-.

Es müssen jedoch nicht alle der genannten Schichten vorhanden sein, und/oder es können zusätzliche weitere Schichten vorhanden sein.

Die elektronische Vorrichtung enthält bevorzugt zusätzlich zu den Schichten A und B noch eine oder mehrere weitere Schichten zwischen Anode und emittierender Schicht auf. Diese Schichten sind bevorzugt gewählt aus Lochtransportschichten und Elektronenblockierschichten. Unter einer Lochtransportschicht wird eine Schicht verstanden, die zwischen Anode und emittierender Schicht angeordnet ist und lochtransportierende Eigenschaften aufweist. Unter einer Elektronenblockierschicht wird eine Schicht verstanden, die zwischen Anode und emittierender Schicht angeordnet ist,

die anodenseitig direkt an die emittierende Schicht angrenzt, und den Durchtritt von Elektronen aus der emittierenden Schicht heraus in Richtung der Anode reduziert oder verhindert. Gemäß einer bevorzugten Ausführungsform enthält die elektronische Vorrichtung zwischen Anode und emittierender Schicht die folgenden Schichten: Schicht A, Schicht B, eine weitere lochtransportierende Schicht und eine elektronenblockierende Schicht, in der genannten Reihenfolge. Bevorzugt liegen keine weiteren Schichten zwischen Anode und emittierender Schicht vor.

Verbindungen, die in der oben genannten weiteren lochtransportierenden Schicht und der elektronenblockierenden Schicht der elektronischen

Vorrichtung eingesetzt werden, sind bevorzugt gewählt aus Indenofluorenamin-Derivaten, Aminderivaten, Hexaazatriphenylenderivaten, Aminderivaten mit kondensierten Aromaten, Monobenzoindenofluorenaminen, Dibenzoindenofluorenaminen, Spirobifluoren-Aminen, Fluoren-Aminen, Spiro-Dibenzopyran-Aminen, Dihydroacridin-Derivaten, Spirodibenzofuranen und Spirodibenzothiophenen, Phenanthren-Diarylaminen, Spiro-Tribenzotropolonen, Spirobifluorenen mit meta-Phenyldiamingruppen, Spiro-Bisacridinen, Xanthen-Diarylaminen, und 9,10-Dihydroanthracen-Spiroverbindungen mit Diarylaminogruppen.

Die oben genannten Verbindungen gewählt aus Indenofluorenamin-Derivaten, Aminderivaten, Hexaazatriphenylenderivaten, Aminderivaten mit kondensierten Aromaten, Monobenzoindenofluorenaminen, Dibenzoindenofluorenaminen, Spirobifluoren-Aminen, Fluoren-Aminen, Spiro-Dibenzopyran-Aminen, Dihydroacridin-Derivaten, Spirodibenzofuranen und Spirodibenzothiophenen, Phenanthren-Diarylaminen, Spiro-Tribenzotropolonen, Spirobifluorenen mit meta-Phenyldiamingruppen, Spiro-Bisacridinen, Xanthen-Diarylaminen, und 9,10-Dihydroanthracen-Spiroverbindungen mit Diarylaminogruppen sind allgemein zur Verwendung in Schichten mit lochtransportierender Funktion geeignet. Zu den Schichten mit lochtransportierender Funktion gehören Lochinjektionsschichten, Lochtransportschichten, Elektronenblockierschichten und auch emittierende Schichten. Bei Verwendung in emittierenden Schichten sind die Verbindungen als Matrixmaterialien, insbesondere als Matrixmaterialien mit lochtransportierenden Eigenschaften, geeignet. Das in diesem Abschnitt genannte gilt für OLEDs jeglichen Aufbaus, nicht nur für OLEDs gemäß den Definitionen der vorliegenden Anmeldung.

Insbesondere geeignet zur Verwendung in Schichten mit lochtransportierender Funktion jeglicher OLEDs, nicht nur der OLEDs gemäß den Definitionen der vorliegenden Anmeldung, sind die folgenden Verbindungen:

| | |
|---|---|
| 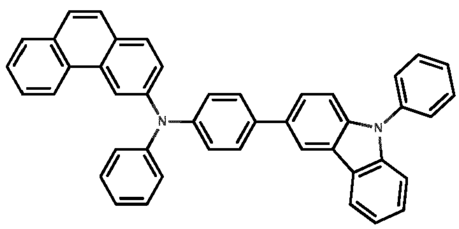 | 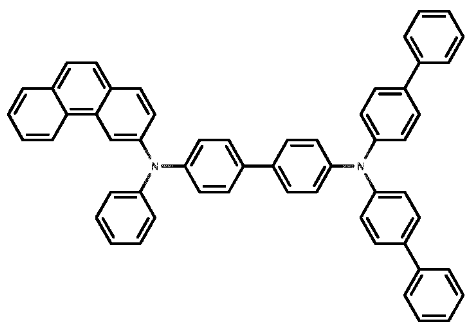 |
| HT-1<br>WO 2013/182263 | HT-2<br>WO 2013/182263 |
| 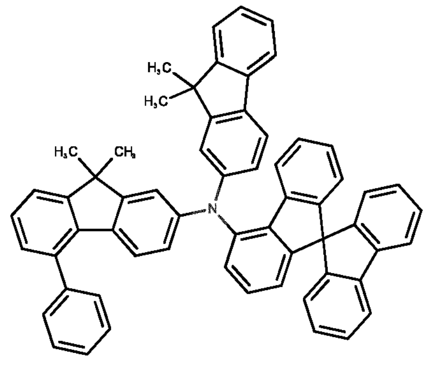 | 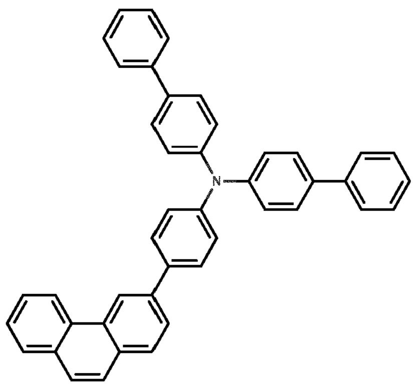 |
| HT-3<br>WO 2019/115577 und WO 2013/120577 | HT-4<br>WO 2013/182263 |

(fortgesetzt)

| | |
|---|---|
| 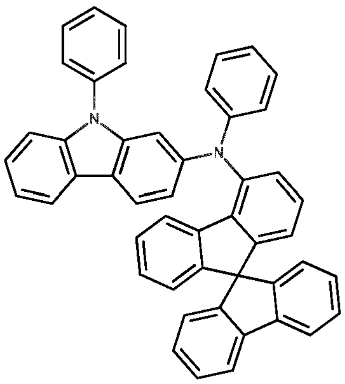 | 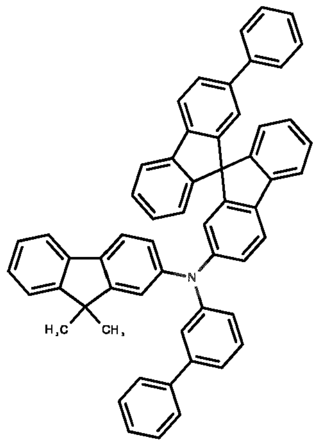 |
| HT-5<br>WO 2013/120577 | HT-6<br>WO 2012/034627 |
| 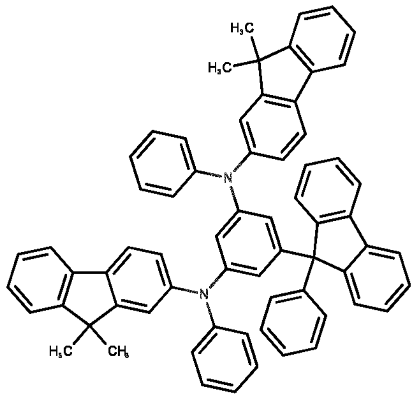 | 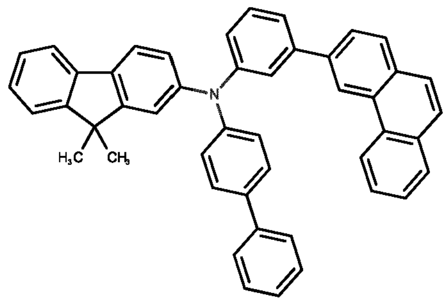 |
| HT-7<br>WO 2009/124627 | HT-8<br>WO 2013/182263 |
| 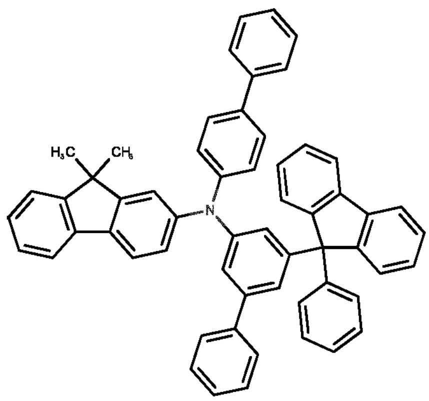 | |
| HT-9<br>WO 2009/124627 | |

Die oben genannten Verbindungen sind allgemein zur Verwendung in lochtransportierenden Schichten geeignet. Ihre Verwendung ist nicht beschränkt auf eine Verwendung beispielsweise als Verbindung H gemäß der vorliegenden Anmeldung, oder in sonstiger Weise beschränkt auf bestimmte OLEDs, wie die in der vorliegenden Anmeldung beschriebenen OLEDs.

Die Verbindungen HT-1 bis HT-9 können nach den Vorschriften hergestellt werden, die in den oben genannten Offenlegungsschriften offenbart sind. Die weitere Lehre betreffend Verwendung und Herstellung der Verbindungen, die in

den in der obenstehenden Tabelle aufgeführten Offenlegungsschriften offenbart ist, ist hiermit explizit einbezogen und ist bevorzugt mit der oben genannten Lehre betreffend die Verwendung der oben genannten Verbindungen als lochtransportierende Materialien zu kombinieren. Die Verbindungen HT-1 bis HT-9 zeigen hervorragende Eigenschaften bei der Verwendung in OLEDs, insbesondere hervorragende Lebensdauer und Effizienz.

Die elektronische Vorrichtung enthält bevorzugt eine oder mehrere Schichten zwischen emittierender Schicht und Kathode. Diese Schichten sind gewählt aus Lochblockierschichten, Elektronentransportschichten und Elektroneninjektionsschichten. Unter einer Lochblockierschicht wird eine Schicht verstanden, die kathodenseitig direkt an die emittierende Schicht angrenzt und den Durchtritt von Löchern aus der emittierenden Schicht heraus in Richtung der Kathode behindert oder verhindert. Unter einer Elektronentransportschicht wird eine Schicht verstanden, die zwischen emittierender Schicht und Kathode angeordnet ist und Elektronen transportiert. Unter einer Elektronenblockierschicht wird eine Schicht verstanden, die direkt anodenseitig an die Kathode angrenzt und die Injektion von Elektronen aus der Kathode heraus erleichtert.

Gemäß einer bevorzugten Ausführungsform enthält die Elektroneninjektionsschicht ein oder mehrere Materialien gewählt aus Aluminiumkomplexen, beispielsweise $Alq_3$, Zirkoniumkomplexen, beispielsweise $Zrq_4$, Lithiumkomplexen, beispielsweise Liq, Benzimidazolderivaten, Triazinderivaten, Pyrimidinderivaten, Pyridinderivaten, Pyrazinderivaten, Chinoxalinderivaten, Chinolinderivaten, Oxadiazolderivaten, aromatischen Ketonen, Lactamen, Boranen, Diazaphospholderivaten und Phosphinoxidderivaten. Insbesondere ist es bevorzugt, dass die Elektroneninjektionsschicht einen oder mehrere n-Dotanden enthält. Bevorzugt enthält sie die Dotanden in einem Anteil von weniger als 20%, besonders bevorzugt weniger als 15%. Gemäß einer alternativen bevorzugten Ausführungsform enthält die Elektroneninjektionsschicht keinen n-Dotanden.

Unter einem n-Dotanden wird im Rahmen der vorliegenden Anmeldung eine Verbindung verstanden, die als Mindermengenkomponente einer Hauptkomponente hinzugefügt wird, wodurch die Elektronenleitfähigkeit einer Schicht enthaltend die Mindermengenkomponente und die Hauptkomponente deutlich erhöht wird. Insbesondere werden darunter Verbindungen verstanden, die ein Oxidationspotential gegenüber Fc/Fc+ von kleiner oder gleich -1,5 eV haben.

Bevorzugt enthalten die Lochblockierschicht und/oder die Elektronentransportschicht und/oder die Elektroneninjektionsschicht eine Verbindung gewählt aus: Aluminiumkomplexen, beispielsweise $Alq_3$, Zirkoniumkomplexen, beispielsweise $Zrq_4$, Lithiumkomplexen, beispielsweise Liq, Benzimidazolderivaten, Triazinderivaten, Pyrimidinderivaten, Pyridinderivaten, Pyrazinderivaten, Chinoxalinderivaten, Chinolinderivaten, Oxadiazolderivaten, aromatischen Ketonen, Lactamen, Boranen, Diazaphospholderivaten und Phosphinoxidderivaten.

Als Kathode der elektronischen Vorrichtung sind Metalle mit geringer Austrittsarbeit, Metalllegierungen oder mehrlagige Strukturen aus verschiedenen Metallen bevorzugt, wie beispielsweise Erdalkalimetalle, Alkalimetalle, Hauptgruppenmetalle oder Lanthanoide (z. B. Ca, Ba, Mg, Al, In, Mg, Yb, Sm, etc.). Weiterhin eignen sich Legierungen aus einem Alkali- oder Erdalkalimetall und Silber, beispielsweise eine Legierung aus Magnesium und Silber. Bei mehrlagigen Strukturen können auch zusätzlich zu den genannten Metallen weitere Metalle verwendet werden, die eine relativ hohe Austrittsarbeit aufweisen, wie z. B. Ag oder Al, wobei dann in der Regel Kombinationen der Metalle, wie beispielsweise Ca/Ag, Mg/Ag oder Ba/Ag verwendet werden. Es kann auch bevorzugt sein, zwischen einer metallischen Kathode und dem organischen Halbleiter eine dünne Zwischenschicht eines Materials mit einer hohen Dielektrizitätskonstante einzubringen. Hierfür kommen beispielsweise Alkalimetall- oder Erdalkalimetallfluoride, aber auch die entsprechenden Oxide oder Carbonate in Frage (z. B. LiF, $Li_2O$, $BaF_2$, MgO, NaF, CsF, $Cs_2CO_3$, etc.). Weiterhin kann dafür Lithiumchinolinat (LiQ) verwendet werden. Die Schichtdicke dieser Schicht beträgt bevorzugt zwischen 0.5 und 5 nm.

Die Herstellung der Vorrichtung erfolgt nach üblichen Verfahren auf dem Gebiet der elektronischen Vorrichtungen.

In einer bevorzugten Ausführungsform werden eine oder mehrere Schichten der elektronischen Vorrichtung, darunter bevorzugt die Schichten A und B, mit einem Sublimationsverfahren aufgetragen. Dabei werden die Materialien in Vakuum-Sublimationsanlagen bei einem Anfangsdruck kleiner $10^{-5}$ mbar, bevorzugt kleiner $10^{-6}$ mbar aufgedampft. Dabei ist es jedoch auch möglich, dass der Anfangsdruck noch geringer ist, beispielsweise kleiner $10^{-7}$ mbar.

Gemäß einer weiteren bevorzugten Ausführungsform werden eine oder mehrere Schichten der elektronischen Vorrichtung mit dem OVPD (Organic Vapour Phase Deposition) Verfahren oder mit Hilfe einer Trägergassublimation aufgetragen. Dabei werden die Materialien bei einem Druck zwischen $10^{-5}$ mbar und 1 bar aufgebracht. Ein Spezialfall dieses Verfahrens ist das OVJP (Organic Vapour Jet Printing) Verfahren, bei dem die Materialien direkt durch eine Düse aufgebracht und so strukturiert werden.

Gemäß einer weiteren bevorzugten Ausführungsform werden eine oder mehrere Schichten der elektronischen Vorrichtung aus Lösung, wie z. B. durch Spincoating, oder mit einem beliebigen Druckverfahren, wie z. B. Siebdruck, Flexodruck, Nozzle Printing oder Offsetdruck, besonders bevorzugt aber LITI (Light Induced Thermal Imaging, Thermotransferdruck) oder Ink-Jet Druck (Tintenstrahldruck), hergestellt.

Gemäß einer weiteren bevorzugten Ausführungsform werden eine oder mehrere Schichten der Vorrichtung aus Lösung und eine oder mehrere Schichten der Vorrichtung durch ein Sublimationsverfahren aufgetragen.

Die Vorrichtung wird nach Aufbringung der Funktionsschichten (je nach Anwendung) strukturiert, kontaktiert und

schließlich versiegelt, um schädigende Effekte von Wasser und Luft auszuschließen.

Die elektronische Vorrichtungen wird bevorzugt in Displays, als Lichtquelle in Beleuchtungsanwendungen sowie als Lichtquelle in medizinischen und/oder kosmetischen Anwendungen eingesetzt.

Verzeichnis der Abbildungen:

Fig. 1 zeigt die in den Beispielen verwendete ITO-Fingerstruktur zur Messung des Crosstalks.

**Beispiele**

A) Herstellung der OLEDs und Messmethoden

Glasplättchen, die mit strukturiertem ITO (Indium Zinn Oxid) der Dicke 50 nm beschichtet sind, bilden die Substrate, auf welche die OLEDs aufgebracht werden.

Die OLEDs haben folgenden Schichtaufbau: Substrat / optionale erste Lochinjektionsschicht (HIL) / erste Lochtransportschicht (HTL1) / zweite Lochtransportschicht (HTL2) / Elektronenblockierschicht (EBL) / Emissionsschicht (EML) / Lochblockierschicht (HBL) / Elektronentransportschicht (ETL) / Elektroneninjektionsschicht (EIL) und abschließend eine Kathode. Die Kathode wird durch eine 100 nm dicke Aluminiumschicht gebildet. Als blau emittierender Dotand wird eine fluoreszierende Indenofluoren-Aminverbindung verwendet. Als Material der HBL wird eine Fluorenyl-Triazin-Verbindung verwendet. Der Aufbau der OLEDs ist den unten gezeigten Tabellen zu entnehmen. Die Strukturen weiterer verwendeter Materialien sind in einer untenstehenden Tabelle gezeigt.

Alle Materialien werden in einer Vakuumkammer thermisch aufgedampft. Dabei besteht die Emissionsschicht immer aus einem Matrixmaterial und einem Emitter, der dem Matrixmaterial durch Coverdampfung in einem bestimmten Volumenanteil beigemischt (hinzudotiert) wird. Eine Angabe wie SMB:SEB (95%:5%) bedeutet hierbei, dass das Material SBM in einem Volumenanteil von 95% und das Material SEB in einem Volumenanteil von 5% in der Schicht vorliegt. Analoges gilt für die Elektronentransportschicht und die Schicht enthaltend den Bismut-Komplex.

B) Vergleich von anmeldungsgemäßen OLEDs mit OLEDs, die keine p-dotierte Schicht enthalten

Es wird die OLED E1 (anmeldungsgemäß) mit der OLED V1 verglichen. OLED V1 entspricht OLED E1, mit dem einzigen Unterschied, dass V1 nicht p-dotiert ist in der HTL1.

Die OLEDs haben den folgenden Aufbau:

| Bsp. | *HIL* | *HTL1* | *HTL2* | *EBL* | *EML* | *HBL* | *ETL* | *EIL* |
|---|---|---|---|---|---|---|---|---|
| V1 | HIM 3 nm | HTM1 20 nm | HTM1 180 nm | HTM1 10 nm | H1:SEB(5%) 20 nm | ETM1 5 nm | ETM2:LiQ(50%) 25 nm | LiQ 1 nm |
| E1 | HIM 3 nm | HTM1: HIM(5%) 20 nm | HTM1 180 nm | HTM1 10 nm | H1:SEB(5%) 20 nm | ETM1 5 nm | ETM2:LiQ(50%) 25 nm | LiQ 1 nm |

Dabei werden die folgenden Ergebnisse erhalten:

| Bsp. | U @ 10 mA/cm$^2$ | dU_LT @ 60 mA/cm$^2$ | Crosstalk @ 8 V |
|---|---|---|---|
| | [V] | mV/h | mA |
| V1 | 3.9 | 0.87 | 2.42E-04 |
| E1 | 3.7 | 0.54 | 1.40E-05 |

Der Vergleich zeigt, dass die anmeldungsgemäße OLEDs einen deutlich geringeren Spannungsanstieg pro Stunde bei einer Stromdichte von 60mA/cm$^2$ aufweist (dU_LT @ 60 mA/cm$^2$ in mV/h), als die Vergleichs-OLEDs. Bei der Messung dieses Parameters wird der Spannungsanstieg zwischen 50 und 350 h Lebensdauer linear approximiert.

Zudem ist die Betriebsspannung, gemessen bei 10 mA/cm$^2$ Stromdichte, bei der anmeldungsgemäßen OLED geringer als bei der Vergleichs-OLED, und der Crosstalk ist deutlich geringer.

Die zur Messung des Crosstalks verwendete ITO-Fingerstruktur ist in Fig. 1 gezeigt. Die Dicke der Fingerstruktur und der Abstand zwischen den ITO-Fingern in der Struktur betragen jeweils 100 $\mu$m.

Zur Bestimmung des Crosstalks wird der Stromfluss zwischen den beiden leitfähigen ITO-Strukturen bei einer konstanten Spannung von 8V gemessen. Auf die Fingerstrukturen ist jeweils ein vollständiger OLED-Stack, allerdings

ohne Aluminium-Deckelektrode, aufgebracht.

Wird anstelle der Verbindung HTM1 als Lochtransportmaterial die alternative Verbindung HTM2 verwendet, zeigen sich dieselben Vorteile für die anmeldungsgemäßen OLEDs (Vergleichspaar E2:V2): verringerter Spannungsanstieg und verrringerter Crosstalk.

| Bsp. | *HIL* | *HTL1* | *HTL2* | *EBL* | *EML* | *HBL* | *ETL* | *EIL* |
|---|---|---|---|---|---|---|---|---|
| | Dicke / nm | Dicke / nm | Dicke / nm | Dicke / nm | Dicke / nm | Dicke / nm | Dicke / nm | Dicke / nm |
| V2 | HIM 3 nm | HTM2 20 nm | HTM2 180 nm | HTM1 10 nm | H1:SEB(5%) 20 nm | ETM1 5 nm | ETM2:LiQ(50%) 25 nm | LiQ 1 nm |
| E2 | HIM 3 nm | HTM2: HIM(5%) 20 nm | HTM2 180 nm | HTM1 10 nm | H1:SEB(5%) 20 nm | ETM1 5 nm | ETM2:LiQ(50%) 25 nm | LiQ 1 nm |

| Bsp. | U@ 10 mA/cm$^2$ | dU_LT @ 60 mA/cm$^2$ | Crosstalk @ 8 V |
|---|---|---|---|
| | [V] | mV/h | mA |
| V2 | 4.4 | 0.43 | 3.20E-04 |
| E2 | 3.9 | 0.39 | 1.46E-04 |

| **Strukturen der verwendeten Materialien** | | |
|---|---|---|
| 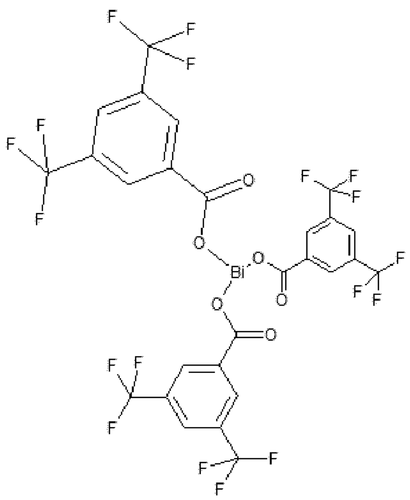 | 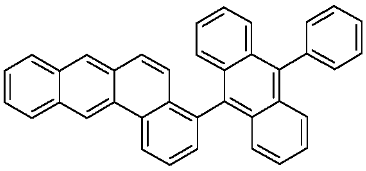 | 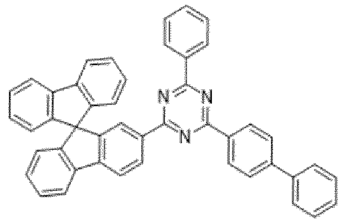 |
| HIM | H1 | ETM2 |
| 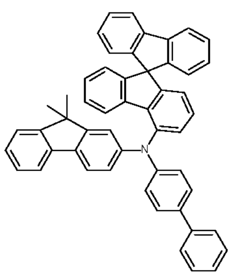 | 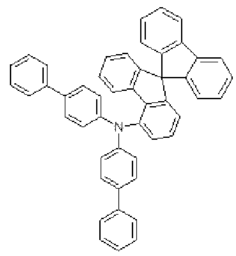 | 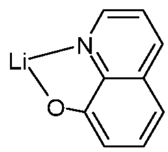 |
| HTM1 | HTM2 | LiQ |

C) Vergleich von anmeldungsgemäßen OLEDs mit OLEDs, bei denen die p-dotierte Schicht direkt an die Anode angrenzt

In weiteren Vergleichsversuchen wird die anmeldungsgemäße OLED E3 mit der OLED V3 verglichen, die keine HIL aus einem Einzelmaterial aufweist. Der Aufbau der OLEDs ist Folgender:

| **Bsp.** | ***HIL*** | ***HTL1*** | ***HTL2*** | ***EBL*** | ***EML*** | ***HBL*** | ***ETL*** | ***EIL*** |
|---|---|---|---|---|---|---|---|---|
| | Dicke / nm | Dicke / nm | Dicke / nm | Dicke / nm | Dicke / nm | Dicke / nm | Dicke / nm | Dicke / nm |
| V3 | - | HTM1: HIM(5%) 20 nm | HTM1 180 nm | HTM1 10 nm | H1:SEB(5%) 20 nm | ETM1 5 nm | ETM2:LiQ(50%) 25 nm | LiQ 1 nm |
| E3 | HIM 3 nm | HTM1: HIM(5%) 20 nm | HTM1 180 nm | HTM1 10 nm | H1:SEB(5%) 20 nm | ETM1 5 nm | ETM2:LiQ(50%) 25 nm | LiQ 1 nm |

Dabei werden für die Vergleichs-OLED V3 zwar initial gute Ergebnisse bezüglich Betriebsspannung und auch ein geringer Crosstalk erhalten, jedoch tritt ein starker Spannunganstieg während der Betriebsdauer der OLED auf, verglichen mit der anmeldungsgemäßen OLED E3:

| **Bsp.** | **dU_LT @ 60 mA/cm$^2$** |
|---|---|
| | mV/h |
| V3 | 105 |
| E3 | 0.54 |

Wird anstelle der Verbindung HTM1 als Lochtransportmaterial die alternative Verbindung HTM2 verwendet, zeigt sich derselbe Vorteil für die anmeldungsgemäßen OLEDs (Vergleichspaar E4:V4): ein deutlich geringerer Spannungsanstieg während der Betriebsdauer der OLEDs:

| **Bsp.** | ***HIL*** | ***HTL1*** | ***HTL2*** | ***EBL*** | ***EML*** | ***HBL*** | ***ETL*** | ***EIL*** |
|---|---|---|---|---|---|---|---|---|
| | Dicke / nm | Dicke / nm | Dicke / nm | Dicke / nm | Dicke / nm | Dicke / nm | Dicke / nm | Dicke / nm |
| V4 | - | HTM2: HIM(5%) 20 nm | HTM2 180 nm | HTM1 10 nm | H1:SEB(5%) 20 nm | ETM1 5 nm | ETM2:LiQ(50%) 25 nm | LiQ 1 nm |
| E4 | HIM 3 nm | HTM2: HIM(5%) 20 nm | HTM2 180 nm | HTM1 10 nm | H1:SEB(5%) 20 nm | ETM1 5 nm | ETM2:LiQ(50%) 25 nm | LiQ 1 nm |

| **Bsp.** | **dU_LT @ 60 mA/cm$^2$** |
|---|---|
| | mV/h |
| V4 | 0.98 |
| E4 | 0.39 |

Zusammenfassend tritt nur bei den anmeldungsgemäßen OLEDs sowohl der erwünschte geringe Spannungsanstieg während der Betriebsdauer als auch der gewünschte geringe Crosstalk auf.

**Patentansprüche**

1. Elektronische Vorrichtung, enthaltend

   - eine Anode,
   - eine an die Anode kathodenseitig angrenzende Schicht A, die eine Verbindung K1, gewählt aus Koordinationsverbindungen enthaltend mindestens ein Bismut-Atom, in einem Anteil von mindestens 20% enthält,
   - eine an die Schicht A kathodenseitig angrenzende Schicht B, die eine Verbindung H und eine weitere Verbindung K2, die gewählt ist aus Koordinationsverbindungen enthaltend mindestens ein Bismut-Atom, enthält;
   - eine Kathode.

2. Elektronische Vorrichtung gemäß Anspruch 1, **dadurch gekennzeichnet, dass** sie gewählt ist aus organischen Elektrolumineszenzvorrichtungen.

3. Elektronische Vorrichtung gemäß Anspruch 1 oder 2, **dadurch gekennzeichnet, dass** die Schicht A direkt an die Anode angrenzt.

4. Elektronische Vorrichtung gemäß einem oder mehreren der Ansprüche 1 bis 3, **dadurch gekennzeichnet, dass** die Schicht A die Verbindung K1 in einem Anteil von mindestens 99% enthält.

5. Elektronische Vorrichtung gemäß einem oder mehreren der Ansprüche 1 bis 4, **dadurch gekennzeichnet, dass** die Verbindung K1 gewählt ist aus Koordinationsverbindungen enthaltend mindestens einen Liganden L und mindestens ein Bi-Atom, das in der Oxidationsstufe +3 vorliegt.

6. Elektronische Vorrichtung gemäß einem oder mehreren der Ansprüche 1 bis 5, **dadurch gekennzeichnet, dass** die Verbindung K1 als Koordinationsverbindung mindestens einen Liganden L aufweist, der eine organische Verbindung ist.

7. Elektronische Vorrichtung gemäß Anspruch 6, **dadurch gekennzeichnet, dass** die an das Bismutatom bindende Gruppe des Liganden L gewählt ist aus Carbonsäuregruppen und Thiocarbonsäuregruppen.

8. Elektronische Vorrichtung gemäß einem oder mehreren der Ansprüche 5 bis 7, **dadurch gekennzeichnet, dass** der Ligand L mindestens eine Carbonsäuregruppe enthält, die zusätzlich zur Carbonsäuregruppe mindestens eine weitere elektronenziehende Gruppe aufweist, die gewählt ist aus F, Cl, CN und $CF_3$.

9. Elektronische Vorrichtung gemäß einem oder mehreren der Ansprüche 6 bis 8, **dadurch gekennzeichnet, dass** der Ligand L einer der folgenden Formeln (L-I), (L-II), (L-III) und (L-IV) entspricht

| | |
|---|---|
| 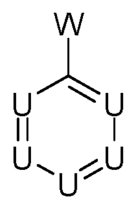 | 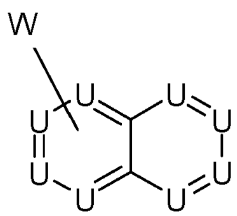 |
| Formel (L-I) | Formel (L-II) |
| 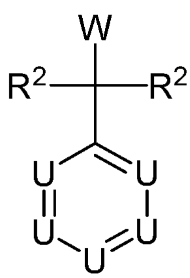 | 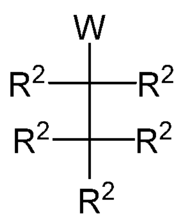 |
| Formel (L-III) | Formel (L-IV) |

wobei gilt:

W ist gewählt aus Carbonsäuregruppen, Thiocarbonsäuregruppen, im Besonderen Thiolsäuregruppen, Thionsäuregruppen und
Dithiolsäuregruppen, Carbonsäureamidgruppen und
Carbonsäureimidgruppen, besonders bevorzugt aus Carbonsäuregruppen;
U ist bei jedem Auftreten gleich oder verschieden gewählt aus N und $CR^1$, wenn an es keine Gruppe W gebunden ist, und U ist gleich C, wenn an es eine Gruppe W gebunden ist; und
$R^1$ ist bei jedem Auftreten gleich oder verschieden gewählt aus H, D, F, Cl, Br, I, $C(=O)R^2$, CN, $Si(R^2)_3$, $N(R^2)_2$, $P(=O)(R^2)_2$, $OR^2$, $S(=O)R^2$, $S(=O)_2R^2$, geradkettigen Alkyl- oder Alkoxygruppen mit 1 bis 20 C-Atomen, verzweigten oder cyclischen Alkyl- oder Alkoxygruppen mit 3 bis 20 C-Atomen, Alkenyl- oder Alkinylgruppen mit 2 bis 20 C-Atomen, aromatischen Ringsystemen mit 6 bis 40 aromatischen Ringatomen, und heteroaromatischen Ringsystemen mit 5 bis 40 aromatischen Ringatomen; wobei zwei oder mehr Reste $R^1$ miteinander verknüpft sein können und einen Ring bilden können; wobei die genannten Alkyl-, Alkoxy-, Alkenyl- und Alkinylgruppen und die genannten aromatischen Ringsysteme und heteroaromatischen Ringsysteme jeweils mit Resten $R^2$ substituiert sind; und wobei eine oder mehrere $CH_2$-Gruppen in den genannten Alkyl-, Alkoxy-, Alkenyl- und Alkinylgruppen durch $-R^2C=CR^2-$, -C=C-, $Si(R^2)_2$, C=O, $C=NR^2$, -C(=O)O-, $-C(=O)NR^2-$, $NR^2$, $P(=O)(R^2)$, -O-, -S-, SO oder $SO_2$ ersetzt sein können;
$R^2$ ist bei jedem Auftreten gleich oder verschieden gewählt aus H, D, F, Cl, Br, I, $C(=O)R^3$, CN, $Si(R^3)_3$, $N(R^3)_2$, $P(=O)(R^3)_2$, $OR^3$, $S(=O)R^3$, $S(=O)_2R^3$, geradkettigen Alkyl- oder Alkoxygruppen mit 1 bis 20 C-Atomen, verzweigten oder cyclischen Alkyl- oder Alkoxygruppen mit 3 bis 20 C-Atomen, Alkenyl- oder Alkinylgruppen mit 2 bis 20 C-Atomen, aromatischen Ringsystemen mit 6 bis 40 aromatischen Ringatomen, und heteroaromatischen Ringsystemen mit 5 bis 40 aromatischen Ringatomen; wobei zwei oder mehr Reste $R^2$ miteinander verknüpft sein können und einen Ring bilden können; wobei die genannten Alkyl-, Alkoxy-, Alkenyl- und Alkinylgruppen und die genannten aromatischen Ringsysteme und heteroaromatischen Ringsysteme jeweils mit Resten $R^3$ substituiert sind; und wobei eine oder mehrere $CH_2$-Gruppen in den genannten Alkyl-, Alkoxy-, Alkenyl- und Alkinylgruppen durch $-R^3C=CR^3-$, -C=C-, $Si(R^3)_2$, C=O, $C=NR^3$, -C(=O)O-, $-C(=O)NR^3-$, $NR^3$, $P(=O)(R^3)$, -O-, -S-, SO oder $SO_2$ ersetzt sein können;
$R^3$ ist bei jedem Auftreten gleich oder verschieden gewählt aus H, D, F, Cl, Br, I, CN, $NO_2$, Alkyl- oder Alkoxygruppen mit 1 bis 20 C-Atomen, Alkenyl- oder Alkinylgruppen mit 2 bis 20 C-Atomen, aromatischen Ringsystemen mit 6 bis 40 aromatischen Ringatomen und heteroaromatischen Ringsystemen mit 5 bis 40 aromatischen Ringatomen; wobei zwei oder mehr Reste $R^3$ miteinander verknüpft sein können und einen Ring bilden können; und wobei die genannten Alkyl-, Alkoxy-, Alkenyl- und Alkinylgruppen, aromatischen Ringsysteme und heteroaromatischen Ringsysteme mit einem oder mehreren Resten gewählt aus F und CN substituiert sein können.

**10.** Elektronische Vorrichtung gemäß Anspruch 9, **dadurch gekennzeichnet, dass** in den Formeln (L-I) bis (L-III) jeweils mindestens eine Gruppe $R^1$ vorhanden ist, die gewählt ist aus F, Cl, Br, CN, $NO_2$ und Alkylgruppen mit 1 bis 20 C-Atomen, welche mindestens einen Substituenten gewählt aus F, Cl, CN und $NO_2$ aufweisen.

**11.** Elektronische Vorrichtung gemäß einem oder mehreren der Ansprüche 6 bis 10, **dadurch gekennzeichnet, dass** der Ligand L gewählt ist aus fluorierten Benzoesäure-Derivaten, fluorierten oder nicht-fluorierten Phenylessigsäurederivaten und fluorierten oder nicht-fluorierten Essigsäurederivaten.

**12.** Elektronische Vorrichtung gemäß einem oder mehreren der Ansprüche 1 bis 11, **dadurch gekennzeichnet, dass** die Schicht B direkt kathodenseitig an die Schicht A angrenzt.

**13.** Elektronische Vorrichtung gemäß einem oder mehreren der Ansprüche 1 bis 12, **dadurch gekennzeichnet, dass** die Verbindung K2 mit der Verbindung H in der Schicht B ein Lewissäure-Lewisbase-Paar bildet, wobei die Verbindung K2 als Lewissäure wirkt und die Verbindung H als Lewis-Base.

**14.** Elektronische Vorrichtung gemäß einem oder mehreren der Ansprüche 1 bis 13, **dadurch gekennzeichnet, dass** die Schicht B die Verbindung K2 in einer Konzentration von 0.1 % bis 20 % enthält.

**15.** Elektronische Vorrichtung gemäß einem oder mehreren der Ansprüche 1 bis 14, **dadurch gekennzeichnet, dass** die Verbindung K2 gewählt ist aus Koordinationsverbindungen enthaltend mindestens einen Liganden L und mindestens ein Bi-Atom, das in der Oxidationsstufe +3 vorliegt.

**16.** Elektronische Vorrichtung gemäß einem oder mehreren der Ansprüche 1 bis 15, **dadurch gekennzeichnet, dass** die Verbindung K2 mindestens einen Liganden L aufweist, der eine organische Verbindung ist, wobei die an das Bismutatom bindende Gruppe des Liganden L gewählt ist aus Carbonsäuregruppen und Thiocarbonsäuregruppen.

**17.** Elektronische Vorrichtung gemäß einem oder mehreren der Ansprüche 1 bis 16, **dadurch gekennzeichnet, dass** die Verbindung K2 mindestens einen Liganden L aufweist, der mindestens eine Carbonsäuregruppe enthält und zusätzlich zur Carbonsäuregruppe mindestens eine Gruppe gewählt aus F, Cl, CN, und $CF_3$ aufweist.

**18.** Elektronische Vorrichtung gemäß einem oder mehreren der Ansprüche 1 bis 17, **dadurch gekennzeichnet, dass** die Verbindung K2 mindestens einen Liganden L enthält, der einer der Formeln (L-I), (L-II), (L-III) und (L-IV) entspricht, wie sie in Anspruch 9 definiert sind.

**19.** Elektronische Vorrichtung gemäß einem oder mehreren der Ansprüche 1 bis 18, **dadurch gekennzeichnet, dass** die Verbindung K1 und die Verbindung K2 gleich gewählt sind.

**20.** Elektronische Vorrichtung gemäß einem oder mehreren der Ansprüche 1 bis 19, **dadurch gekennzeichnet, dass** die Verbindung H gewählt ist aus aromatischen Aminen, die eine einzige Aminogruppe enthalten.

**21.** Elektronische Vorrichtung gemäß einem oder mehreren der Ansprüche 1 bis 20, **dadurch gekennzeichnet, dass** die Verbindung H ein HOMO von -5.1 eV bis -5.7 eV hat, bestimmt mittels Cyclovoltammetrie.

**22.** Elektronische Vorrichtung gemäß einem oder mehreren der Ansprüche 1 bis 21, **dadurch gekennzeichnet, dass** die Verbindung H einer der folgenden Formeln (H-I-I) bis (H-III-I) entspricht

| | |
|---|---|
| 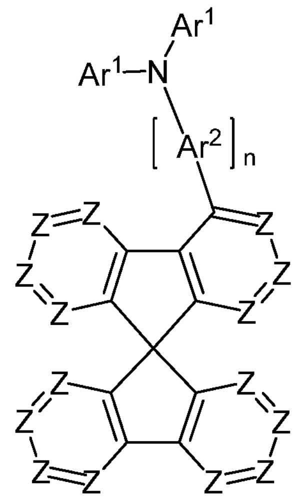 | 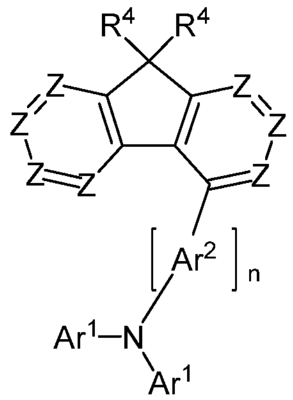 |
| Formel (H-I-I) | Formel (H-II-I) |
| 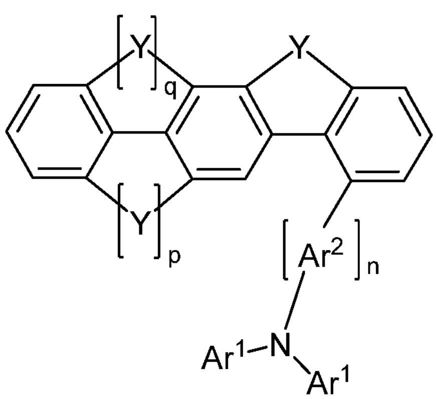 | |
| Formel (H-III-I) | |

wobei die freien Positionen in Formel (H-III-I) jeweils mit einem Rest $R^4$ substituiert sind, und wobei für die auftretenden Gruppen und Indices gilt:

Z ist bei jedem Auftreten gleich oder verschieden $CR^4$ oder N;
Y ist bei jedem Auftreten gleich oder verschieden O, S, $C(R^4)_2$, $Si(R^4)_2$, $PR^4$, $NR^4$, $C(R^4)_2$-$C(R^4)_2$, oder $CR^4$=$CR^4$;
$Ar^1$ ist bei jedem Auftreten gleich oder verschieden gewählt aus aromatischen Ringsystemen mit 6 bis 60 aromatischen Ringatomen, die mit Resten $R^4$ substituiert sind, und heteroaromatischen Ringsystemen mit 5 bis 60 aromatischen Ringatomen, die mit Resten $R^4$ substituiert sind; dabei können Gruppen $Ar^1$ untereinander über Reste $R^4$ verbunden sein;

$Ar^2$ ist ein aromatisches Ringsystem mit 6 bis 20 aromatischen Ringatomen, das mit Resten $R^4$ substituiert ist, oder ein heteroaromatisches Ringsystem mit 5 bis 20 aromatischen Ringatomen, das mit Resten $R^4$ substituiert ist;

$R^4$ ist bei jedem Auftreten gleich oder verschieden gewählt aus H, D, F, Cl, Br, I, $C(=O)R^5$, CN, $Si(R^5)_3$, $N(R^5)_2$, $P(=O)(R^5)_2$, $OR^5$, $S(=O)R^5$, $S(=O)_2R^5$, geradkettigen Alkyl- oder Alkoxygruppen mit 1 bis 20 C-Atomen, verzweigten oder cyclischen Alkyl- oder Alkoxygruppen mit 3 bis 20 C-Atomen, Alkenyl- oder Alkinylgruppen mit 2 bis 20 C-Atomen, aromatischen Ringsystemen mit 6 bis 40 aromatischen Ringatomen, und heteroaromatischen Ringsystemen mit 5 bis 40 aromatischen Ringatomen; wobei zwei oder mehr Reste $R^4$ miteinander verknüpft sein können und einen Ring bilden können; wobei die genannten Alkyl-, Alkoxy-, Alkenyl- und Alkinylgruppen und die genannten aromatischen Ringsysteme und heteroaromatischen Ringsysteme jeweils mit Resten $R^5$ substituiert sind; und wobei eine oder mehrere $CH_2$-Gruppen in den genannten Alkyl-, Alkoxy-, Alkenyl- und Alkinylgruppen durch -$R^5C$=$CR^5$-, -C=C-, $Si(R^5)_2$, C=O, C=$NR^5$, -C(=O)O-, -C(=O)$NR^5$-, $NR^5$, $P(=O)(R^5)$, -O-, -S-, SO oder $SO_2$ ersetzt sein können;
$R^5$ ist bei jedem Auftreten gleich oder verschieden gewählt aus H, D, F, Cl, Br, I, CN, Alkyl- oder Alkoxygruppen mit 1 bis 20 C-Atomen, Alkenyl- oder Alkinylgruppen mit 2 bis 20 C-Atomen, aromatischen Ringsystemen mit 6 bis 40 aromatischen Ringatomen und heteroaromatischen Ringsystemen mit 5 bis 40 aromatischen Ringatomen; wobei zwei oder mehr Reste $R^5$ miteinander verknüpft sein können und einen Ring bilden können; und wobei die genannten Alkyl-, Alkoxy-, Alkenyl- und Alkinylgruppen, aromatischen Ringsysteme und heteroaromatischen Ringsysteme mit einem oder mehreren Resten gewählt aus F und CN substituiert sein können;
n,p,q ist gleich oder verschieden 0 oder 1.

**23.** Elektronische Vorrichtung gemäß einem oder mehreren der Ansprüche 1 bis 22, **dadurch gekennzeichnet, dass** die elektronische Vorrichtung zusätzlich zu den Schichten A und B noch eine oder mehrere weitere Schichten zwischen Anode und emittierender Schicht enthält.

**24.** Verwendung einer elektronischen Vorrichtung gemäß einem oder mehreren der Ansprüche 1 bis 23 in Displays, als Lichtquelle in Beleuchtungsanwendungen sowie als Lichtquelle in medizinischen und/oder kosmetischen Anwendungen.

**25.** Verfahren zur Herstellung einer elektronischen Vorrichtung gemäß einem oder mehreren der Ansprüche 1 bis 23, **dadurch gekennzeichnet, dass** die Schichten A und B mit einem Sublimationsverfahren aufgetragen werden.

## Claims

**1.** Electronic device comprising

- an anode,
- a layer A which is adjacent to the anode on the cathode side, comprising a compound K1 which is selected from coordination compounds containing at least one bismuth atom, in a proportion of at least 20%,
- a layer B which is adjacent to layer A on the cathode side, comprising a compound H and a further compound K2 which is selected from coordination compounds containing at least one bismuth atom;
- a cathode.

**2.** Electronic device according to Claim 1, **characterised in that** it is selected from organic electroluminescent devices.

**3.** Electronic device according to Claim 1 or 2, **characterised in that** layer A is directly adjacent to the anode.

**4.** Electronic device according to one or more of Claims 1 to 3, **characterised in that** layer A comprises compound K1 in a proportion of at least 99%.

**5.** Electronic device according to one or more of Claims 1 to 4, **characterised in that** compound K1 is selected from coordination compounds containing at least one ligand L and at least one Bi atom in the +3 oxidation state.

**6.** Electronic device according to one or more of Claims 1 to 5, **characterised in that** compound K1 as coordination compound has at least one ligand L which is an organic compound.

**7.** Electronic device according to Claim 6, **characterised in that** in the ligand L the group that is bonded to the bismuth atom is selected from carboxylic acid groups and thiocarboxylic acid groups.

**8.** Electronic device according to one or more of Claims 5 to 7, **characterised in that** the ligand L contains at least one carboxylic acid group which, in addition to the carboxylic acid group, has at least one further electron-withdrawing group selected from F, Cl, CN and $CF_3$.

**9.** Electronic device according to one or more of Claims 6 to 8, **characterised in that** the ligand L corresponds to one of the following formulae (L-I), (L-II), (L-III) and (L-IV):

| | |
|---|---|
| 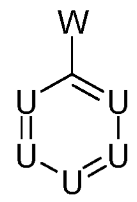 | 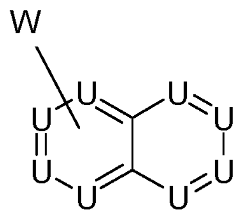 |
| formula (L-I) | formula (L-II) |
| 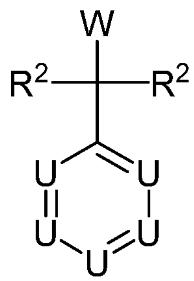 | 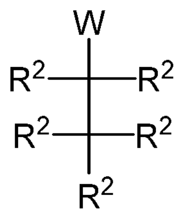 |
| formula (L-III) | formula (L-IV) |

where:

W is selected from carboxylic acid groups, thiocarboxylic acid groups, in particular thiolic acid groups, thionic acid groups and dithiolic acid groups, carboxamide groups and carboximide groups, particularly preferably from carboxylic acid groups;

U is selected on each occurrence, identically or differently, from N and $CR^1$ if no group W is bonded to it, and U is equal to C if a group W is bonded to it; and

$R^1$ is selected on each occurrence, identically or differently, from H, D, F, Cl, Br, I, $C(=O)R^2$, CN, $Si(R^2)_3$, $N(R^2)_2$, $P(=O)(R^2)_2$, $OR^2$, $S(=O)R^2$, $S(=O)_2R^2$, straight-chain alkyl or alkoxy groups having 1 to 20 C atoms, branched or cyclic alkyl or alkoxy groups having 3 to 20 C atoms, alkenyl or alkynyl groups having 2 to 20 C atoms, aromatic ring systems having 6 to 40 aromatic ring atoms, and heteroaromatic ring systems having 5 to 40 aromatic ring atoms; where two or more radicals $R^1$ may be linked to one another and may form a ring; where the said alkyl, alkoxy, alkenyl and alkynyl groups and the said aromatic ring systems and heteroaromatic ring systems are in each case substituted by radicals $R^2$; and where one or more $CH_2$ groups in the said alkyl, alkoxy, alkenyl and alkynyl groups may be replaced by $-R^2C=CR^2-$, -C=C-, $Si(R^2)_2$, C=O, $C=NR^2$, -C(=O)O-, $-C(=O)NR^2-$, $NR^2$, $P(=O)(R^2)$, -O-, -S-, SO or $SO_2$;

$R^2$ is selected on each occurrence, identically or differently, from H, D, F, Cl, Br, I, $C(=O)R^3$, CN, $Si(R^3)_3$, $N(R^3)_2$, $P(=O)(R^3)_2$, $OR^3$, $S(=O)R^3$, $S(=O)_2R^3$, straight-chain alkyl or alkoxy groups having 1 to 20 C atoms, branched or cyclic alkyl or alkoxy groups having 3 to 20 C atoms, alkenyl or alkynyl groups having 2 to 20 C atoms, aromatic ring systems having 6 to 40 aromatic ring atoms, and heteroaromatic ring systems having 5 to 40 aromatic ring atoms; where two or more radicals $R^2$ may be linked to one another and may form a ring; where the said alkyl, alkoxy, alkenyl and alkynyl groups and the said aromatic ring systems and heteroaromatic ring systems are in each case substituted by radicals $R^3$; and where one or more $CH_2$ groups in the said alkyl, alkoxy, alkenyl and alkynyl groups may be replaced by $-R^3C=CR^3-$, -C=C-, $Si(R^3)_2$, C=O, $C=NR^3$, -C(=O)O-, $-C(=O)NR^3-$, $NR^3$, $P(=O)(R^3)$, -O-, -S-, SO or $SO_2$;
$R^3$ is selected on each occurrence, identically or differently, from H, D, F, Cl, Br, I, CN, $NO_2$, alkyl or alkoxy groups having 1 to 20 C atoms, alkenyl or alkynyl groups having 2 to 20 C atoms, aromatic ring systems having 6 to 40 aromatic ring atoms and heteroaromatic ring systems having 5 to 40 aromatic ring atoms; where two or more radicals $R^3$ may be linked to one another and may form a ring; and where the said alkyl, alkoxy, alkenyl and alkynyl groups, aromatic ring systems and heteroaromatic ring systems may be substituted by one or more radicals selected from F and CN.

**10.** Electronic device according to Claim 9, **characterised in that** at least one group $R^1$ selected from F, Cl, Br, CN, $NO_2$ and alkyl groups having 1 to 20 C atoms which have at least one substituent selected from F, Cl, CN and $NO_2$ is in each case present in the formulae (L-I) to (L-III).

**11.** Electronic device according to one or more of Claims 6 to 10, **characterised in that** the ligand L is selected from fluorinated benzoic acid derivatives, fluorinated or unfluorinated phenylacetic acid derivatives and fluorinated or unfluorinated acetic acid derivatives.

**12.** Electronic device according to one or more of Claims 1 to 11, **characterised in that** layer B is directly adjacent to layer A on the cathode side.

**13.** Electronic device according to one or more of Claims 1 to 12, **characterised in that** compound K2 forms a Lewis acid/Lewis base pair with compound H in the layer B, where compound K2 acts as Lewis acid and compound H as Lewis base.

**14.** Electronic device according to one or more of Claims 1 to 13, **characterised in that** layer B comprises compound K2 in a concentration of 0.1% to 20%.

**15.** Electronic device according to one or more of Claims 1 to 14, **characterised in that** compound K2 is selected from coordination compounds containing at least one ligand L and at least one Bi atom in the +3 oxidation state.

**16.** Electronic device according to one or more of Claims 1 to 15, **characterised in that** compound K2 has at least one ligand L which is an organic compound, where in the ligand L the group that is bonded to the bismuth atom is selected from carboxylic acid groups and thiocarboxylic acid groups.

**17.** Electronic device according to one or more of Claims 1 to 16, **characterised in that** compound K2 has at least one ligand L which contains at least one carboxylic acid group and, in addition to the carboxylic acid group, has at least one group selected from F, Cl, CN and $CF_3$.

**18.** Electronic device according to one or more of Claims 1 to 17, **characterised in that** compound K2 contains at least one ligand L which corresponds to one of the formulae (L-I), (L-II), (L-III) and (L-IV) as defined in Claim 9.

**19.** Electronic device according to one or more of Claims 1 to 18, **characterised in that** compound K1 and compound K2 are selected identically.

**20.** Electronic device according to one or more of Claims 1 to 19, **characterised in that** compound H is selected from aromatic amines that contain a single amino group.

**21.** Electronic device according to one or more of Claims 1 to 20, **characterised in that** compound H has an HOMO of -5.1 eV to -5.7 eV, determined by means of cyclic voltammetry.

**22.** Electronic device according to one or more of Claims 1 to 21, **characterised in that** compound H corresponds to one

of the following formulae (H-I-I) to (H-III-I):

| | |
|---|---|
| 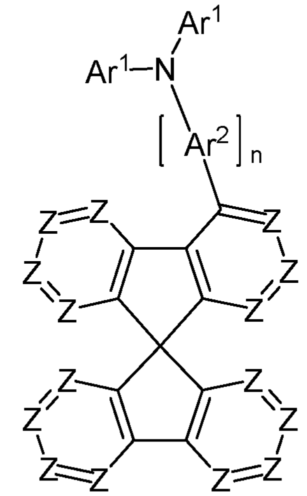 | 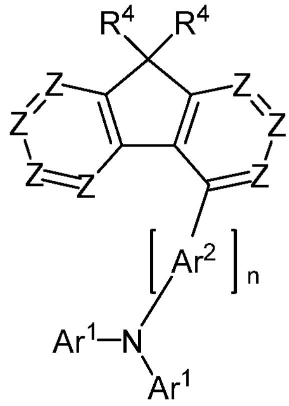 |
| formula (H-I-I) | formula (H-II-I) |
| 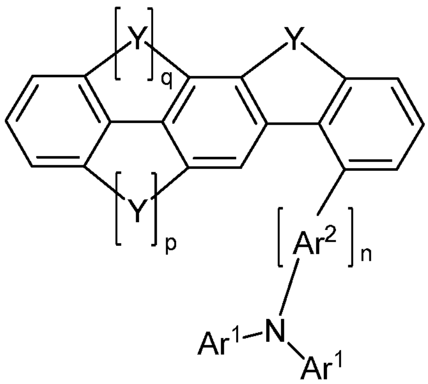 | |
| formula (H-III-I) | |

where the free positions in formula (H-III-I) are in each case substituted by a radical $R^4$, and where the following applies to the groups and indices occurring:

Z is on each occurrence, identically or differently, $CR^4$ or N;
Y is on each occurrence, identically or differently, O, S, $C(R^4)_2$, $Si(R^4)_2$, $PR^4$, $NR^4$, $C(R^4)_2$-$C(R^4)_2$ or $CR^4$=$CR^4$;
$Ar^1$ is selected on each occurrence, identically or differently, from aromatic ring systems having 6 to 60 aromatic ring atoms which are substituted by radicals $R^4$, and heteroaromatic ring systems having 5 to 60 aromatic ring atoms which are substituted by radicals $R^4$; groups $Ar^1$ may be connected to one another via radicals $R^4$;

$Ar^2$ is an aromatic ring system having 6 to 20 aromatic ring atoms which is substituted by radicals $R^4$, or a heteroaromatic ring system having 5 to 20 aromatic ring atoms which is substituted by radicals $R^4$;

$R^4$ is selected on each occurrence, identically or differently, from H, D, F, Cl, Br, I, C(=O)$R^5$, CN, $Si(R^5)_3$, $N(R^5)_2$, P(=O)$(R^5)_2$, $OR^5$, S(=O)$R^5$, $S(=O)_2R^5$, straight-chain alkyl or alkoxy groups having 1 to 20 C atoms, branched or cyclic alkyl or alkoxy groups having 3 to 20 C atoms, alkenyl or alkynyl groups having 2 to 20 C atoms, aromatic ring systems having 6 to 40 aromatic ring atoms, and heteroaromatic ring systems having 5 to 40 aromatic ring atoms; where two or more radicals $R^4$ may be linked to one another and may form a ring; where the said alkyl, alkoxy, alkenyl and alkynyl groups and the said aromatic ring systems and heteroaromatic ring systems are in each case substituted by radicals $R^5$; and where one or more $CH_2$ groups in the said alkyl, alkoxy, alkenyl and alkynyl groups may be replaced by -$R^5$C=C$R^5$-, -C=C-, $Si(R^5)_2$, C=O, C=$NR^5$,

-C(=O)O-, -C(=O)NR$^5$-, NR$^5$, P(=O)(R$^5$), -O-, -S-, SO or $SO_2$;
R$^5$ is selected on each occurrence, identically or differently, from H, D, F, Cl, Br, I, CN, alkyl or alkoxy groups having 1 to 20 C atoms, alkenyl or alkynyl groups having 2 to 20 C atoms, aromatic ring systems having 6 to 40 aromatic ring atoms and heteroaromatic ring systems having 5 to 40 aromatic ring atoms; where two or more radicals R$^5$ may be linked to one another and may form a ring; and where the said alkyl, alkoxy, alkenyl and alkynyl groups, aromatic ring systems and heteroaromatic ring systems may be substituted by one or more radicals selected from F and CN;
n, p, q are, identically or differently, 0 or 1.

**23.** Electronic device according to one or more of Claims 1 to 22, **characterised in that**, in addition to layers A and B, the electronic device also comprises one or more further layers between anode and emitting layer.

**24.** Use of an electronic device according to one or more of Claims 1 to 23 in displays, as light source in lighting applications and as light source in medical and/or cosmetic applications.

**25.** Process for the production of an electronic device according to one or more of Claims 1 to 23, **characterised in that** layers A and B are applied by means of a sublimation process.

## Revendications

**1.** Dispositif électronique comprenant

- une anode,
- une couche A qui est adjacente à l'anode du côté de la cathode, comprenant un composé K1 qui est choisi parmi les composés de coordination contenant au moins un atome de bismuth, selon une proportion d'au moins 20%,
- une couche B qui est adjacente à la couche A du côté de la cathode, comprenant un composé H et un autre composé K2 qui est choisi parmi les composés de coordination contenant au moins un atome de bismuth ;
- une cathode.

**2.** Dispositif électronique selon la revendication 1, **caractérisé en ce qu'**il est choisi parmi les dispositifs électroluminescents organiques.

**3.** Dispositif électronique selon la revendication 1 ou 2, **caractérisé en ce que** la couche A est directement adjacente à l'anode.

**4.** Dispositif électronique selon l'une ou plusieurs parmi les revendications 1 à 3, **caractérisé en ce que** la couche A comprend le composé K1 selon une proportion d'au moins 99%.

**5.** Dispositif électronique selon l'une ou plusieurs parmi les revendications 1 à 4, **caractérisé en ce que** le composé K1 est choisi parmi les composés de coordination contenant au moins un ligand L et au moins un atome Bi à l'état d'oxydation +3.

**6.** Dispositif électronique selon l'une ou plusieurs parmi les revendications 1 à 5, **caractérisé en ce que** le composé K1 en tant que composé de coordination possède au moins un ligand L qui est un composé organique.

**7.** Dispositif électronique selon la revendication 6, **caractérisé en ce que** dans le ligand L, le groupement qui est lié à l'atome de bismuth est choisi parmi les groupements acide carboxylique et les groupements acide thiocarboxylique.

**8.** Dispositif électronique selon l'une ou plusieurs parmi les revendications 5 à 7, **caractérisé en ce que** le ligand L contient au moins un groupement acide carboxylique qui, outre le groupement acide carboxylique, possède au moins un autre groupement électroattracteur choisi parmi F, Cl, CN et $CF_3$.

**9.** Dispositif électronique selon l'une ou plusieurs parmi les revendications 6 à 8, **caractérisé en ce que** le ligand L correspond à l'une des formules (L-I), (L-II), (L-III) et (L-IV) suivantes :

| | |
|---|---|
| 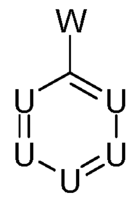 | 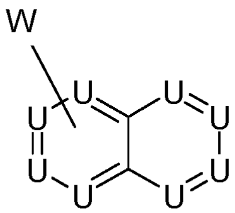 |
| formule (L-I) | formule (L-II) |
| 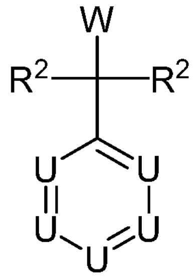 | 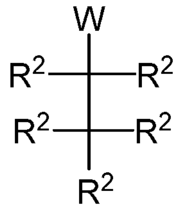 |
| formule (L-III) | formule (L-IV) |

dans lesquelles :

W est choisi parmi les groupements acide carboxylique, les groupements acide thiocarboxylique, en particulier les groupements acide thiolique, les groupements acide thionique et les groupements acide dithiolique, les groupements carboxamide et les groupements carboximide, particulièrement préférablement parmi les groupements acide carboxylique ;

U est choisi à chaque occurrence, de manière identique ou différente, parmi N et $CR^1$ si aucun groupement W n'y est lié, et U est égal à C si un groupement W y est lié ; et

$R^1$ est choisi à chaque occurrence, de manière identique ou différente, parmi H, D, F, Cl, Br, I, $C(=O)R^2$, CN, $Si(R^2)_3$, $N(R^2)_2$, $P(=O)(R^2)_2$, $OR^2$, $S(=O)R^2$, $S(=O)_2R^2$, des groupements alkyle ou alcoxy à chaîne linéaire ayant de 1 à 20 atomes de C, des groupements alkyle ou alcoxy ramifiés ou cycliques ayant de 3 à 20 atomes de C, des groupements alcényle ou alcynyle ayant de 2 à 20 atomes de C, des noyaux aromatiques ayant de 6 à 40 atomes de cycle aromatique, et des noyaux hétéroaromatiques ayant de 5 à 40 atomes de cycle aromatique ; où deux, ou plus, radicaux $R^1$ peuvent être liés les uns aux autres et peuvent former un cycle ; où lesdits groupements alkyle, alcoxy, alcényle et alcynyle et lesdits noyaux aromatiques et noyaux hétéroaromatiques sont dans chaque cas substitués par des radicaux $R^2$ ; et où un ou plusieurs groupements $CH_2$ dans lesdits groupements alkyle, alcoxy, alcényle et alcynyle peuvent être remplacés par $-R^2C=CR^2-$, -C=C-, $Si(R^2)_2$, C=O, $C=NR^2$, -C(=O)O-, $-C(=O)NR^2-$, $NR^2$, $P(=O)(R^2)$, -O-, -S-, SO ou $SO_2$ ;

$R^2$ est choisi à chaque occurrence, de manière identique ou différente, parmi H, D, F, Cl, Br, I, $C(=O)R^3$, CN, $Si(R^3)_3$, $N(R^3)_2$, $P(=O)(R^3)_2$, $OR^3$, $S(=O)R^3$, $S(=O)_2R^3$, des groupements alkyle ou alcoxy à chaîne linéaire ayant de 1 à 20 atomes de C, des groupements alkyle ou alcoxy ramifiés ou cycliques ayant de 3 à 20 atomes de C, des groupements alcényle ou alcynyle ayant de 2 à 20 atomes de C, des noyaux aromatiques ayant de 6 à 40 atomes de cycle aromatique, et des noyaux hétéroaromatiques ayant de 5 à 40 atomes de cycle aromatique ; où deux, ou plus, radicaux $R^2$ peuvent être liés les uns aux autres et peuvent former un cycle ; où lesdits groupements alkyle, alcoxy, alcényle et alcynyle et lesdits noyaux aromatiques et noyaux hétéroaromatiques sont dans chaque cas substitués par des radicaux $R^3$ ; et où un ou plusieurs groupements $CH_2$ dans lesdits groupements alkyle, alcoxy, alcényle et alcynyle peuvent être remplacés par $-R^3C=CR^3-$, -C=C-, $Si(R^3)_2$, C=O, $C=NR^3$, -C(=O)O-, $-C(=O)NR^3-$, $NR^3$, $P(=O)(R^3)$, -O-, -S-, SO ou $SO_2$ ;

$R^3$ est choisi à chaque occurrence, de manière identique ou différente, parmi H, D, F, Cl, Br, I, CN, $NO_2$, des groupements alkyle ou alcoxy ayant de 1 à 20 atomes de C, des groupements alcényle ou alcynyle ayant de 2 à 20 atomes de C, des noyaux aromatiques ayant de 6 à 40 atomes de cycle aromatique et des noyaux hétéroaromatiques ayant de 5 à 40 atomes de cycle aromatique ; où deux, ou plus, radicaux $R^3$ peuvent être liés les uns aux autres et peuvent former un cycle ; et où lesdits groupements alkyle, alcoxy, alcényle et alcynyle, noyaux aromatiques et noyaux hétéroaromatiques peuvent être substitués par un ou plusieurs radicaux choisis parmi F et CN.

**10.** Dispositif électronique selon la revendication 9, **caractérisé en ce qu'**au moins un groupement $R^1$ choisi parmi F, Cl,

Br, CN, $NO_2$ et des groupements alkyle ayant de 1 à 20 atomes de C qui possèdent au moins un substituant choisi parmi F, Cl, CN et $NO_2$ est dans chaque cas présent dans les formules (L-I) à (L-III).

**11.** Dispositif électronique selon l'une ou plusieurs parmi les revendications 6 à 10, **caractérisé en ce que** le ligand L est choisi parmi les dérivés d'acide benzoïque fluoré, les dérivés d'acide phénylacétique fluoré ou non fluoré et les dérivés d'acide acétique fluoré ou non fluoré.

**12.** Dispositif électronique selon l'une ou plusieurs parmi les revendications 1 à 11, **caractérisé en ce que** la couche B est directement adjacente à la couche A du côté de la cathode.

**13.** Dispositif électronique selon l'une ou plusieurs parmi les revendications 1 à 12, **caractérisé en ce que** le composé K2 forme une paire acide de Lewis/base de Lewis avec le composé H dans la couche B, où le composé K2 agit comme acide de Lewis et le composé H comme base de Lewis.

**14.** Dispositif électronique selon l'une ou plusieurs parmi les revendications 1 à 13, **caractérisé en ce que** la couche B comprend le composé K2 selon une concentration allant de 0,1% à 20%.

**15.** Dispositif électronique selon l'une ou plusieurs parmi les revendications 1 à 14, **caractérisé en ce que** le composé K2 est choisi parmi les composés de coordination contenant au moins un ligand L et au moins un atome Bi à l'état d'oxydation +3.

**16.** Dispositif électronique selon l'une ou plusieurs parmi les revendications 1 à 15, **caractérisé en ce que** le composé K2 possède au moins un ligand L qui est un composé organique, où dans le ligand L le groupement qui est lié à l'atome de bismuth est choisi parmi des groupements acide carboxylique et des groupements acide thiocarboxylique.

**17.** Dispositif électronique selon l'une ou plusieurs parmi les revendications 1 à 16, **caractérisé en ce que** le composé K2 possède au moins un ligand L qui contient au moins un groupement acide carboxylique et, outre le groupement acide carboxylique, possède au moins un groupement choisi parmi F, Cl, CN et $CF_3$.

**18.** Dispositif électronique selon l'une ou plusieurs parmi les revendications 1 à 17, **caractérisé en ce que** le composé K2 contient au moins un ligand L qui correspond à l'une des formules (L-I), (L-II), (L-III) et (L-IV) telles que définies selon la revendication 9.

**19.** Dispositif électronique selon l'une ou plusieurs parmi les revendications 1 à 18, **caractérisé en ce que** le composé K1 et le composé K2 sont choisis de manière identique.

**20.** Dispositif électronique selon l'une ou plusieurs parmi les revendications 1 à 19, **caractérisé en ce que** le composé H est choisi parmi les amines aromatiques qui contiennent un seul groupement amino.

**21.** Dispositif électronique selon l'une ou plusieurs parmi les revendications 1 à 20, **caractérisé en ce que** le composé H présente une HOMO allant de -5,1 eV à -5,7 eV, déterminée par voltampérométrie cyclique.

**22.** Dispositif électronique selon l'une ou plusieurs parmi les revendications 1 à 21, **caractérisé en ce que** le composé H correspond à l'une des formules (H-I-I) à (H-III-I) suivantes :

| | |
|---|---|
| 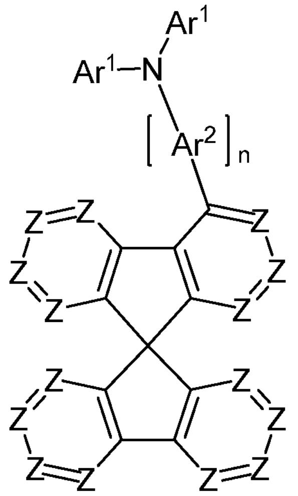 | 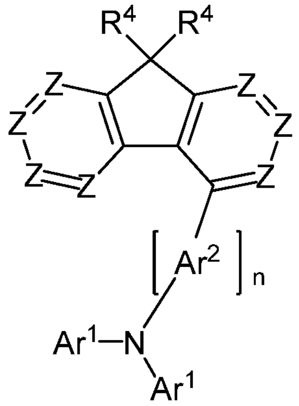 |
| formule (H-I-I) | formule (H-II-I) |
| 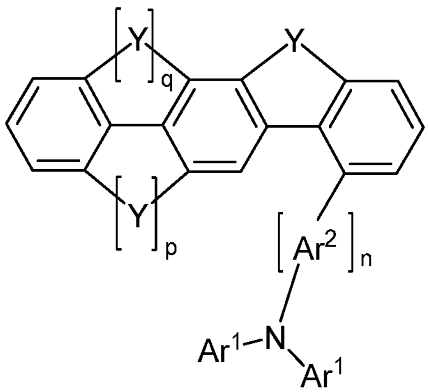 | |
| formule (H-III-I) | |

dans lesquelles les positions libres dans la formule (H-III-I) sont dans chaque cas substituées par un radical $R^4$, et où ce qui suit s'applique aux groupements et indices présents :

Z est à chaque occurrence, de manière identique ou différente, $CR^4$ ou N ;
Y est à chaque occurrence, de manière identique ou différente, O, S, $C(R^4)_2$, $Si(R^4)_2$, $PR^4$, $NR^4$, $C(R^4)_2$-$C(R^4)_2$ ou $CR^4$=$CR^4$ ;
$Ar^1$ est choisi à chaque occurrence, de manière identique ou différente, parmi des noyaux aromatiques ayant de 6 à 60 atomes de cycle aromatique qui sont substitués par des radicaux $R^4$, et des noyaux hétéroaromatiques ayant de 5 à 60 atomes de cycle aromatique qui sont substitués par des radicaux $R^4$ ; les groupements $Ar^1$ peuvent être reliés les uns aux autres via des radicaux $R^4$ ;

$Ar^2$ est un noyau aromatique ayant de 6 à 20 atomes de cycle aromatique qui est substitué par des radicaux $R^4$, ou un noyau hétéroaromatique ayant de 5 à 20 atomes de cycle aromatique qui est substitué par des radicaux $R^4$ ;

$R^4$ est choisi à chaque occurrence, de manière identique ou différente, parmi H, D, F, Cl, Br, I, $C(=O)R^5$, CN, $Si(R^5)_3$, $N(R^5)_2$, $P(=O)(R^5)_2$, $OR^5$, $S(=O)R^5$, $S(=O)_2R^5$, des groupements alkyle ou alcoxy à chaîne linéaire ayant de 1 à 20 atomes de C, des groupements alkyle ou alcoxy ramifiés ou cycliques ayant de 3 à 20 atomes de C, des groupements alcényle ou alcynyle ayant de 2 à 20 atomes de C, des noyaux aromatiques ayant de 6 à 40 atomes de cycle aromatique, et des noyaux hétéroaromatiques ayant de 5 à 40 atomes de cycle aromatique ; où deux, ou plus, radicaux $R^4$ peuvent être liés les uns aux autres et peuvent former un cycle ; où lesdits groupements alkyle, alcoxy, alcényle et alcynyle et lesdits noyaux aromatiques et noyaux hétéroaromatiques sont dans chaque cas substitués par des radicaux $R^5$ ; et où un ou plusieurs groupements $CH_2$ dans lesdits groupements alkyle, alcoxy, alcényle et alcynyle peuvent être remplacés par -$R^5C$=$CR^5$-, -C=C-, $Si(R^5)_2$, C=O, $C=NR^5$, -C(=O)O-, -C(=O)

$NR^5$-, $NR^5$, $P(=O)(R^5)$, -O-, -S-, SO ou $SO_2$ ;

$R^5$ est choisi à chaque occurrence, de manière identique ou différente, parmi H, D, F, Cl, Br, I, CN, des groupements alkyle ou alcoxy ayant de 1 à 20 atomes de C, des groupements alcényle ou alcynyle ayant de 2 à 20 atomes de C, des noyaux aromatiques ayant de 6 à 40 atomes de cycle aromatique et des noyaux hétéroaromatiques ayant de 5 à 40 atomes de cycle aromatique ; où deux, ou plus, radicaux $R^5$ peuvent être liés les uns aux autres et peuvent former un cycle ; et où lesdits groupements alkyle, alcoxy, alcényle et alcynyle, noyaux aromatiques et noyaux hétéroaromatiques peuvent être substitués par un ou plusieurs radicaux choisis parmi F et CN ;

n, p, q valent, de manière identique ou différente, 0 ou 1.

**23.** Dispositif électronique selon l'une ou plusieurs parmi les revendications 1 à 22, **caractérisé en ce que**, outre les couches A et B, le dispositif électronique comprend également une ou plusieurs autres couches entre l'anode et la couche émettrice.

**24.** Utilisation d'un dispositif électronique selon l'une ou plusieurs parmi les revendications 1 à 23 dans des affichages, comme source de lumière dans des applications d'éclairage et comme source de lumière dans des applications médicales et/ou cosmétiques.

**25.** Procédé de production d'un dispositif électronique selon l'une ou plusieurs parmi les revendications 1 à 23, **caractérisé en ce que** les couches A et B sont appliquées à l'aide d'un procédé de sublimation.

Fig. 1

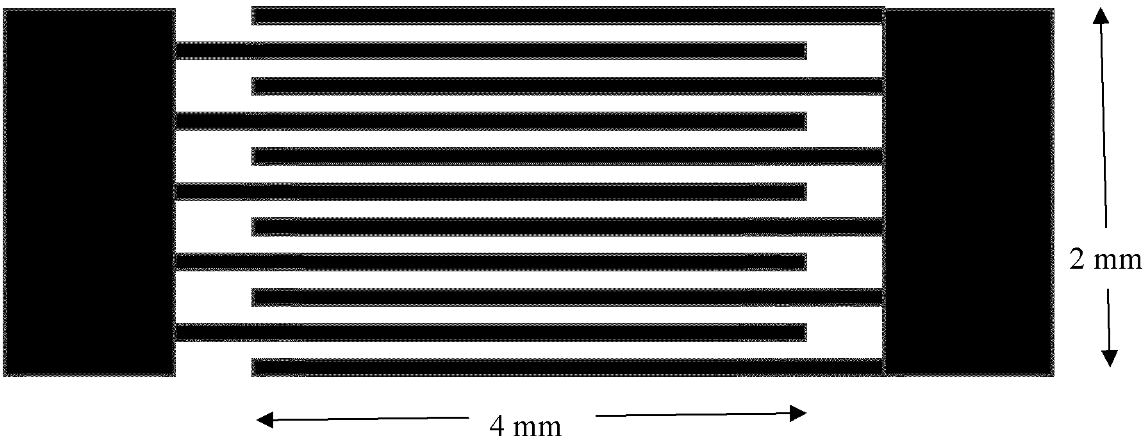

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

### In der Beschreibung aufgeführte Patentdokumente


- WO 2016062371 A1
- EP 3462516 A1
- WO 0070655 A
- WO 0141512 A
- WO 0202714 A
- WO 0215645 A
- EP 1191613 A
- EP 1191612 A
- EP 1191614 A
- WO 05033244 A
- WO 05019373 A
- US 20050258742 A
- WO 2013182263 A
- WO 2019115577 A
- WO 2013120577 A
- WO 2012034627 A
- WO 2009124627 A